# EUROPEAN PATENT APPLICATION

(11) **EP 4 407 665 A2**
(43) Date of publication of application: **31.07.2024**
(21) Application number: 24154003.8
(22) Date of filing: 25.01.2024
(51) Int. Cl.: H01L 21/67, H01L 21/677

(54) **SUBSTRATE PROCESSING SYSTEM**

(30) Priority: 27.01.2023 JP 2023011057
(71) Applicant: SCREEN Holdings Co., Ltd., Kyoto-shi, Kyoto 602-8585 (JP)
(72) Inventor: AMAHISA, Kenji, Kyoto-shi, 602-8585 (JP); TOMITA, Tsuyoshi, Kyoto-shi, 602-8585 (JP); TANIGUCHI, Shinichi, Kyoto-shi, 602-8585 (JP); IWASAKI, Akihiro, Kyoto-shi, 602-8585 (JP)
(74) Representative: Kilian Kilian & Partner mbB

(57) **Abstract**

The present invention continuously performs batch processing and single-wafer processing on substrates by connecting a batch processing apparatus and a single-wafer processing apparatus separated from each other by a relay apparatus. With such a configuration, it is possible to relatively easily achieve a substrate processing system capable of continuously performing batch processing and single-wafer processing on substrates by surely utilizing technologies cultivated in individual batch processing-type and single-wafer processing-type apparatuses.

## Description

### Cross-Reference to Related Applications

This application claims priority to Japanese Patent Application No. 2023-011057 filed January 27, 2023, the subject matter of which is incorporated herein by reference in entirety.

### BACKGROUND

### Technical Field

The present invention relates to a substrate processing system that performs predetermined processing on various substrates such as a semiconductor substrate, a substrate for liquid crystal display or for flat panel display (FPD) such as an organic electroluminescence (EL) display device, a photomask glass substrate, and an optical disk substrate.

### Related Art

Examples of this type of conventional apparatus include an apparatus including a batch-type module and a single-wafer-type module (see, for example, JP 2021-64654 A). The batch-type module collectively performs predetermined processing on a plurality of substrates. The single-wafer-type module performs predetermined processing on each substrate. Each of the batch-type module and the single-wafer-type module has a unique merit. A substrate processing apparatus including the batch-type module and the single-wafer-type module has both of the merits, and thus achieves a configuration having more advantages than a batch-type substrate processing apparatus or a single-wafer-type substrate processing apparatus.

The apparatus of JP 2021-64654 A includes a single-substrate-type processing part related to single-wafer-type substrate processing on the back side of a loading/unloading part into and from which a cassette is loaded and unloaded, and a batch-type processing part related to batch-type substrate processing on the back side of the single-substrate-type processing part. Therefore, according to this apparatus configuration, substrates taken out from a cassette C in the loading/unloading part first pass through the single-substrate-type processing part to be conveyed to the batch-type processing part. The substrates subjected to batch processing by the batch-type processing part are returned to the single-substrate-type processing part. The single-substrate-type processing part then performs single-wafer processing on the batch-processed substrates. The series of substrate processing is achieved by the apparatus in which the batch-type module and the single-wafer-type module are integrated.

### <List of documents mentioned above>

JP 2021-64654 A
However, the above-described apparatus has a hardware configuration that is greatly different from that of an existing substrate processing apparatus, which causes various problems. Examples of the existing substrate processing apparatus include an apparatus that performs only batch processing and an apparatus that performs only single-wafer processing. The apparatus that performs only batch processing is configured to collectively take out a plurality of substrates from a cassette that accommodates the substrates, perform batch processing thereon, and return the substrates to the cassette. On the other hand, the apparatus that performs only single-wafer processing is configured to take out substrates one by one from a cassette, perform single-wafer processing thereon, and return the substrates to the cassette. These two types of apparatuses have long been operated, and apparatus configurations and operation methods have also been established. However, in the apparatus configuration in which the batch-type module and the single-wafer-type module are integrated as in JP 2021-64654 A, there is a possibility that an unexpected malfunction occurs during operation. An attempt to newly manufacture the apparatus in which the batch-type module and the single-wafer-type module are integrated also results in an increase in design cost and manufacturing cost of the apparatus.

The present invention has been made in view of such circumstances, and an object of the present invention is to relatively easily achieve a substrate processing system capable of continuously performing batch processing and single-wafer processing on substrates.

### SUMMARY

In order to solve the above problems, the present invention has the following configuration.
(1) A substrate processing system that continuously performs batch processing of collectively processing a plurality of substrates and single-wafer processing of processing the substrates one by one, the substrate processing system including: a batch processing apparatus configured to perform batch processing; at least one single-wafer processing apparatus configured to perform single-wafer processing on a batch-processed substrate; and at least one relay apparatus in which two positions are defined, one being a carry-in position for receiving the batch-processed substrate from the batch processing apparatus, and the other being a carry-out position for transferring the substrate received at the carry-in position to the single-wafer processing apparatus, wherein the batch processing apparatus includes: a first carrier placement shelf on which a carrier is placed, the carrier accommodating a plurality of substrates in a horizontal attitude at a predetermined interval in a vertical direction; a transfer block adjacent to the first carrier placement shelf; and a batch processing block adjacent to the transfer block, the transfer block including: a substrate handling mechanism configured to collectively take out the plurality of substrates from the carrier placed on the first carrier placement shelf; and a first attitude changing mechanism configured to collectively change the plurality of substrates taken out from the carrier from the horizontal attitude to a vertical attitude, the batch processing block including: at least one batch processing bath in which the plurality of substrates in the vertical attitude are collectively immersed; and a collective conveyance mechanism configured to collectively convey the plurality of substrates in the vertical attitude among the transfer block, the batch processing bath, and the carry-in position of the relay apparatus, wherein the single-wafer processing apparatus includes: a second carrier placement shelf on which the carrier is placed; an indexer block adjacent to the second carrier placement shelf; and a single-wafer processing block adjacent to the indexer block, the single-wafer processing block including: a plurality of single-wafer processing chambers configured to perform a drying treatment on the substrates in a horizontal attitude one by one; and a single-wafer conveyance mechanism configured to receive the batch-processed substrates in the horizontal attitude one by one from the carry-out position of the relay apparatus and convey the substrates to the single-wafer processing chambers, the indexer block including an indexer robot configured to allow the single-wafer-processed substrates to be accommodated in the carrier placed on the second carrier placement shelf, wherein the relay apparatus includes: a second attitude changing mechanism configured to change the plurality of substrates received from the batch processing apparatus from the vertical attitude to the horizontal attitude; and a relay conveyance mechanism configured to convey the substrates along a substrate conveyance path provided between the carry-in position and the carry-out position.

[Operation and Effect] In accordance with the invention according to (1) described above, the batch processing apparatus and the single-wafer processing apparatus separated from each other are connected by the relay apparatus, so that it is possible to configure the substrate processing system that continuously performs the batch processing of collectively processing a plurality of substrates and the single-wafer processing of processing the substrates one by one. That is, the present invention includes the relay apparatus in which the two positions are defined: the carry-in position for receiving the batch-processed substrate from the batch processing apparatus and the carry-out position for transferring the substrate received at the carry-in position to the single-wafer processing apparatus. The relay apparatus receives the substrate subjected to the batch processing by the batch processing apparatus at the carry-in position, and transfers the substrate to the single-wafer processing apparatus at the carry-out position, the batch processing apparatus and the single-wafer processing apparatus being separated from each other. This makes it possible to configure the substrate processing system that continuously performs the batch processing and the single-wafer processing on the basis of technologies cultivated in the individual apparatuses. It is also possible to reduce the design cost and manufacturing cost of the system.

In addition to the invention according to (1) described above, this specification also discloses the following inventions.

(2) In the substrate processing system according to (1), in the relay apparatus, the second attitude changing mechanism is provided on the carry-in position side, the relay apparatus further including a single-wafer substrate shift mechanism configured to take out, one by one, the plurality of substrates collectively changed from the vertical attitude to the horizontal attitude by the second attitude changing mechanism, and transfer the substrates to the relay conveyance mechanism, and the relay conveyance mechanism conveys the substrates in the horizontal attitude transferred from the single-wafer substrate shift mechanism, one by one toward the carry-out position.

[Operation and Effect] In accordance with the configuration of (2), the relay apparatus is configured to collectively change the attitudes of the plurality of substrates on the carry-in position side, and transfer the substrates whose attitudes have been changed one by one to the carry-out position by the relay conveyance mechanism. Since the single-wafer processing apparatus is configured to acquire the substrates one by one at the carry-out position of the relay apparatus as described above, the single-wafer processing apparatus has a simplified configuration, and the number of single-wafer processing chambers to be mounted can be increased. This makes it possible to provide the substrate processing system having a high throughput.

(3) In the substrate processing system according to (1), in the relay apparatus, the second attitude changing mechanism is provided on the carry-in position side, and the relay conveyance mechanism collectively conveys the plurality of substrates collectively changed from the vertical attitude to the horizontal attitude by the second attitude changing mechanism, toward the carry-out position.

[Operation and Effect] In accordance with the configuration of (3), the relay apparatus is configured to collectively change the attitudes of the plurality of substrates on the carry-in position side, and collectively transfer the substrates whose attitudes have been changed to the carry-out position by the relay conveyance mechanism. With such a configuration, the substrates can be conveyed at a higher speed in the relay apparatus, and it is possible to provide the substrate processing system having a smooth substrate flow.

(4) In the substrate processing system according to (1), in the relay apparatus, the second attitude changing mechanism is provided on the carry-out position side, the relay conveyance mechanism collectively conveys the plurality of substrates in the vertical attitude received from the batch processing apparatus, to the second attitude changing mechanism, and the second attitude changing mechanism collectively changes the plurality of substrates received from the relay conveyance mechanism from the vertical attitude to the horizontal attitude.

[Operation and Effect] In accordance with the configuration of (4), the relay apparatus is configured to convey the plurality of substrates acquired at the carry-in position toward the single-wafer processing apparatus by the relay conveyance mechanism, and change the attitudes of the plurality of substrates at the carry-out position. With such a configuration, the substrates can be conveyed at a higher speed in the relay apparatus, and it is possible to provide the substrate processing system having a smooth substrate flow. Furthermore, since the second attitude changing mechanism is placed on the single-wafer processing apparatus side, the batch processing apparatus has a simplified configuration.

(5) In the substrate processing system according to (1), the relay conveyance mechanism includes a belt conveyor mechanism.

[Operation and Effect] In accordance with the configuration of (5), the relay conveyance mechanism in the relay apparatus includes the belt conveyor mechanism. With such a configuration, it is possible to provide the substrate processing system that conveys the substrates in the horizontal attitude one by one by a simple and reliable method.

(6) In the substrate processing system according to (1), the relay conveyance mechanism includes a robot configured to grip the substrate.

[Operation and Effect] In accordance with the configuration of (6), the relay conveyance mechanism in the relay apparatus includes the robot configured to grip the substrate(s). With such a configuration, it is possible to provide the substrate processing system that surely conveys the plurality of substrates.

(7) In the substrate processing system according to (1), the relay apparatus includes, at the carry-in position, a standby bath in which the plurality of substrates in the vertical attitude carried in from the batch processing apparatus are immersed in a liquid.

[Operation and Effect] In accordance with the configuration of (7), the relay apparatus includes, at the carry-in position, the standby bath in which the plurality of substrates in the vertical attitude carried in from the batch processing apparatus are immersed in a liquid. With such a configuration, it is possible to provide the substrate processing system that surely conveys the plurality of substrates without drying the substrates in the relay apparatus.

(8) In the substrate processing system according to (1), the relay apparatus includes a liquid supply part configured to supply a liquid to the substrate conveyed by the relay conveyance mechanism to wet a surface of the substrate with the liquid.

[Operation and Effect] In accordance with the configuration of (8), the relay apparatus includes the liquid supply part configured to supply a liquid to the substrate conveyed by the relay conveyance mechanism to wet the surface of the substrate with the liquid. With such a configuration, it is possible to provide the substrate processing system that surely conveys the plurality of substrates without drying the substrates in the relay apparatus.

(9) In the substrate processing system according to (1), the relay apparatus includes a batch processing apparatus-side shutter configured to block circulation of an atmosphere through the substrate conveyance path of the relay apparatus and provided on the carry-in position side.

[Operation and Effect] In accordance with the configuration of (9), the relay apparatus includes the batch processing apparatus-side shutter configured to block circulation of the atmosphere through the substrate conveyance path of the relay apparatus and provided on the carry-in position side. With such a configuration, it is possible to block the atmosphere of the batch processing apparatus and the atmosphere of the single-wafer processing apparatus. This makes it possible to provide the substrate processing system in which various mechanisms of the single-wafer processing apparatus are prevented from malfunctioning even when an erodible chemical solution is used in the batch processing apparatus.

(10) In the substrate processing system according to (1), the relay apparatus includes a single-wafer processing apparatus-side shutter configured to block circulation of an atmosphere through the substrate conveyance path of the relay apparatus and provided on the carry-out position side.

[Operation and Effect] In accordance with the configuration of (10), the relay apparatus includes the single-wafer processing apparatus-side shutter configured to block circulation of the atmosphere through the substrate conveyance path of the relay apparatus and provided on the carry-out position side. With such a configuration, it is possible to block the atmosphere of the batch processing apparatus and the atmosphere of the single-wafer processing apparatus. This makes it possible to provide the substrate processing system in which various mechanisms of the single-wafer processing apparatus are prevented from malfunctioning even when an erodible chemical solution is used in the batch processing apparatus.

(11) In the substrate processing system according to (1), in the relay apparatus, the carry-out position is positioned in a middle layer of a stacked body including the single-wafer processing chambers stacked in the vertical direction in the single-wafer processing apparatus.

[Operation and Effect] In accordance with the configuration of (11), the relay apparatus is positioned in the middle layer of the stacked body including the single-wafer processing chambers stacked in the vertical direction in the single-wafer processing apparatus. With such a configuration, the single-wafer processing chamber provided in an upper layer of the stacked body and the carry-out position of the relay apparatus are disposed close to each other. Thus, the substrate can be conveyed from the relay apparatus to the single-wafer processing chamber by being conveyed only by a small distance. Therefore, according to this configuration, the substrate processing system having a high throughput can be provided. According to this configuration, the same applies to the single-wafer processing chamber provided in a lower layer of the stacked body. In this respect, the substrate processing system having a high throughput can also be provided.

(12) In the substrate processing system according to (1), the carry-out position of the relay apparatus and the plurality of single-wafer processing chambers are disposed around the single-wafer conveyance mechanism.

[Operation and Effect] In accordance with the configuration of (12), the single-wafer conveyance mechanism in the single-wafer processing apparatus remains at a position surrounded by the carry-out position of the relay apparatus and the plurality of single-wafer processing chambers. With such a configuration, the single-wafer processing chambers can be disposed close to the carry-out position. Therefore, according to this configuration, the substrate can be conveyed from the relay apparatus to the single-wafer processing chambers by being conveyed only by a small distance. This makes it possible to provide the substrate processing system having a high throughput.

(13) In the substrate processing system according to (1), the relay apparatus is provided closer to the transfer block than the at least one batch processing bath of the batch processing apparatus.

[Operation and Effect] In accordance with the configuration of (13), the relay apparatus is provided closer to the transfer block than the at least one batch processing bath of the batch processing apparatus. With such a configuration, even when the single-wafer processing apparatus and the batch processing apparatus are different in size, the relay apparatus can bridge between the two apparatuses. This is because the single-wafer processing apparatus extends at least to a position on the rear side of the transfer block.

(14) The substrate processing system according to (1) includes a carrier conveyance mechanism configured to convey the carrier between the batch processing apparatus and the single-wafer processing apparatus to cause the substrates after substrate processing to return to the same carrier as the carrier that accommodates the substrates before substrate processing.

[Operation and Effect] In accordance with the configuration of (14), the substrate processing system includes the carrier conveyance mechanism configured to convey the carrier between the batch processing apparatus and the single-wafer processing apparatus to cause the substrates after substrate processing to return to the same carrier as the carrier that accommodates the substrates before substrate processing. With such a configuration, the substrates after the substrate processing can be accommodated in the same carrier as the carrier to which the substrates before the substrate processing belong. This makes it possible to provide the substrate processing system that facilitates management of the substrates.

(15) In the substrate processing system according to (1), the batch processing apparatus includes: a first housing configured to accommodate the blocks constituting the batch processing apparatus; and a first load port protruding from a first wall surface perpendicular to a predetermined direction from the batch processing block toward the transfer block, among wall surfaces forming the first housing, and the single-wafer processing apparatus includes: a second housing configured to accommodate the blocks constituting the single-wafer processing apparatus; and a second load port protruding from a second wall surface perpendicular to the predetermined direction, among wall surfaces forming the second housing, the second load port being at a position on a same side as the first load port in the predetermined direction.

[Operation and Effect] In accordance with the configuration of (15), the batch processing apparatus includes the first load port protruding from the first wall surface forming the first housing that accommodates the blocks constituting the batch processing apparatus, and the single-wafer processing apparatus includes the second load port protruding from the second wall surface forming the second housing that accommodates the blocks constituting the single-wafer processing apparatus, the second load port being at the position on the same side as the first load port. With such a configuration, the carrier can be conveyed from the batch processing apparatus to the single-wafer processing apparatus by using the individual carrier conveyance mechanism provided in a plant where the substrate processing system is installed. This makes it possible to provide the substrate processing system in which the carrier is easily moved.

(16) In the substrate processing system according to (1), the batch processing apparatus includes: a first housing configured to accommodate the blocks constituting the batch processing apparatus; and a first load port protruding from a first wall surface perpendicular to a predetermined direction from the batch processing block toward the transfer block, among wall surfaces forming the first housing, the single-wafer processing apparatus includes: a second housing configured to accommodate the blocks constituting the single-wafer processing apparatus; and a second load port protruding from a second wall surface perpendicular to the predetermined direction, among wall surfaces forming the second housing, and the relay apparatus includes a relay housing configured to connect the first housing and the second housing separated from each other, the relay housing being provided between a first perpendicular wall surface of the first housing perpendicular to the first wall surface, and a second perpendicular wall surface of the second housing perpendicular to the second wall surface and provided at a position facing the first perpendicular wall surface.

[Operation and Effect] In accordance with the configuration of (16), the first housing constituting the batch processing apparatus and the second housing constituting the single-wafer processing apparatus are provided apart from each other without sharing the wall surface, and the relay apparatus is provided so as to bridge between these housings. With such a configuration, apparatus maintenance can be performed using a gap between the first housing and the second housing. This makes it possible to provide the substrate processing system that is easy for maintenance.

(17) The substrate processing system according to (1) includes: the one batch processing apparatus; the first and second single-wafer processing apparatuses; and the first and second relay apparatuses, wherein the batch processing apparatus is disposed between the first single-wafer processing apparatus and the second single-wafer processing apparatus with a gap between the respective apparatuses, the batch processing apparatus and the first single-wafer processing apparatus are connected by the first relay apparatus, and the batch processing apparatus and the second single-wafer processing apparatus are connected by the second relay apparatus.

[Operation and Effect] In accordance with the configuration of (17), the batch processing apparatus is disposed between the first single-wafer processing apparatus and the second single-wafer processing apparatus with a gap between the respective apparatuses, and the batch processing apparatus and the first single-wafer processing apparatus are connected by the first relay apparatus. The batch processing apparatus and the second single-wafer processing apparatus are connected by the second relay apparatus. By providing the plurality of single-wafer processing apparatuses for the batch processing apparatus in this manner, it is possible to inhibit a decrease in throughput occurring in the single-wafer processing.

(18) The substrate processing system according to (1) includes: the one batch processing apparatus; the first and second single-wafer processing apparatuses; and the first and second relay apparatuses, wherein the batch processing apparatus, the first single-wafer processing apparatus, and the second single-wafer processing apparatus are disposed sequentially with a gap between the respective apparatuses, the batch processing apparatus and the first single-wafer processing apparatus are connected by the first relay apparatus, and the batch processing apparatus and the second single-wafer processing apparatus are connected by the second relay apparatus.

[Operation and Effect] In accordance with the configuration of (18), the batch processing apparatus, the first single-wafer processing apparatus, and the second single-wafer processing apparatus are disposed sequentially with a gap between the respective apparatuses, and the batch processing apparatus and the first single-wafer processing apparatus are connected by the first relay apparatus. The batch processing apparatus and the second single-wafer processing apparatus are connected by the second relay apparatus. By providing the plurality of single-wafer processing apparatuses for the batch processing apparatus in this manner, it is possible to inhibit a decrease in throughput occurring in the single-wafer processing.

(19) The substrate processing system according to (1) includes an airflow generator configured to cause an atmosphere of the relay apparatus to flow into the batch processing apparatus.

[Operation and Effect] In accordance with the configuration of (19), the batch processing apparatus includes the airflow generator configured to cause the atmosphere of the relay apparatus to flow into the batch processing apparatus. With such a configuration, it is possible to provide the substrate processing system in which various mechanisms of the single-wafer processing apparatus are prevented from malfunctioning even when an erodible chemical solution is used in the batch processing apparatus. This is because the airflow generator prevents the atmosphere from flowing from the batch processing apparatus into the single-wafer processing apparatus.

(20) In the substrate processing system according to (1), the batch processing block includes a collective drying chamber configured to collectively dry the plurality of substrates, the single-wafer processing block includes a single-wafer processing chamber configured to perform a chemical treatment on the substrates one by one, and control related to a batch processing mode in which substrate processing is completed only by the batch processing apparatus, control related to a single-wafer processing mode in which substrate processing is completed only by the single-wafer processing apparatus, and control related to a hybrid processing mode in which substrate processing is completed using the batch processing apparatus and the single-wafer processing apparatus are selectively configured.

[Operation and Effect] In accordance with the configuration of (20), the substrate processing can be completed by the single-wafer processing apparatus, or the substrate processing can be completed by the batch processing apparatus. The substrate processing can also be completed by the batch processing apparatus and the single-wafer processing apparatus. With such a configuration, it is possible to provide the substrate processing system that can be operated in various modes according to the purpose of substrate processing.

The present invention continuously performs the batch processing and the single-wafer processing on the substrates by connecting the batch processing apparatus and the single-wafer processing apparatus separated from each other by the relay apparatus. With such a configuration, it is possible to configure the substrate processing system by surely utilizing highly-reliable apparatus configurations cultivated in batch processing-type and single-wafer processing-type apparatuses. Consequently, according to the present invention, it is possible to predict what kind of malfunction occurs during operation, and it is also possible to reduce the design cost and manufacturing cost of the substrate processing system.

### BRIEF DESCRIPTION OF DRAWINGS

FIG. 1 is a plan view illustrating an overall configuration of a substrate processing system according to a first embodiment;
FIG. 2 is a plan view illustrating an overall configuration of a batch processing apparatus in the first embodiment;
FIG. 3 is a schematic view illustrating a configuration of an HVC attitude changer in the first embodiment;
FIGS. 4A to 4F are schematic views illustrating a configuration of a first attitude changing mechanism in the first embodiment;
FIGS. 5A and 5B are schematic views illustrating a configuration of a relay apparatus in the first embodiment;
FIGS. 6A and 6B are schematic views illustrating the configuration of the relay apparatus in the first embodiment;
FIGS. 7A to 7D are schematic views illustrating the configuration of the relay apparatus in the first embodiment;
FIGS. 8A to 8D are schematic views illustrating the configuration of the relay apparatus in the first embodiment;
FIGS. 9A to 9C are schematic views illustrating the configuration of the relay apparatus in the first embodiment;
FIGS. 10A to 10C are schematic views illustrating the configuration of the relay apparatus in the first embodiment;
FIGS. 11A to 11C are schematic views illustrating a configuration of a shutter in the first embodiment;
FIG. 12 is a schematic view illustrating the configuration of the relay apparatus according to the first embodiment;
FIG. 13 is a flowchart illustrating a flow of substrate processing according to the first embodiment;
FIG. 14 is a schematic view illustrating the flow of substrate processing according to the first embodiment;
FIG. 15 is a schematic view illustrating the flow of substrate processing according to the first embodiment;
FIGS. 16A and 16B are flowcharts illustrating a flow of substrate processing according to the first embodiment;
FIG. 17 is a schematic view illustrating the flow of substrate processing according to the first embodiment;
FIG. 18 is a plan view illustrating a substrate processing system according to a second embodiment;
FIGS. 19A to 19C are schematic views illustrating a configuration of a forward/reverse rotation belt conveyor according to the second embodiment;
FIG. 20 is a schematic view illustrating a flow of substrate processing according to the second embodiment;
FIG. 21 is a plan view illustrating a substrate processing system according to a third embodiment;
FIGS. 22A to 22C are schematic views illustrating a transfer procedure of a substrate according to the third embodiment;
FIG. 23 is a schematic view illustrating a flow of substrate processing according to the third embodiment;
FIG. 24 is a schematic view illustrating the flow of substrate processing according to the third embodiment;
FIG. 25 is a plan view illustrating a substrate processing system according to a modification;
FIG. 26 is a plan view illustrating a substrate processing system according to a modification;
FIGS. 27A and 27B are plan views illustrating a substrate processing system according to a modification;
FIG. 28 is a plan view illustrating a substrate processing system according to a modification;
FIGS. 29A and 29B are plan views illustrating a substrate processing system according to a modification;
FIGS. 30A to 30C are plan views illustrating a substrate processing system according to a modification;
FIGS. 31A to 31C are schematic views illustrating a substrate processing system according to a modification;
FIGS. 32A and 32B are schematic views illustrating a substrate processing system according to a modification;
FIGS. 33A and 33B are schematic views illustrating a substrate processing system according to a modification; and
FIGS. 34A to 34D are schematic views illustrating a substrate processing system according to a modification.

### DETAILED DESCRIPTION

Hereinafter, embodiments of the present invention will be described with reference to the drawings. A substrate processing system of the present invention continuously performs batch processing of collectively processing a plurality of substrates Wand single-wafer processing of processing the substrates W one by one, and has a configuration in which a batch processing apparatus related to the batch processing and a single-wafer processing apparatus related to the single-wafer processing are connected by a relay apparatus.

The substrate processing system according to the present invention performs various kinds of processing such as a chemical treatment, a cleaning treatment, and a drying treatment on the substrates W. The substrate processing system adopts a processing method (so-called hybrid method) in which two methods: a batch-type processing method of collectively processing the plurality of substrates W and a single-wafer-type processing method of processing the substrates W one by one, are used in combination. The batch-type processing method is a processing method of collectively processing the plurality of substrates W arranged in a vertical attitude. The single-wafer-type processing method is a processing method of processing the substrates W in a horizontal attitude one by one.

### [First Embodiment]

### <1. Overall Configuration>

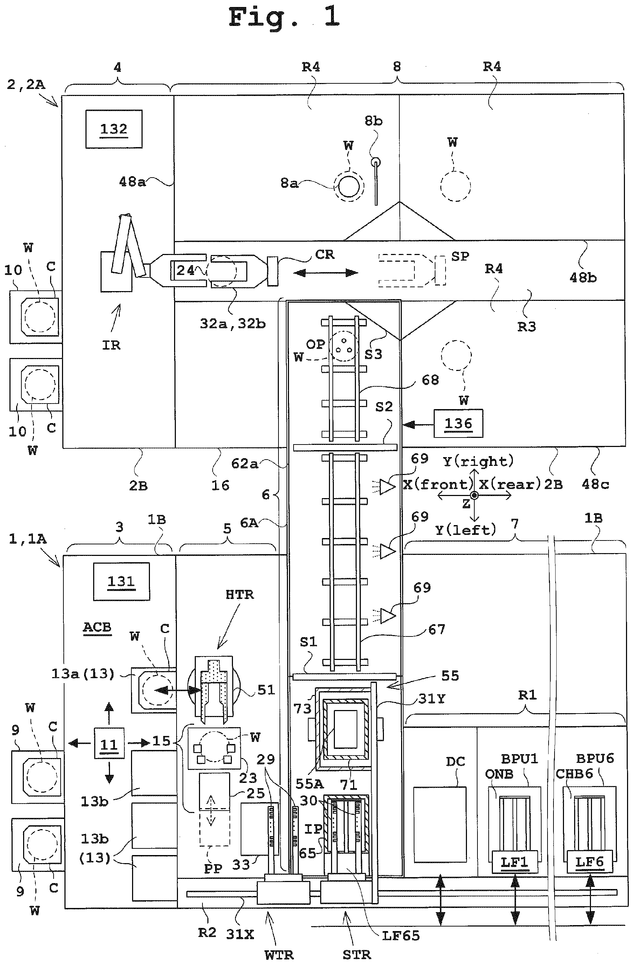

As illustrated in FIG. 1, the substrate processing system includes a batch processing apparatus 1 and a single-wafer processing apparatus 2 that are separately configured, and a relay apparatus 6 that connects the two apparatuses 1 and 2. The batch processing apparatus 1 is related to batch processing of collectively processing a plurality of substrates. The single-wafer processing apparatus 2 is related to single-wafer processing of processing the substrates one by one. The relay apparatus 6 is configured to convey the batch-processed substrates from the batch processing apparatus 1 to the single-wafer processing apparatus 2, and has a bridging structure provided at a position interposed between the batch processing apparatus 1 and the single-wafer processing apparatus 2.

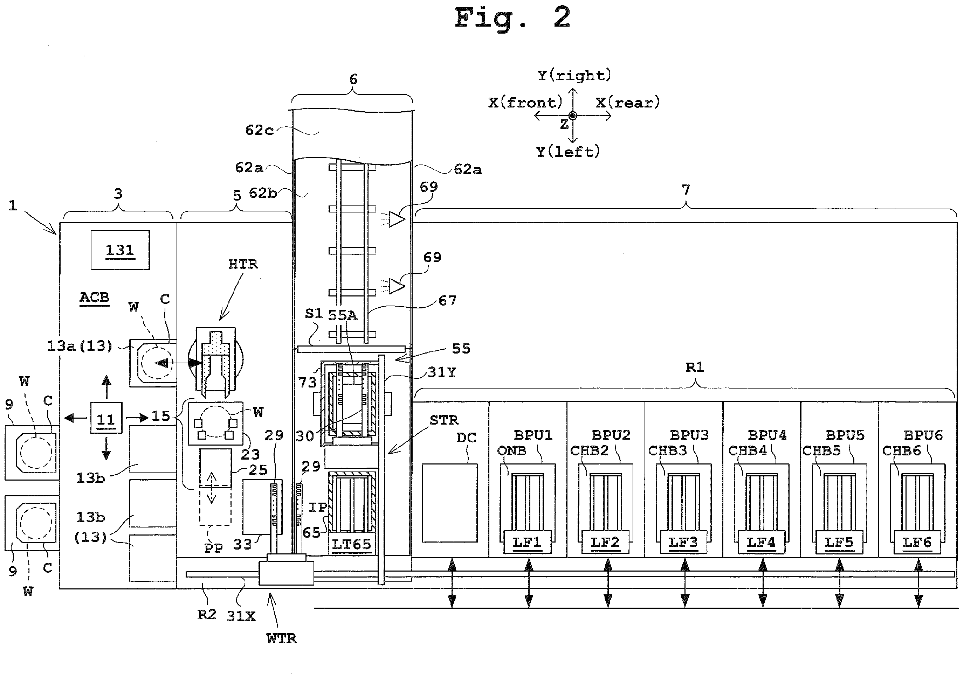

As illustrated in FIG. 1, each of the batch processing apparatus 1 and the single-wafer processing apparatus 2 includes blocks partitioned by partition walls. That is, the batch processing apparatus 1 includes a stocker block 3, a transfer block 5 adjacent to the stocker block 3, and a batch processing block 7 adjacent to the transfer block 5. FIG. 2 illustrates a specific configuration of the batch processing block 7 in the batch processing apparatus 1. On the other hand, the single-wafer processing apparatus 2 includes an indexer block 4 and a single-wafer processing block 8 adjacent to the indexer block 4.

The batch processing apparatus 1 includes a first housing 1A that accommodates the respective blocks constituting the batch processing apparatus 1. The single-wafer processing apparatus 2 includes a second housing 2A that accommodates the respective blocks constituting the single-wafer processing apparatus 2. The first housing 1A includes a first load port 9 protruding from a first wall surface perpendicular to an X direction from the batch processing block 7 toward the transfer block 5, among wall surfaces forming the first housing. The second housing 2A includes a second load port 10 protruding from a second wall surface perpendicular to the X direction among wall surfaces forming the second housing 2A. The second load port 10 is at the same position as the first load port 9 in the X direction.

In this specification, for the sake of convenience, a direction in which the stocker block 3, the transfer block 5, and the batch processing block 7 are arranged in the batch processing apparatus 1 is referred to as "front-rear direction X". The front-rear direction X is also a direction in which the indexer block 4 and the single-wafer processing block 8 are arranged in the single-wafer processing apparatus 2. The front-rear direction X extends horizontally. Of the front-rear direction X, a direction from the transfer block 5 toward the stocker block 3 in the batch processing apparatus 1 is referred to as "front side". The front side is also a direction from the single-wafer processing block 8 toward the indexer block 4 in the single-wafer processing apparatus 2. A direction opposite to the front side is referred to as "rear side". A direction extending horizontally perpendicular to the front-rear direction X is referred to as "width direction Y". One direction of the "width direction Y" is referred to as "right side" for convenience, and the other direction thereof is referred to as "left side" for convenience. A direction (height direction) perpendicular to the front-rear direction X and the width direction Y is referred to as "vertical direction Z" for convenience. In each drawing, front, rear, right, left, up, and down are appropriately shown for reference.

In the substrate processing system of the present invention, first, the batch processing apparatus 1 performs the batch processing on the substrates W, and the relay apparatus 6 conveys the batch-processed substrates W to the single-wafer processing apparatus 2. The single-wafer processing apparatus 2 then performs the single-wafer processing on the substrates W to complete the entire substrate processing. Hereinafter, specific configurations of the batch processing apparatus 1, the relay apparatus 6, and the single-wafer processing apparatus 2 will be described in this order along a flow of the substrates W in the substrate processing system of the present invention.

### <2. Batch Processing Apparatus: Stoker Block>

The stocker block 3 includes the first load port 9 that is an inlet used when a carrier C is input into the block. The carrier C accommodates the plurality of substrates W in a horizontal attitude at predetermined intervals in the vertical direction. The first load port 9 protrudes from an outer wall of the stocker block 3 extending in the width direction (Y direction).

The plurality of (for example, 25) substrates W in the horizontal attitude are stacked and accommodated at regular intervals in one carrier C. The carrier C accommodating the unprocessed substrates W to be loaded into the batch processing apparatus 1 is first placed on the first load port 9. The carrier C has a plurality of grooves (not illustrated) extending in the horizontal direction to accommodate the substrates W in a state in which surfaces of the substrates Ware separated from each other. One substrate W is inserted into each of the grooves. Examples of the carrier C include a sealed front opening unify pod (FOUP). In the present invention, an opentype container may be adopted as the carrier C.

An internal structure of the stocker block 3 will be described. The stocker block 3 includes a conveyance/accommodation part ACB that stocks and manages the carrier C. The conveyance/accommodation part ACB includes a carrier conveyance mechanism 11 that conveys the carrier C, and a shelf 13 on which the carrier C is placed. The number of carriers C that can be stocked by the stocker block 3 is 1 or more.

The stocker block 3 has a plurality of the shelves 13 on which the carrier C is placed. The shelves 13 are provided on a partition wall separating the stocker block 3 and the transfer block 5. The shelves 13 include a stock shelf 13b on which the carrier C is simply temporarily placed, and a carrier placement shelf 13a for substrate take-out to be accessed by a first substrate conveyance mechanism HTR of the transfer block 5. The carrier placement shelf 13a for substrate take-out/accommodation corresponds to a first carrier placement shelf of the present invention. The carrier placement shelf 13a is configured to place thereon the carrier C from which the substrates W are to be taken out. Although one carrier placement shelf 13a is provided in the present embodiment, a plurality of the carrier placement shelves 13a may be provided. The carrier conveyance mechanism 11 takes in the carrier C accommodating the unprocessed substrates W from the first load port 9, and places the carrier C on the carrier placement shelf 13a for substrate take-out. At this time, the carrier conveyance mechanism 11 can also temporarily place the carrier C on the stock shelf 13b before placing the carrier C on the carrier placement shelf 13a. The number of carrier placement shelves 13a of the stocker block 3 is 1 or more. The first substrate conveyance mechanism corresponds to a substrate handling mechanism of the present invention.

### <3. Batch Processing Apparatus: Transfer Block>

The transfer block 5 is disposed adjacent to the rear side of the stocker block 3. The transfer block 5 includes the first substrate conveyance mechanism HTR, an HVC attitude changer 23, and a pusher mechanism 25. The first substrate conveyance mechanism HTR can access the carrier C placed on the carrier placement shelf 13a for substrate take-out. The HVC attitude changer 23 and the pusher mechanism 25 collectively change the attitudes of the plurality of substrates W from the horizontal attitude to a vertical attitude. The first substrate conveyance mechanism HTR corresponds to the substrate handling mechanism of the present invention. The HVC attitude changer 23 and the pusher mechanism 25 constitute a first attitude changing mechanism 15, and correspond to a first attitude changing mechanism of the present invention. Furthermore, a substrate transfer position PP for transferring the plurality of substrates W to a second substrate conveyance mechanism WTR provided in a collective conveyance region R2 is set in the transfer block 5. The first substrate conveyance mechanism HTR, the HVC attitude changer 23, and the pusher mechanism 25 are arranged in this order in the Y direction.

The first substrate conveyance mechanism HTR is provided on the right side of the rear side of the conveyance/accommodation part ACB of the stocker block 3. The first substrate conveyance mechanism HTR is a mechanism for collectively taking out the plurality of substrates W from the carrier C placed on the carrier placement shelf 13a for substrate take-out/accommodation. The first substrate conveyance mechanism HTR includes a plurality of (for example, 25) hands 51 that collectively convey the plurality of substrates W. Each of the hands 51 supports one substrate W. The first substrate conveyance mechanism HTR collectively takes out the plurality of (for example, 25) substrates W from the carrier C placed on the carrier placement shelf 13a of the stocker block 3. The first substrate conveyance mechanism HTR can convey the plurality of gripped substrates W to a support base 23A of the HVC attitude changer 23. The HVC attitude changer 23 changes the plurality of received substrates W from the horizontal attitude to a vertical attitude. The pusher mechanism 25 is configured to hold the plurality of substrates W in the vertical attitude and move them up, down, left, and right.

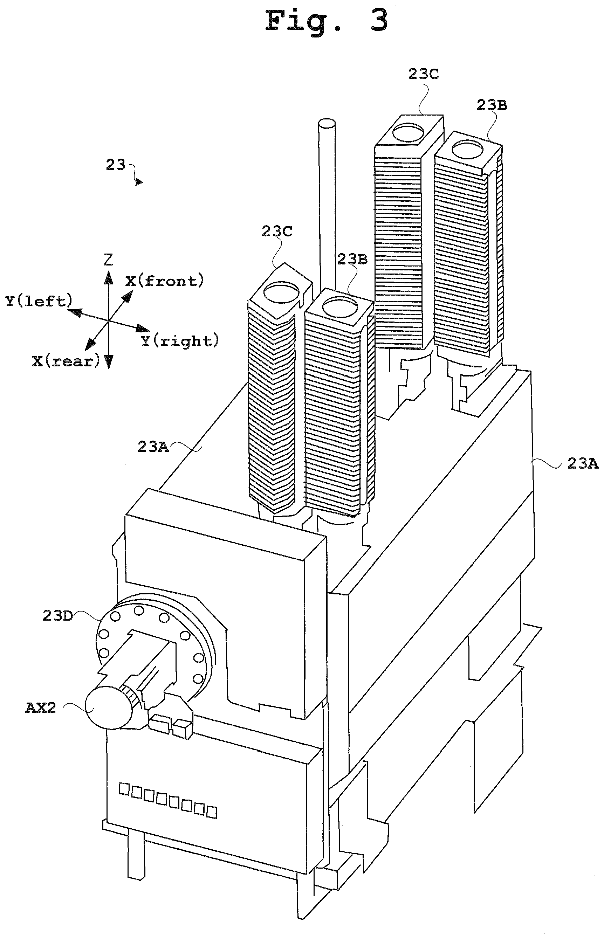

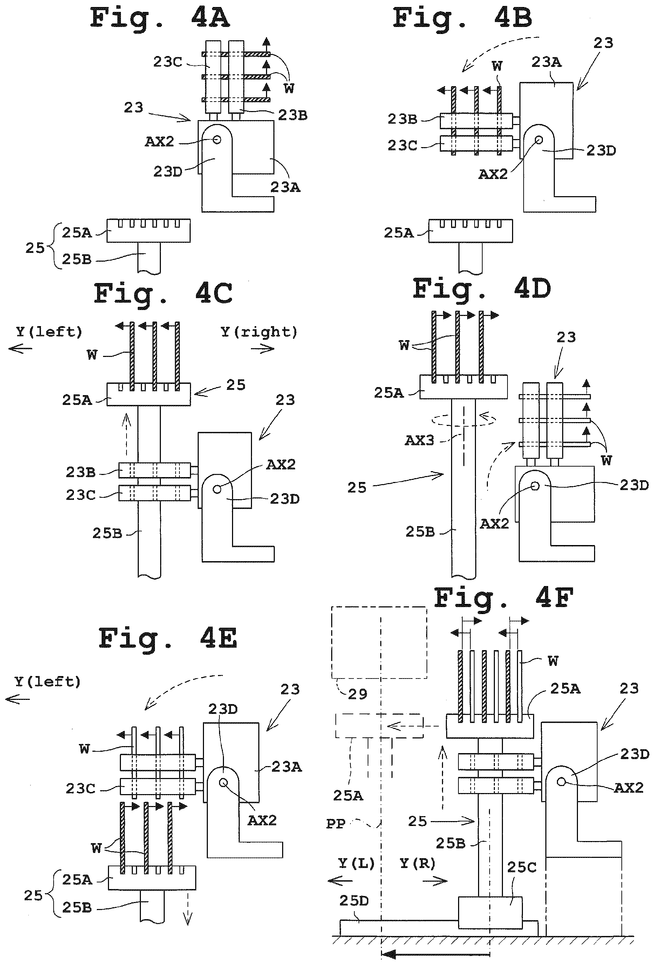

FIG. 3 illustrates the HVC attitude changer 23 of the first embodiment. The HVC attitude changer 23 includes a pair of horizontal holders 23B and a pair of vertical holders 23C extending in a longitudinal direction (Z direction). The support base 23A has a support surface extending in an XY plane to support the horizontal holders 23B and the vertical holders 23C. A rotation drive mechanism 23D is configured to rotate the horizontal holders 23B and the vertical holders 23C by 90° together with the support base 23A. This rotation causes the horizontal holders 23B and the vertical holders 23C to extend in a left-right direction (Y direction). FIGS. 4A to 4F are schematic views illustrating operations of the HVC attitude changer 23. Hereinafter, a configuration of each part will be described with reference to FIGS. 3 and 4A to 4F.

The horizontal holders 23B support the plurality of substrates W in the horizontal attitude from below. That is, the horizontal holders 23B have a comb-shaped structure having a plurality of protrusions corresponding to the substrates W to be supported. An elongated recess in which the periphery of each substrate W is to be positioned is provided between adjacent protrusions. When the periphery of the substrate W is inserted into the recess, the substrate W is supported in the horizontal attitude with a lower surface of the substrate W in the horizontal attitude coming into contact with an upper surface of the protrusion.

The vertical holders 23C support the plurality of substrates W in the vertical attitude from below. That is, the vertical holders 23C have a comb-shaped structure having a plurality of protrusions corresponding to the substrates W to be supported. An elongated V-groove in which the periphery of each substrate W is to be positioned is provided between adjacent protrusions. When the periphery of the substrate W is inserted into the V-groove, the substrate W is held in the V-groove and supported in the vertical attitude. Since the two vertical holders 23C are provided on the support base 23A, the substrate W is held between different V-grooves at two positions of the periphery.

The pair of horizontal holders 23B and the pair of vertical holders 23C extending in the longitudinal direction (Z direction) are provided along a virtual circle corresponding to the substrate W in the horizontal attitude so as to surround the substrate W to be held. The paired horizontal holders 23B are separated from each other by the diameter of the substrate W, and hold one end of the substrate W and another end that is the farthest from the one end. In this way, the paired horizontal holders 23B support the substrates W in the horizontal attitude. On the other hand, the paired vertical holders 23C are separated from each other by a distance shorter than the diameter of the substrate W, and support a predetermined portion of the substrate W and a specific portion positioned near the predetermined portion. In this way, the paired vertical holders 23C support the substrates W in the vertical attitude. The paired horizontal holders 23B are at the same position in the left-right direction (Y direction). The paired vertical holders 23C are at the same position in the left-right direction (Y direction). The pair of vertical holders 23C is provided on a direction (leftward) side to which the support base 23A is rotated and laid down relative to the pair of horizontal holders 23B.

The rotation drive mechanism 23D supports the support base 23A so as to be rotatable by at least 90° around a horizontal shaft AX2 extending in the front-rear direction (X direction). When the support base 23A in a horizontal position is rotated by 90°, the support base 23A assumes a vertical position, and the attitudes of the plurality of substrates W held by the horizontal holders 23B and the vertical holders 23C are changed from the horizontal attitude to the vertical attitude.

As illustrated in FIG. 4F, the pusher mechanism 25 includes a pusher 25A, a raising/lowering rotator 25B, a horizontal mover 25C, and a rail 25D. The substrates W in the vertical attitude can be mounted on the pusher 25A. The raising/lowering rotator 25B rotates and raises and lowers the pusher 25A. The horizontal mover 25C moves the raising/lowering rotator 25B in the left-right direction (Y direction). The rail 25D extends in the left-right direction (Y direction) to guide the horizontal mover 25C. The pusher 25A is configured to support respective lower portions of the plurality of (for example, 50) substrates W in the vertical attitude. The raising/lowering rotator 25B is provided under the pusher 25A, and includes an extensible mechanism that raises and lowers the pusher 25A in an up-down direction. The raising/lowering rotator 25B can also rotate the pusher 25A at least by 180° around a vertical axis. The horizontal mover 25C is configured to support the raising/lowering rotator 25B, and horizontally moves the pusher 25A and the raising/lowering rotator 25B. The horizontal mover 25C can move the pusher 25A from a pick-up position close to the HVC attitude changer 23 to the substrate transfer position PP by being guided by the rail 25D. The horizontal mover 25C can also shift the substrates W in the vertical attitude by a distance corresponding to a half pitch in substrate arrangement on the pusher 25A, in an arrangement direction of the substrates W.

Here, operations of the HVC attitude changer 23 and the pusher mechanism 25 will be described. The HVC attitude changer 23 and the pusher mechanism 25 arrange, for example, a total of 50 substrates W accommodated in two carriers C, at predetermined intervals (for example, 5 mm) in a face-to-face manner. The 25 substrates W in the first carrier C are described as first substrates W1 belonging to a first substrate group. Similarly, the 25 substrates W in the second carrier C are described as second substrates W2 belonging to a second substrate group. In FIGS. 4A to 4F, the number of first substrates W1 is 3, and the number of second substrates W2 is 3 for convenience of drawing.

FIG. 4A illustrates a state in which the first substrates W1 in the horizontal attitude are collectively transferred to the HVC attitude changer 23 from the first substrate conveyance mechanism HTR. At this time, device surfaces (surfaces where a circuit pattern is formed) of the first substrates W1 are directed upward. The 25 first substrates W1 are disposed at predetermined intervals (for example, 10 mm). The interval of 10 mm is called a full pitch (normal pitch). The horizontal holders 23B hold the first substrates W1 in this state. At this time, the pusher 25A is at the pick-up position below the support base 23A.

FIG. 4B illustrates a state when the support base 23A of the HVC attitude changer 23 is rotated by 90° by the rotation drive mechanism 23D. The HVC attitude changer 23 changes the attitudes of the 25 first substrates W1 from the horizontal attitude to the vertical attitude in this manner. The vertical holders 23C hold the first substrates W1 in this state.

FIG. 4C illustrates a state in which the pusher 25A is moved upward from the pick-up position to a position set directly above the pick-up position. The raising/lowering rotator 25B performs this upward movement. When the pusher 25A moves upward from below the first substrates W1 as described above, the first substrates W1 supported by the vertical holders 23C of the HVC attitude changer 23 are pulled out from the vertical holders 23C to move onto the pusher 25A. Grooves for holding the substrates W are provided on an upper surface of the pusher 25A. The first substrates W1 are supported by these grooves arranged at equal intervals. Since the grooves are arranged at the half pitch and the first substrates W1 are arranged at the full pitch in the HVC attitude changer 23, grooves in which the first substrates W1 are held and empty grooves that support no substrate W are alternately arranged on the upper surface of the pusher 25A positioned at the directly-above position.

FIG. 4D illustrates an operation in which the pusher 25A is rotated by 180° by the raising/lowering rotator 25B, and an operation in which the support base 23A of the HVC attitude changer 23 is reversely rotated by 90° by the rotation drive mechanism 23D. The HVC attitude changer 23 in this state can support the second substrates W2. When the pusher 25A is rotated by 180°, the substrate W supported at a right end of the pusher 25A moves to a left end of the pusher 25A, and the empty groove positioned at the left end of the pusher 25A moves to the right end of the pusher 25A. A positional relationship between the HVC attitude changer 23 and the pusher 25A is set such that the substrate W positioned at a right end of the HVC attitude changer 23 is transferred to the right end of the pusher 25A. Thus, the HVC attitude changer 23 can transfer the second substrate W2 at the right end to the groove at the right end of the pusher 25A regardless of the presence of the first substrates W1 supported by the pusher 25A. The same applies to the other second substrates W2 supported by the HVC attitude changer 23. That is, the second substrates W2 arranged at the full-pitch intervals in the HVC attitude changer 23 can be arranged at the full-pitch intervals sequentially from the right end of the pusher 25A. This is because the empty grooves are arranged at the full-pitch intervals starting from the right end in the pusher 25A after rotation. At this time, the first substrates W1 on the pusher 25A are each inserted into a gap between the adjacent second substrates W2 arranged on the pusher 25A. FIG. 4D illustrates a state when the second substrates W2 have already been conveyed to the HVC attitude changer 23. In FIG. 4D, the horizontal holders 23B support the second substrates W2.

When the pusher 25A at the directly-above position in the state of FIG. 4D returns to the original pick-up position, the HVC attitude changer 23 can rotate the support base 23A by 90° again.

FIG. 4E illustrates a state when the support base 23A is actually rotated again. At this time, the pusher 25A has been rotated by 180°. Thus, when the pusher 25A is moved again to the directly-above position as illustrated in FIG. 4F, the second substrates W2 are inserted into the empty grooves each sandwiched between the adjacent first substrates W1 on the upper surface of the pusher 25A without interfering with the first substrates W1. In this way, a lot is formed in which the first substrates W1 and the second substrates W2 are alternately arranged. In FIG. 4E, the vertical holders 23C support the second substrates W2. Since the lot is configured by arranging the substrates W in the face-to-face manner, the device surfaces of the first substrates W1 constituting the lot are all directed rightward in FIG. 4F, and the device surfaces of the second substrates W2 are all directed leftward in FIG. 4F.

FIG. 4F illustrates a state when the pusher 25A moves to the directly-above position again. The lot generated in the pusher 25A is conveyed leftward (Y direction) by the horizontal mover 25C to be moved to the substrate transfer position PP.

In the following description, the substrate arrangement as a processing target may have any configuration. That is, the main parts of the present invention have the same configuration in both of a normal lot (for example, 25 substrates W arranged at the full pitch) and the above-described batch lot. In the following description, the processing target is simply referred to as the lot or the plurality of substrates W.

A dry lot support part 33 is provided mainly for the purpose of allowing the lot obtained by assembling a batch by the HVC attitude changer 23 and the pusher mechanism 25 to temporarily stand by, and is at a position sandwiched between the substrate transfer position PP and the relay apparatus 6 to be described later. To convey the lot from the dry lot support part 33 to the batch processing block 7, the second substrate conveyance mechanism WTR of the batch processing apparatus 1 is used.

### <4. Batch Processing Apparatus: Batch Processing Block>

The batch processing block 7 performs batch processing on the lot described above. The batch processing block 7 is divided into a batch processing region R1 and the collective conveyance region R2 that are arranged in the width direction (Y direction). Each region extends in the front-rear direction (X direction). Specifically, the batch processing region R1 is disposed inside the batch processing block 7. The collective conveyance region R2 is adjacent to the batch processing region R1, and is disposed on the leftmost side of the batch processing block 7.

### <4.1. Batch Processing Region>

The batch processing region R1 in the batch processing block 7 is a rectangular region extending in the front-rear direction (X direction). One end side (front side) of the batch processing region R1 is adjacent to the relay apparatus 6. The other end side of the batch processing region R1 extends in a direction (rear side) away from the transfer block 5 and the relay apparatus 6. Therefore, the relay apparatus 6 is inserted into a position where the batch processing apparatus 1 is divided in the middle. To convey the lot from the batch processing apparatus 1 to the relay apparatus 6, the second substrate conveyance mechanism WTR of the batch processing apparatus 1 is used. Therefore, the collective conveyance region R2, which is a region where the second substrate conveyance mechanism WTR can move, is not divided by the relay apparatus 6 and extends in the Y direction along a left end portion of the relay apparatus 6. The relay apparatus 6 is fitted into the batch processing apparatus 1, but does not reach a left end of the batch processing apparatus 1. This is because the collective conveyance region R2 is provided at the left end of the batch processing apparatus 1.

The batch processing region R1 mainly includes a batch-type processor that performs batch-type processing. Specifically, a batch drying chamber DC that collectively dries the plurality of substrates W, and a plurality of batch processing units BPU1 to BPU6 that collectively immerse the plurality of substrates W in the direction in which the batch processing region R1 extends are arranged in the batch processing region R1. The disposition of the batch drying chamber DC and the batch processing units BPU1 to BPU6 will be specifically described. The batch drying chamber DC is adjacent to the rear side of the relay apparatus 6. The first batch processing unit BPU1 is adjacent to the rear side of the batch drying chamber DC. The second batch processing unit BPU2 is adjacent to the rear side of the first batch processing unit BPU1. The third batch processing unit BPU3 is adjacent to the rear side of the second batch processing unit BPU2. The fourth batch processing unit BPU4 is adjacent to the rear side of the third batch processing unit BPU3. The fifth batch processing unit BPU5 is adjacent to the rear side of the fourth batch processing unit BPU4. The sixth batch processing unit BPU6 is adjacent to the rear side of the fifth batch processing unit BPU5. Therefore, the batch drying chamber DC, the first batch processing unit BPU1, the second batch processing unit BPU2, the third batch processing unit BPU3, the fourth batch processing unit BPU4, the fifth batch processing unit BPU5, and the sixth batch processing unit BPU6 are disposed so as to be separated from the relay apparatus 6 in this order. In FIG. 1, the second batch processing unit BPU2 to the fifth batch processing unit BPU5 are omitted for convenience of drawing. This configuration can be understood by referring to FIG. 2. The batch processing units BPU1 to BPU6 correspond to a batch processing bath of the present invention.

Specifically, the second batch processing unit BPU2 includes a batch chemical treatment bath CHB2 that collectively performs a chemical treatment on the lot, and a lifter LF2 that raises and lowers the lot between a substrate transfer position and a chemical treatment position (see FIG. 2). The substrate transfer position is a position set above the batch chemical treatment bath CHB2 accessible by the second substrate conveyance mechanism WTR. The chemical treatment position is a position set inside the batch chemical treatment bath CHB2 capable of immersing the lot in a chemical solution. The batch chemical treatment bath CHB2 performs an acid treatment on the lot. The acid treatment may be a phosphoric acid treatment, but may be a treatment using another acid. In the phosphoric acid treatment, an etching treatment is performed on the plurality of substrates W constituting the lot. In the etching treatment, for example, a nitride film on the surface of the substrate W is chemically etched.

The batch chemical treatment bath CHB2 stores an acid solution such as a phosphoric acid solution. The batch chemical treatment bath CHB2 is provided with the lifter LF2 that moves the lot up and down. The batch chemical treatment bath CHB2 supplies, for example, a chemical solution upward from below to circulate the chemical solution. The lifter LF2 ascends and descends in the vertical direction (Z direction). Specifically, the lifter LF2 ascends and descends between the treatment position inside the batch chemical treatment bath CHB2 and the transfer position above the batch chemical treatment bath CHB2. The lifter LF2 holds the lot including the substrates W in the vertical attitude. The lifter LF2 transfers the lot to and from the second substrate conveyance mechanism WTR at the transfer position. When the lifter LF2 descends from the transfer position to the treatment position while holding the lot, the entire region of the substrates W is positioned below a solution surface of the chemical solution. When the lifter LF2 ascends from the treatment position to the transfer position while holding the lot, the entire region of the substrates W is positioned above the solution surface of the chemical solution.

Specifically, the third batch processing unit BPU3 includes a batch chemical treatment bath CHB3 and a lifter LF3 that raises and lowers the lot between a substrate transfer position and a chemical treatment position. The batch chemical treatment bath CHB3 has the same configuration as the batch chemical treatment bath CHB2 described above. That is, the batch chemical treatment bath CHB3 stores the above-described chemical solution, and is provided with the lifter LF3. The batch chemical treatment bath CHB3 performs the same treatment as the batch chemical treatment bath CHB2 on the lot. The batch processing apparatus 1 of the present embodiment includes a plurality of treatment baths capable of performing the same chemical treatment. This is because the phosphoric acid treatment takes more time than other treatments. The phosphoric acid treatment requires a long time (for example, 60 minutes). Therefore, the apparatus of the present embodiment can perform the acid treatment in parallel by the plurality of batch chemical treatment baths.

The fourth batch processing unit BPU4 to the sixth batch processing unit BPU6 have the same configuration as the second batch processing unit BPU2 and the third batch processing unit BPU3. That is, the fourth batch processing unit BPU4 includes a batch chemical treatment bath CHB4 and a lifter LF4 that raises and lowers the lot between a substrate transfer position and a chemical treatment position. Similarly, the fifth batch processing unit BPU5 includes a batch chemical treatment bath CHB5 and a lifter LF5 that raises and lowers the lot between a substrate transfer position and a chemical treatment position. The sixth batch processing unit BPU6 includes a batch chemical treatment bath CHB6 and a lifter LF6 that raises and lowers the lot between a substrate transfer position and a chemical treatment position. Therefore, the lot is acid-treated in any one of the batch chemical treatment bath CHB2 to the batch chemical treatment bath CHB6. Performing the chemical treatment in parallel by the five processing units in this manner increases the throughput of the apparatus.

Specifically, the first batch processing unit BPU1 includes a batch rinse treatment bath ONB that stores a rinse solution, and a lifter LF1 that raises and lowers the lot between a substrate transfer position and a rinse position. The substrate transfer position is a position set above the batch rinse treatment bath ONB accessible by the second substrate conveyance mechanism WTR. The rinse position is a position set inside the batch rinse treatment bath ONB capable of immersing the lot in the rinse solution. The batch rinse treatment bath ONB has the same configuration as the above-described batch chemical treatment bath CHB2. That is, the batch rinse treatment bath ONB stores the rinse solution, and is provided with the lifter LF1. Unlike the other treatment baths, the batch rinse treatment bath ONB stores pure water, and is provided for the purpose of cleaning the chemical solution adhering to the plurality of substrates W. When specific resistance of pure water in the batch rinse treatment bath ONB increases to a predetermined value, the cleaning treatment ends. The pure water stored in the batch rinse treatment bath ONB only has to have a purity degree enough to perform a batch rinse treatment on the substrates W.

As described above, the batch rinse treatment bath ONB in the present embodiment is positioned closer to the relay apparatus 6 than the batch chemical treatment bath CHB2 to the batch chemical treatment bath CHB6. With such a configuration, each mechanism constituting the relay apparatus 6 and the batch chemical treatment bath CHB2 to the batch chemical treatment bath CHB6 are separated as much as possible, so that the relay apparatus 6 is not adversely affected by acid such as phosphoric acid. Since the relay apparatus 6 and the batch rinse treatment bath ONB are disposed close to each other, the rinse-treated lot is conveyed only by a short distance and immediately carried into the relay apparatus 6. Therefore, according to the configuration of the present embodiment, it is possible to quickly complete the conveyance of the substrates W while maintaining a wet state of the substrates W.

The batch drying chamber DC is disposed at a position sandwiched between the first batch processing unit BPU1 and the relay apparatus 6. The batch drying chamber DC includes a drying chamber that accommodates the lot in which the substrates W in the vertical attitude are arranged. The drying chamber includes an inert gas supply nozzle that supplies an inert gas into the chamber, and a vapor supply nozzle that supplies vapor of an organic solvent into the chamber. The batch drying chamber DC first supplies an inert gas to the lot supported in the chamber to replace the atmosphere in the chamber with the inert gas. The inside of the chamber then starts to be depressurized. In a state in which the inside of the chamber is depressurized, vapor of an organic solvent is supplied into the chamber. The organic solvent is discharged to the outside of the chamber together with moisture adhering to the substrates W. The batch drying chamber DC dries the lot in this way. The inert gas may be, for example, nitrogen. The organic solvent may be, for example, isopropyl alcohol (IPA).

### <4.2 Collective Conveyance Region>

The collective conveyance region R2 in the batch processing block 7 is a rectangular region extending in the front-rear direction (X direction). The collective conveyance region R2 is provided along an outer edge of the batch processing region R1, and has one end side extending to the transfer block 5 and the other end side extending in a direction away from the transfer block 5. Therefore, the collective conveyance region R2 is configured along the relay apparatus 6 as well at a position sandwiched between the transfer block 5 and the batch processing block 7.

The collective conveyance region R2 is provided with the second substrate conveyance mechanism WTR that collectively conveys the plurality of substrates W. The second substrate conveyance mechanism WTR collectively conveys the plurality of substrates W (specifically, the lot) among the substrate transfer position PP defined in the transfer block 5, the dry lot support part 33, the batch drying chamber DC, the respective batch processing units BPU1 to BPU6, and a carry-in position IP in the relay apparatus 6 to be described later. The second substrate conveyance mechanism WTR can reciprocate in the front-rear direction (X direction) across the transfer block 5, the relay apparatus 6, and the batch processing block 7. The second substrate conveyance mechanism WTR is movable not only to the batch processing region R1 in the batch processing block 7, but also to the substrate transfer position PP and the dry lot support part 33 in the transfer block 5, and the carry-in position IP in the relay apparatus 6. The second substrate conveyance mechanism WTR corresponds to a collective conveyance mechanism of the present invention.

The second substrate conveyance mechanism WTR includes a pair of chucks 29 that conveys the lot. The pair of chucks 29 can be changed between a closed state in which the chucks are close to each other, and an open state in which the chucks are away from each other. Each chuck 29 is a member extending in the Y direction and in which grooves for gripping the substrates Ware arranged at the half pitch. The pair of chucks 29 is closed to receive the plurality of substrates W constituting the lot. The pair of chucks 29 is opened to transfer the plurality of substrates W constituting the lot to another member (the lifter LF1 or the like). The second substrate conveyance mechanism WTR transfers the lot to and from the substrate transfer position PP and the dry lot support part 33 in the transfer block 5, and a lifter LF65 belonging to a substrate standby bath 65 provided at the carry-in position IP in the relay apparatus 6. In addition, the second substrate conveyance mechanism WTR transfers the lot to and from each of the lifters LF1 to LF6 belonging to the batch processing units BPU1 to BPU6 and the batch drying chamber DC in the batch processing block 7.

The collective conveyance region R2 is provided with a guide rail 31X extending in the X direction to guide the second substrate conveyance mechanism WTR. The second substrate conveyance mechanism WTR is movable back and forth in the X direction along the guide rail 31X. Therefore, the guide rail 31X extends from the batch processing block 7 to the transfer block 5 through the relay apparatus 6. More specifically, the guide rail 31X faces the substrate transfer position PP in the transfer block 5 from the Y direction, and faces the sixth batch processing unit BPU6 in the batch processing block 7 from the Y direction. In addition, the guide rail 31X faces the dry lot support part 33 in the transfer block 5, the substrate standby bath 65 in the relay apparatus 6, and the batch drying chamber DC and the first batch processing unit BPU1 to the sixth batch processing unit BPU6 in the batch processing block 7, from the Y direction.

### <5. Relay Apparatus>

The relay apparatus 6 has a structure to bridge between the batch processing apparatus 1 and the single-wafer processing apparatus 2, and has a left end portion fitted into the batch processing apparatus 1 and a right end portion fitted into the single-wafer processing apparatus 2. The relay apparatus 6 includes a conveyance path for the substrates W that extends in the Y direction to connect the collective conveyance region R2 of the batch processing apparatus 1 and a single-wafer conveyance region R3 of the single-wafer processing apparatus 2. The conveyance path is configured to convey the substrates W in the Y direction (horizontally) without changing a position in the Z direction of the substrates W. Therefore, an insertion position of the relay apparatus 6 into the batch processing apparatus 1 and an insertion position of the relay apparatus 6 into the single-wafer processing apparatus 2 are at the same position in the Z direction.

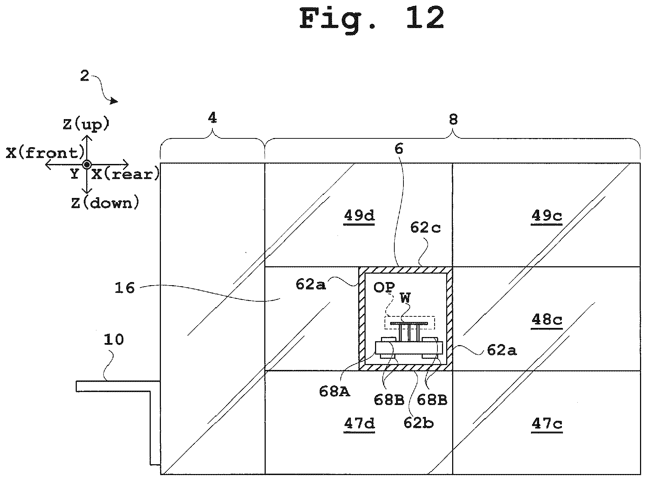

The relay apparatus 6 is positioned in a middle layer of the batch processing apparatus 1 and the single-wafer processing apparatus 2 (see FIG. 12). Therefore, the relay apparatus 6 bridges between the batch processing apparatus 1 and the single-wafer processing apparatus 2 at a position in the air away from a floor surface on which the batch processing apparatus 1 and the single-wafer processing apparatus 2 are installed. Since a specific position of the relay apparatus 6 is related to a structure of the single-wafer processing apparatus 2, the specific position will be described in detail along with a description of the single-wafer processing apparatus 2.

The relay apparatus 6 includes a relay housing 6A that connects the first housing 1A of the batch processing apparatus 1 and the second housing 2A of the single-wafer processing apparatus 2 separated from each other in the Y direction. The relay housing 6A is provided between a third wall surface 1B and a fourth wall surface 2B, the third wall surface 1B facing the second housing 2A among the wall surfaces forming the first housing 1A, and the fourth wall surface 2B facing the third wall surface 1B among the wall surfaces forming the second housing 2A. The third wall surface corresponds to a perpendicular wall surface of the present invention. The fourth wall surface corresponds to a perpendicular wall surface of the present invention.

The relay housing 6A includes a side wall 62a, a bottom plate 62b, and a top plate 62c that connect the batch processing apparatus 1 and the single-wafer processing apparatus 2. Configurations of the side wall 62a, the bottom plate 62b, and the top plate 62c are shown in detail in FIGS. 2 and 12. The relay housing 6A connects the housings of the batch processing apparatus 1 and the single-wafer processing apparatus 2 to constitute one substrate processing system. As a result, the substrate processing system has a configuration in which the atmosphere in the apparatus is isolated from the outside air. The relay housing 6A extends from a first shutter S 1 to a second shutter S2. Therefore, when the first shutter S1 is closed, the batch processing apparatus 1 is isolated from a space on the right side of the first shutter S1 in the relay apparatus 6. The first shutter corresponds to a batch processing apparatus-side shutter of the present invention. The second shutter corresponds to a single-wafer processing apparatus-side shutter of the present invention.

The relay apparatus 6 includes the substrate standby bath 65, an underwater attitude changer 55, a first belt conveyor mechanism 67, and a second belt conveyor mechanism 68. The substrate standby bath 65 allows the batch-processed lot to stand by in pure water. The underwater attitude changer 55 receives the plurality of substrates W arranged in the Y direction, and collectively rotates the received substrates W by 90° in water to change the attitudes of the plurality of substrates W from the vertical attitude to a horizontal attitude. The first belt conveyor mechanism 67 conveys the substrates W one by one in the Y direction. The second belt conveyor mechanism 68 conveys the substrates W conveyed by the first belt conveyor mechanism 67 in the Y direction and sends the substrates W to a carry-out position OP. The substrate standby bath 65, the underwater attitude changer 55, the first belt conveyor mechanism 67, and the second belt conveyor mechanism 68 are arranged in this order in the right direction starting from the left of the batch processing apparatus 1. Hereinafter, each part will be specifically described. The underwater attitude changer 55 corresponds to a second attitude changing mechanism of the present invention. The first belt conveyor mechanism 67 and the second belt conveyor mechanism 68 correspond to a relay conveyance mechanism of the present invention.

### <5.1. Relay Apparatus: Substrate Standby Bath>

The substrate standby bath 65 has the same configuration as the first batch processing unit BPU1 of the batch processing apparatus 1. That is, the substrate standby bath 65 holds pure water, and includes the lifter LF65 that raises and lowers the lot. The lifter LF65 can reciprocate between the carry-in position IP for carrying the lot into the relay apparatus 6, and an immersion position for immersing the carried-in lot in pure water. The carry-in position IP is positioned above the immersion position, and is a position to which the second substrate conveyance mechanism WTR can convey the substrates. The carry-in position IP is set such that the entire region of the substrates W constituting the lot is in the air. The immersion position is set such that the entire region of the substrates W constituting the lot is immersed in pure water.

### <5.2. Relay Apparatus: Full-Pitch Arrangement Substrate Conveyance Mechanism>

A full-pitch arrangement substrate conveyance mechanism STR can convey 25 substrates arranged at the full pitch between the substrate standby bath 65 and the underwater attitude changer 55. In the substrate standby bath 65, 50 substrates arranged at the half pitch are on standby. The full-pitch arrangement substrate conveyance mechanism STR picks up 25 substrates, half of the 50 substrates, and conveys the 25 substrates to the underwater attitude changer 55. The full-pitch arrangement substrate conveyance mechanism STR includes a pair of chucks 30 similar to the pair of chucks 29 in the second substrate conveyance mechanism WTR. Each chuck 30 has grooves formed at the half-pitch intervals similarly to each chuck 29, but is different from the chuck 29 in that two types of grooves are alternately arranged. That is, in the chuck 30, deep grooves that are unable to grip the substrates and shallow grooves that grip the substrates are alternately arranged at the half-pitch intervals. Therefore, when the lot in the lifter LF65 is to be gripped by the full-pitch arrangement substrate conveyance mechanism STR, the 25 substrates Ware picked up by the shallow grooves capable of gripping the substrates W, and the remaining 25 substrates are left in the lifter LF65 without abutting on the deep grooves. Since the shallow grooves in the chucks 30 are arranged at a pitch (full pitch) that is twice the half pitch, the full-pitch arrangement substrate conveyance mechanism STR picks up the 25 substrates W arranged at the full pitch from the lot in the lifter LF65. The lot includes the substrates W arranged in the face-to-face manner. Thus, the picked-up substrates W are arranged such that their front surfaces (device surfaces) are on the right side and their back surfaces are on the left side so as not to cause the device surfaces of the adjacent substrates W to face each other. On the other hand, the 25 substrates W left in the lifter LF65 without being picked up are arranged such that their front surfaces (device surfaces) are on the left side and their back surfaces are on the right side so as not to cause the device surfaces of the adjacent substrates W to face each other.

Similarly to the chucks 29 of the second substrate conveyance mechanism WTR, the pair of chucks 30 of the full-pitch arrangement substrate conveyance mechanism STR can assume two states: a closed state in which the chucks 30 are close to each other in the X direction, and an open state in which the chucks 30 are away from each other in the X direction. When the pair of chucks 30 is closed, the chucks 30 are sufficiently close to each other relative to the diameter of each substrate W. Thus, two points in the lower portion of the substrate W abut on the respective chucks 30. The pair of chucks 30 grips the substrates W in this way. When the pair of chucks 30 in the closed state is opened, the chucks 30 are sufficiently separated from each other relative to the diameter of each substrate W. Thus, the substrates Ware detached from the chucks 30. Specifically, the pair of chucks 30 is opened before receiving the plurality of substrates W from the lifter LF65 at the carry-in position IP, and after transferring the plurality of substrates W to a pusher 55A to be described later at a position above an immersion bath to be described later.

The relay apparatus 6 is provided with a guide rail 31Y extending in the Y direction to guide the full-pitch arrangement substrate conveyance mechanism STR. The full-pitch arrangement substrate conveyance mechanism STR is movable from side to side in the Y direction along the guide rail 31Y Therefore, the guide rail 31Y extends from the substrate standby bath 65 to the underwater attitude changer 55.

The full-pitch arrangement substrate conveyance mechanism STR is guided by the guide rail 31Y to be movable from side to side in the Y direction between the carry-in position IP, which is a position where the full-pitch arrangement substrate conveyance mechanism STR transfers the lot of the lifter LF65, and the position above the immersion bath where the pusher 55A to be described later included in the underwater attitude changer 55 receives the plurality of substrates W. As a result, the full-pitch arrangement substrate conveyance mechanism STR can convey the plurality of substrates W in the Y direction from the carry-in position IP to the position above the immersion bath. When the second substrate conveyance mechanism WTR moves from the transfer block 5 to the batch processing block 7, the full-pitch arrangement substrate conveyance mechanism STR can also move to the position above the immersion bath so as not to interfere with the second substrate conveyance mechanism WTR (see FIG. 2).

### <5.3. Relay Apparatus: Underwater Attitude Changer>

The underwater attitude changer 55 includes an immersion bath 73 that holds pure water, the pusher 55A positioned on a bottom surface of the immersion bath 73, and an in-bath carrier 71 that is immersed in the immersion bath 73. The pusher 55A can ascend and descend between a substrate transfer position with the full-pitch arrangement substrate conveyance mechanism STR set above a liquid surface of the immersion bath 73 and the bottom surface of the immersion bath 73. The in-bath carrier 71 can receive the plurality of substrates W supported by the pusher 55A and rotate 90° in one direction or an opposite direction in this state. The attitudes of the plurality of substrates W in the vertical attitude are changed to a horizontal attitude by the rotation of the in-bath carrier 71.

### <5.4. Relay Apparatus: Belt Conveyor Mechanism>

The first belt conveyor mechanism 67 is a substrate conveyance mechanism having an elongated shape in the Y direction, and having one end extending to the underwater attitude changer 55 and the other end extending to the single-wafer processing apparatus 2. The first belt conveyor mechanism 67 receives the substrates W in the horizontal attitude one by one from the underwater attitude changer 55, and conveys the substrates W to the single-wafer processing apparatus 2. The second belt conveyor mechanism 68 is a substrate conveyance mechanism having an elongated shape in the Y direction, and having one end extending to the other end of the first belt conveyor mechanism 67 and the other end extending to the carry-out position OP of the relay apparatus 6. The second belt conveyor mechanism 68 receives the substrates W in the horizontal attitude conveyed by the first belt conveyor mechanism 67 one by one, and conveys the substrates W to the carry-out position OP set at the end of the relay apparatus 6. The first belt conveyor mechanism corresponds to the relay conveyance mechanism of the present invention.

The first belt conveyor mechanism 67 and the second belt conveyor mechanism 68 constitute the substrate conveyance mechanism that cooperatively conveys the substrates W from the underwater attitude changer 55 to the carry-out position OP. Therefore, the substrate conveyance mechanism includes the plurality of belt conveyor mechanisms. A side wall forming the second housing 2A of the single-wafer processing apparatus 2 is positioned at a position where the first belt conveyor mechanism 67 and the second belt conveyor mechanism 68 face each other. Therefore, when a plateshaped member is provided between the first belt conveyor mechanism 67 and the second belt conveyor mechanism 68, the single-wafer processing apparatus 2 can be separated from the batch processing apparatus 1. Such separation of the apparatuses is achieved by the second shutter S2 provided between the first belt conveyor mechanism 67 and the second belt conveyor mechanism 68. The configuration in which the single-wafer processing apparatus 2 is separated from the batch processing apparatus 1 is advantageous because the substrate processing can be completed only by the single-wafer processing apparatus 2 without using the batch processing apparatus 1. Since the present embodiment is based on a configuration in which the substrates W subjected to the batch processing by the batch processing apparatus 1 are conveyed to and processed in the single-wafer processing apparatus 2, the following description will be given assuming that the second shutter S2 is opened.

In addition, the relay apparatus 6 includes a plurality of shower heads 69 arranged along the first belt conveyor mechanism 67. The shower heads 69 are configured to spray pure water having a purity degree similar to that of pure water held in the immersion bath 73, toward the substrates being conveyed. The side wall 62a, the bottom plate 62b, and the top plate 62c forming the relay housing 6A are configured to surround the first belt conveyor mechanism 67 provided at a position to bridge between the batch processing apparatus 1 and the single-wafer processing apparatus 2. The shower heads 69 are connected to a pure water supply device that supplies pure water through a pipe. The pure water supply device may be provided outside the relay apparatus 6 or inside the relay apparatus 6. The shower heads 69 correspond to a liquid supply part of the present invention.

### <5.5. Operation of Relay Apparatus>

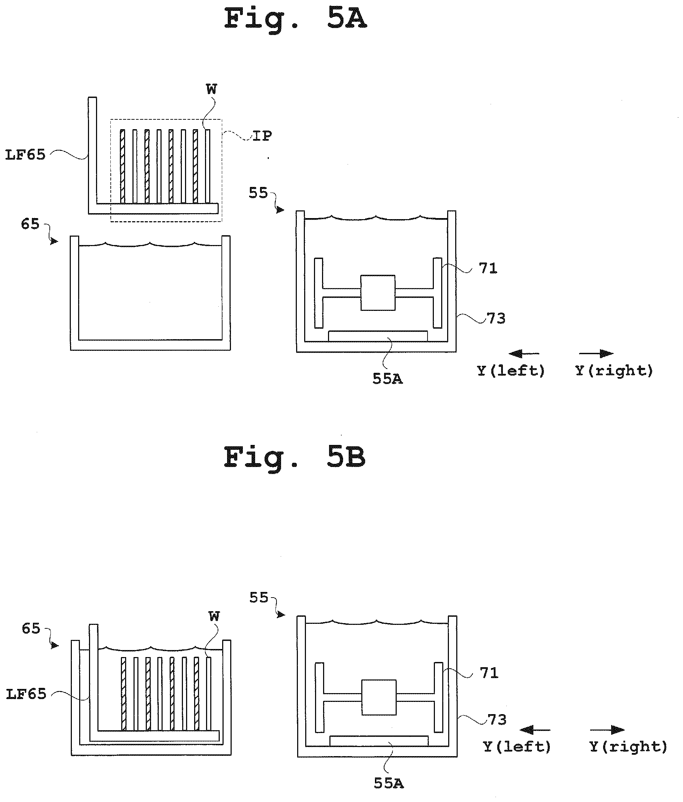

A state in which the relay apparatus 6 conveys the substrates W at the carry-in position IP to the carry-out position OP will be described. FIG. 5A illustrates a state in which the lifter LF65 holds the plurality of substrates W at the carry-in position IP set above the substrate standby bath 65. The second substrate conveyance mechanism WTR conveys the substrates to the carry-in position IP. The plurality of substrates W placed on the lifter LF65 are arranged in the face-to-face manner in which the substrates W with their device surfaces directed rightward and the substrates W with their device surfaces directed leftward are alternately arranged.

FIG. 5B illustrates a state when the lifter LF65 then descends from the carry-in position IP to the immersion position. In this way, the relay apparatus 6 can prevent the substrates waiting to be conveyed from drying out while the substrates W acquired at the carry-in position IP are being conveyed one by one.

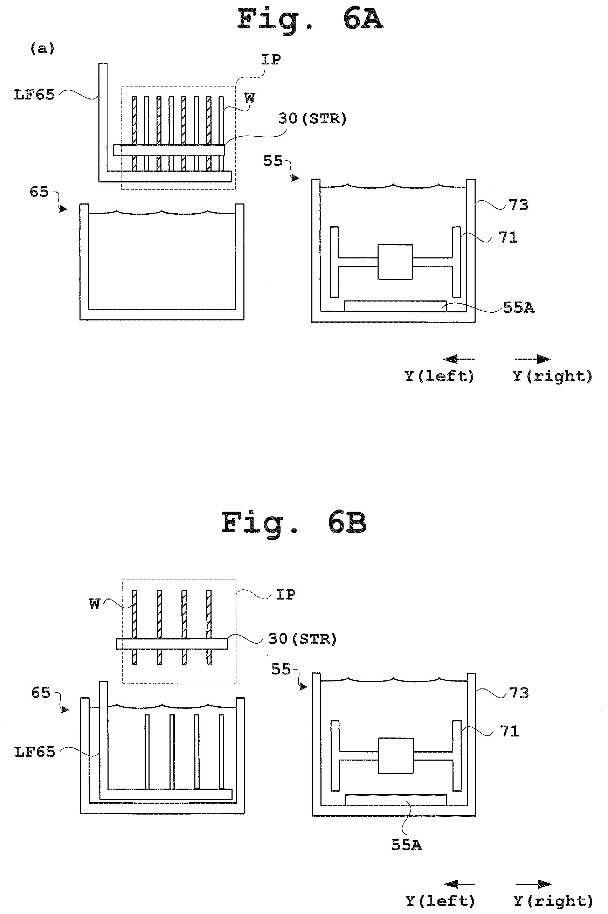

FIG. 6A illustrates a state in which the plurality of substrates W are then collectively transferred from the lifter LF65 to the full-pitch arrangement substrate conveyance mechanism STR so as to convey the plurality of substrates to the underwater attitude changer 55. At this time, the lifter LF65 supports the plurality of substrates W at the carry-in position IP, and the full-pitch arrangement substrate conveyance mechanism STR moves the pair of chucks 30 to a position capable of holding the lot, and closes the chucks 30. At this time, the chucks 30 can grip only half of the plurality of substrates W constituting the lot and arranged at the half pitch as described above. As a result, the substrates W held by the chucks 30 and the substrates W not held by the chucks 30 are alternately arranged in the lot.

FIG. 6B illustrates a state when the lifter LF65 then descends from the carry-in position IP to the immersion position. When the lifter LF65 is lowered from the state of FIG. 6A, the plurality of substrates W corresponding to half of the substrates W constituting the lot and arranged at the full pitch are left in the full-pitch arrangement substrate conveyance mechanism STR, and the remaining half of the substrates are returned to the substrate standby bath 65 in a state of being arranged at the full pitch in the lifter LF65. The device surfaces of the plurality of substrates W left in the full-pitch arrangement substrate conveyance mechanism STR are directed rightward, whereas the device surfaces of the plurality of substrates W held by the lifter LF65 at the immersion position are directed leftward.

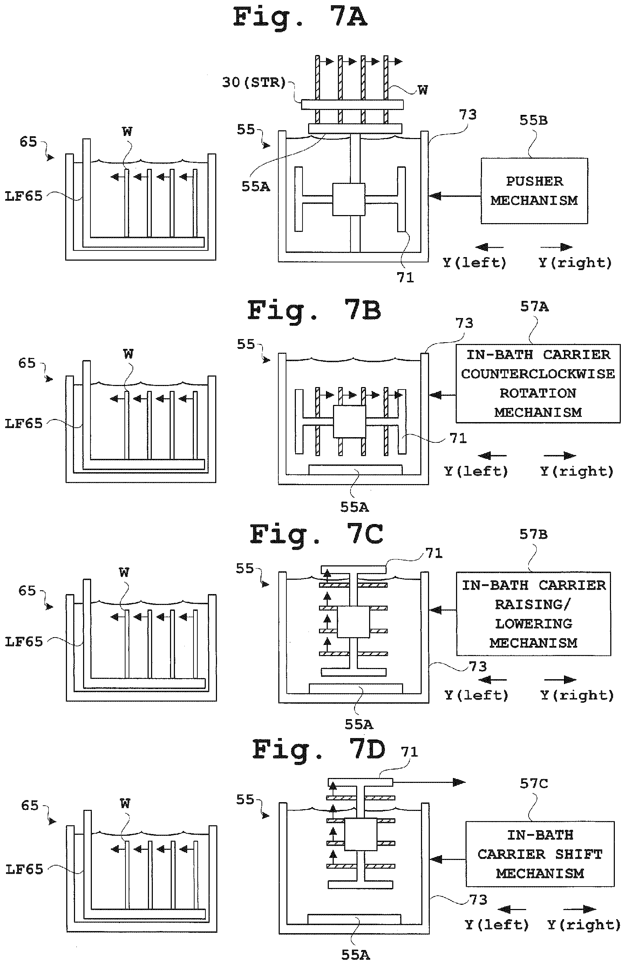

FIG. 7A illustrates a state when the full-pitch arrangement substrate conveyance mechanism STR then moves from the carry-in position IP to the underwater attitude changer 55 positioned on the downstream side of the substrate conveyance. When the pusher 55A of the underwater attitude changer 55 is raised in this state, the pusher 55A is positioned above the immersion bath 73 of the underwater attitude changer 55 as illustrated in FIG. 7A. The pusher 55A can collectively receive the plurality of substrates W arranged at the full pitch from the full-pitch arrangement substrate conveyance mechanism STR on the spot. The ascending and descending action of the pusher 55A is achieved by a pusher mechanism.

FIG. 7B illustrates a state when the pair of chucks 30 in the full-pitch arrangement substrate conveyance mechanism STR is then opened and separated from the pusher 55A. The pusher 55A in this drawing returns to the bottom surface of the immersion bath 73. In this case, the plurality of substrates W held by the pusher 55A do not reach the bottom surface of the immersion bath 73. This is because the in-bath carrier 71 stands by inside the immersion bath 73. The in-bath carrier 71 can hold the plurality of substrates W arranged at the full-pitch intervals. Therefore, when the pusher 55A positioned in the air is lowered, the plurality of substrates W held by the pusher 55A are transferred to the in-bath carrier 71 positioned above the bottom surface of the immersion bath 73. The in-bath carrier 71 is at the immersion position defined in the immersion bath 73 capable of immersing a plurality of substrates in a liquid.

The in-bath carrier 71 can rotate counterclockwise while holding the plurality of substrates W. The rotation axis extends in the X direction, and the rotation angle is 90°. The rotation of the in-bath carrier 71 is achieved by an in-bath carrier counterclockwise rotation mechanism 57A. The plurality of substrates W are rotated below the liquid surface of the immersion bath 73. Therefore, the plurality of substrates W maintain the state of being immersed in the immersion bath 73 during rotation.

FIG. 7C illustrates a state in which the counterclockwise rotation of the in-bath carrier 71 is completed. When the in-bath carrier 71 is rotated counterclockwise by 90°, the plurality of substrates W held by the in-bath carrier 71 are also rotated counterclockwise by 90° in association therewith. This changes the attitudes of the plurality of substrates W held by the in-bath carrier 71 from the vertical attitude to the horizontal attitude as illustrated in FIG. 7C. The device surfaces of the plurality of substrates W directed rightward are directed upward by changing the attitudes.

The in-bath carrier 71 rotated counterclockwise can ascend and descend while holding the plurality of substrates W. The ascending and descending motion of the in-bath carrier 71 is achieved by an in-bath carrier raising/lowering mechanism 57B. When the in-bath carrier 71 is raised from the immersion position of the immersion bath 73, the plurality of substrates W in the horizontal attitude stacked in the vertical direction are raised in association therewith. The present embodiment is configured to convey the substrates in the horizontal attitude one by one to the single-wafer processing apparatus 2. In order to realize this operation, the in-bath carrier raising/lowering mechanism 57B moves one substrate W positioned at an upper end of the in-bath carrier 71 onto the liquid surface of the immersion bath 73. Since the in-bath carrier 71 is configured to hold the 25 substrates W arranged at the full pitch, the remaining 24 substrates W held by the in-bath carrier 71 are all below the liquid surface of the immersion bath 73. In this way, the relay apparatus 6 can prevent the substrates W waiting to be conveyed from drying out while the substrates held by the in-bath carrier 71 are being conveyed one by one.

FIG. 7D illustrates a state in which the raising operation of the in-bath carrier 71 is finished. An in-bath carrier shift mechanism 57C moves the in-bath carrier 71 in the Y direction in a state in which the substrate W at the uppermost position among the plurality of held substrates W is positioned above the liquid surface of the immersion bath 73. In this way, the in-bath carrier 71 approaches a right end of the immersion bath 73, and the substrate W at the uppermost position can be easily carried into the first belt conveyor mechanism 67 described below.

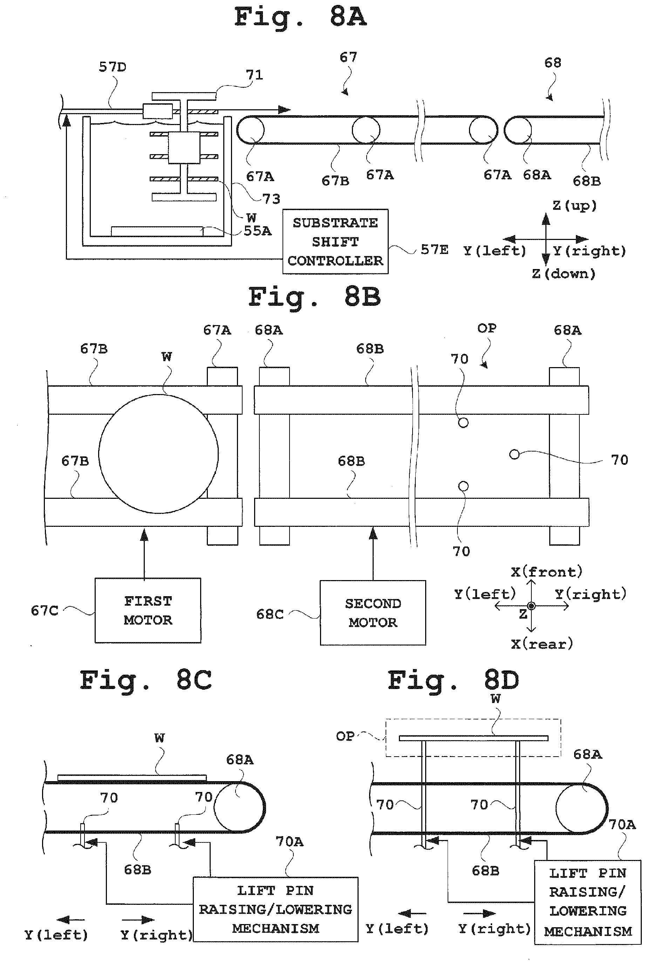

FIG. 8A illustrates a state in which the shift operation of the in-bath carrier 71 is finished. A substrate shift mechanism 57D can move from side to side in the Y direction, and has a plurality of tabs that can grip the substrate W at its distal end. In an initial state, the distal end of the substrate shift mechanism 57D is positioned on the left side of a left end of the immersion bath 73 so as not to interfere with the pusher 55A positioned on the bottom surface of the immersion bath 73. As illustrated in FIG. 8A, when the in-bath carrier 71 is positioned at the right end of the immersion bath 73, the substrate shift mechanism 57D extends rightward from the initial position and grips the substrate W at the uppermost position, which is the only substrate W held in the air, among the substrates W held by the in-bath carrier 71. The substrate shift mechanism 57D further extends rightward from this state to deliver the substrate W to the first belt conveyor mechanism 67. The substrate shift mechanism 57D finishes gripping the substrate W and returns to the initial position. Therefore, the substrate W gripped by the substrate shift mechanism 57D is placed on the first belt conveyor mechanism 67. Such an operation of the substrate shift mechanism 57D is achieved by a substrate shift mechanism controller 57E. The substrate shift mechanism corresponds to a single-wafer substrate shift mechanism of the present invention.

The first belt conveyor mechanism 67 extends in the Y direction from the immersion bath 73 to the second belt conveyor mechanism 68, and can convey the substrate W in the horizontal attitude in the Y direction from the left side to the right side. The first belt conveyor mechanism 67 includes a plurality of rollers 67A extending in the X direction and a belt 67B supported by the rollers 67A. The belt 67B can pass through an upper layer of the roller group and is turned to a lower layer of the roller group by being guided by the most-distal roller 67A positioned on the right side. The belt 67B that has passed through the lower layer of the roller group can then be turned to the upper layer of the roller group again by being guided by the mostproximal roller 67A positioned on the left side.

FIG. 8B illustrates a state in which the substrate W in the horizontal attitude is conveyed to a distal end of the first belt conveyor mechanism 67 by the first belt conveyor mechanism 67. The first belt conveyor mechanism 67 includes two belts: the belt 67B that supports one end of the substrate W and the belt 67B that supports another end of the substrate W. The substrate W is conveyed rightward by the two belts moving in the same direction at the same speed, and is then further conveyed rightward by the second belt conveyor mechanism 68. This conveyance of the substrate W is performed by a first motor 67C rotating the roller 67A. The first motor 67C drives at least one of the rollers 67A constituting the first belt conveyor mechanism 67 to move the belts 67B. The substrate processing system of the present embodiment may include one first motor 67C to collectively drive one or the plurality of rollers 67A, or may include a plurality of the first motors 67C to individually drive the plurality of rollers 67A.

The second belt conveyor mechanism 68 has substantially the same configuration as the first belt conveyor mechanism 67. That is, the second belt conveyor mechanism 68 extends in the Y direction from a right end of the first belt conveyor mechanism 67 to the carry-out position OP defined in the single-wafer processing apparatus 2, and can convey the substrate W in the horizontal attitude in the Y direction from the left side to the right side. The second belt conveyor mechanism 68 is similar to the first belt conveyor mechanism 67 in including a plurality of rollers 68A extending in the X direction, including two belts 68B supporting the two ends of the substrate W, the operation of the belts 68B with respect to the roller group, and the movement of the two belts in the same direction at the same speed. Similarly to the first motor 67C of the first belt conveyor mechanism 67, the conveyance of the substrate W by the second belt conveyor mechanism 68 is executed by one or a plurality of second motors 68C driving one or the plurality of rollers 68A.

A lift pin 70 provided at the carry-out position OP defined in the relay apparatus 6 will be described. At the carry-out position OP of the relay apparatus 6, a plurality of the lift pins 70 are provided in a gap between the two belts of the second belt conveyor mechanism 68. The three lift pins 70 are pins extending in the Z direction, and can freely protrude from and retract into the bottom plate 62b of the relay apparatus 6. When the lift pins 70 are in a contracted state, distal ends of the lift pins 70 are positioned below the substrate W conveyed on the second belt conveyor mechanism 68 as illustrated in FIG. 8C. When the lift pins 70 are in an extended state, the distal ends of the lift pins 70 support a lower surface of the substrate W conveyed on the second belt conveyor mechanism 68, to convey the substrate W to the carry-out position OP set above the second belt conveyor mechanism 68 as illustrated in FIG. 8D. Since the protruding and retracting actions of the lift pins 70 are synchronized among the plurality of lift pins 70, the substrate W positioned at a right end of the second belt conveyor mechanism 68 is raised while maintaining the horizontal attitude. Such an operation of the lift pins 70 is achieved by a lift pin raising/lowering mechanism 70A. The number of lift pins 70 is 3 because it is necessary to maintain the horizontal attitude of the substrate W. In an embodiment, four or more lift pins 70 may be adopted.

FIG. 8D illustrates a state when the substrate W is moved to the carry-out position OP by the lift pins 70. The carry-out position OP of the relay apparatus 6 is defined above the right end of the second belt conveyor mechanism 68. The substrate W delivered from the first belt conveyor mechanism 67 is moved in the Y direction by the second belt conveyor mechanism 68, and then moved in the Z direction by the three lift pins 70 to reach the carry-out position OP.

While the substrate W is being raised to the carry-out position OP by the lift pins 70, the second belt conveyor mechanism 68 is suspended. That is, the second belt conveyor mechanism 68 is configured to convey the substrate W received from the first belt conveyor mechanism 67 to a predetermined position directly below the carry-out position OP and stop. The lift pins 70 are configured to raise the substrate W at the predetermined position to the carry-out position OP and stop. With such a configuration, the substrate W can surely be supported by the lift pins 70.

The substrate W delivered to the carry-out position OP is gripped by a center robot CR of the single-wafer processing apparatus 2, and conveyed to a single-wafer processing chamber. In this manner, the substrate W at the carry-out position OP is immediately conveyed to the single-wafer processing chamber without staying there for a long time. The carry-out position OP becomes empty and can receive the subsequent substrate W. The center robot corresponds to a single-wafer conveyance mechanism of the present invention.

It has been described how the first substrate W among the substrates W constituting the lot is conveyed by the relay apparatus 6. That is, when the substrate W is conveyed sequentially from FIGS. 5A to 8D, the 25 substrates W in the vertical attitude in the substrate standby bath 65 are immersed in pure water, and the 24 substrates W in the horizontal attitude in the immersion bath 73 of the underwater attitude changer 55 are immersed in pure water. Hereinafter, a method of conveying the remaining 49 substrates W will be described.

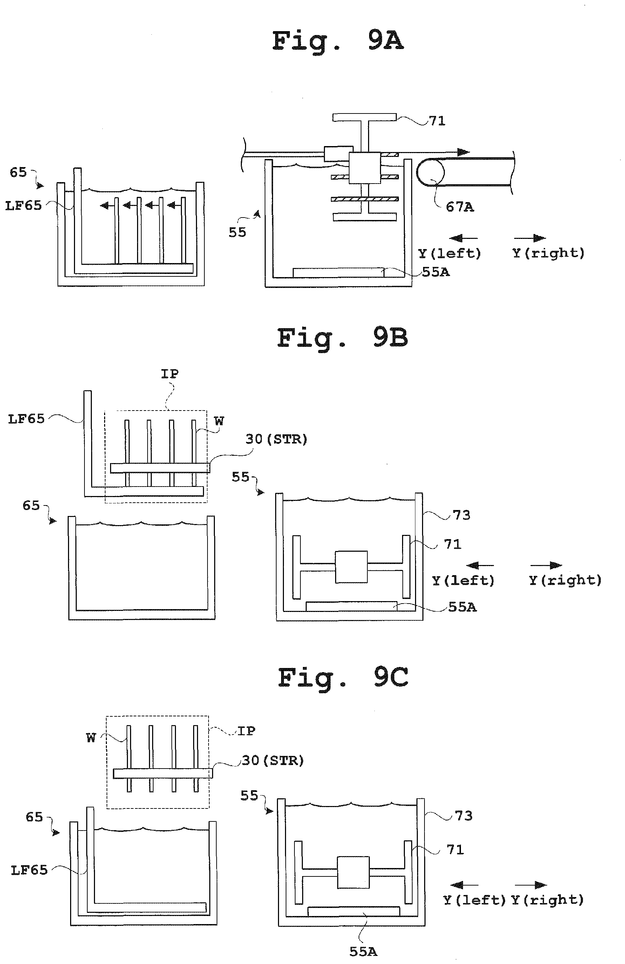

The conveyance of the remaining substrates W can be achieved almost by combining the above-described methods of conveying the substrate W. That is, as illustrated in FIG. 9A, the 24 substrates W in the horizontal attitude left in the immersion bath 73 of the underwater attitude changer 55 are transferred one by one to the first belt conveyor mechanism 67 by the substrate shift mechanism 57D. The uppermost substrate W among the substrates W in the horizontal attitude arranged in the in-bath carrier 71 is the substrate W to be transferred by the substrate shift mechanism 57D. In the present embodiment, the substrate W is transferred to the first belt conveyor mechanism 67 by the substrate shift mechanism 57D while the in-bath carrier 71 is gradually drawn from the immersion bath 73. In this way, it is possible to complete the conveyance of the remaining 24 substrates by causing only the substrate W to be transferred to stand by above the liquid surface and immersing the other substrates W in pure water.

Next, a method of conveying the 25 substrates left in the substrate standby bath 65 will be described. The remaining substrates Ware also conveyed to the underwater attitude changer 55 by the above-described full-pitch arrangement substrate conveyance mechanism STR. FIG. 9B illustrates a state when the lifter LF65 ascends to the carry-in position IP so as to transfer the 25 substrates W to the full-pitch arrangement substrate conveyance mechanism STR. This drawing corresponds to FIG. 6A described above. In the case of FIG. 9B, the full-pitch arrangement substrate conveyance mechanism STR is shifted rightward by the half pitch as compared with the case of FIG. 6A. In this way, the positions of the shallow grooves provided in the chucks 30 and the positions of the 25 substrates W left in the lifter LF65 coincide with each other, and the 25 substrates W are gripped by the pair of chucks 30. Shifting the full-pitch arrangement substrate conveyance mechanism STR by the half pitch is required to cause the full-pitch arrangement substrate conveyance mechanism STR to grip the 25 substrates W not gripped in FIG. 6A. After transferring the substrates to the full-pitch arrangement substrate conveyance mechanism STR, the lifter LF65 retracts to the immersion position of the substrate standby bath 65 (see FIG. 9C). The substrate standby bath corresponds to a standby bath of the present invention.

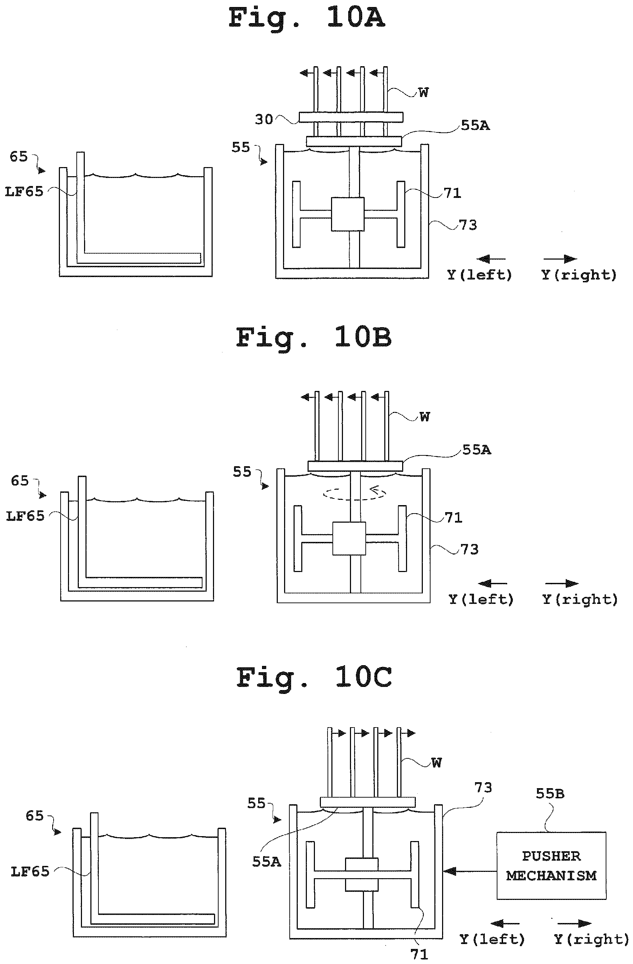

FIG. 10A illustrates a state when the full-pitch arrangement substrate conveyance mechanism STR then moves to the underwater attitude changer 55. When the pusher 55A of the underwater attitude changer 55 is raised in this state, the pusher 55A can collectively receive the plurality of substrates W arranged at the full pitch from the full-pitch arrangement substrate conveyance mechanism STR on the spot as illustrated in FIG. 10A.

FIG. 10B illustrates a state after the full-pitch arrangement substrate conveyance mechanism STR is then separated from the pusher 55A. At this time, the pusher 55A rotates 180° with a support column supporting the pusher 55A as a rotation axis as illustrated in FIG. 10B. Since the plurality of substrates W are arranged in the pusher 55A before rotation with the device surfaces directed leftward, the plurality of substrates W are arranged in the pusher 55A after rotation with the device surfaces directed rightward (see FIG. 10C).

The state of FIG. 10C is similar to that of FIG. 7A described above. Therefore, the plurality of substrates W illustrated in FIG. 10C are conveyed one by one from the immersion bath 73 to the first belt conveyor mechanism 67 by the same method as the method described in FIGS. 7A to 9A.

As described above, the substrate processing system of the present embodiment is configured such that all the device surfaces of the substrates W carried out to the carry-out position OP are directed upward by appropriately rotating the pusher 55A for the lot in which the substrates W are arranged in the face-to-face manner. Specifically, the substrates W whose device surfaces are directed leftward are rotated by 180°, so that the device surfaces are directed rightward. The plurality of substrates W whose device surfaces are directed rightward are rotated counterclockwise by 90° to assume the horizontal attitude with the device surfaces directed upward.

### <5.6. Relay Apparatus: Shutter>

Next, the first shutter S1, the second shutter S2, and a third shutter S3 provided in the relay apparatus 6 will be described. The first shutter S1 and the second shutter S2 are perpendicular to the Y direction in a closed state, and configured to block the substrate conveyance path of the relay apparatus 6. The third shutter S3 is configured to block a space between the carry-out position OP and a base position SP of the center robot CR to be described later.

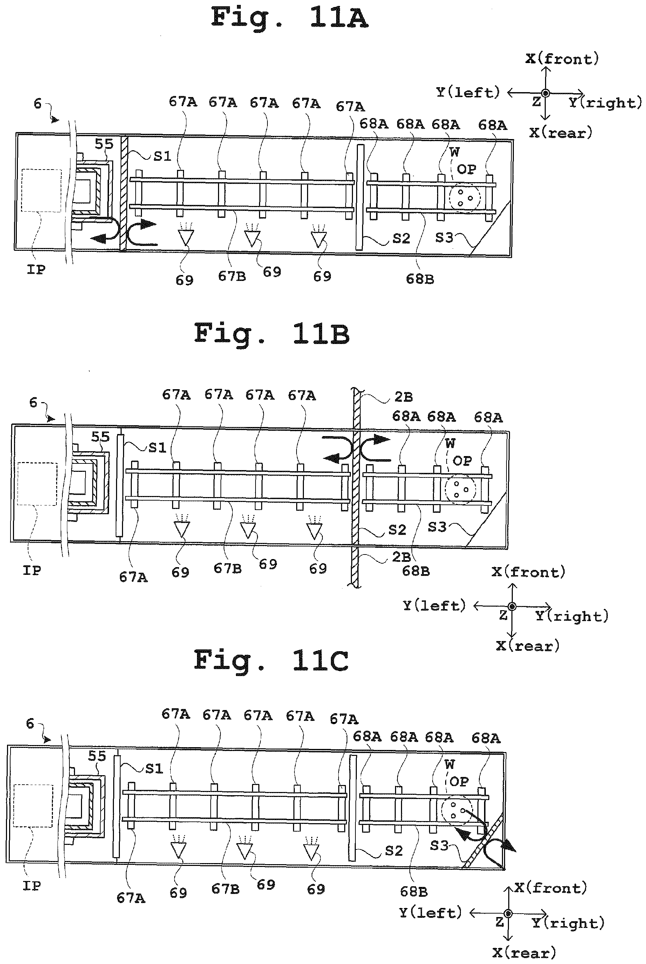

As illustrated in FIG. 11A, the first shutter S1 is provided closer to the carry-in position IP in the relay apparatus 6. The first shutter S1 is closed to divide the relay apparatus 6 into a section in which the first belt conveyor mechanism 67 is provided and a section in which the underwater attitude changer 55 positioned upstream of the first belt conveyor mechanism 67 is provided. When the first shutter S1 is closed, the first shutter S1 blocks circulation of the atmosphere between the respective sections as indicated by an arrow in FIG. 11A. Therefore, when the first shutter S1 is closed, the substrate W is not conveyed across the first shutter S1.

As illustrated in FIG. 11B, the second shutter S2 is provided between the first belt conveyor mechanism 67 and the second belt conveyor mechanism 68 in the relay apparatus 6. The second shutter S2 is at the same position in the Y direction as the fourth wall surface 2B facing the batch processing apparatus 1 among the partition walls forming the second housing 2A of the single-wafer processing apparatus 2. Therefore, when the second shutter S2 is closed, a rectangular opening provided for fitting the relay apparatus 6 in the fourth wall surface 2B is closed by the second shutter S2. The second shutter S2 is closed to divide the relay apparatus 6 into a section in which the second belt conveyor mechanism 68 is provided and a section in which the first belt conveyor mechanism 67 is provided. When the second shutter S2 is closed, the second shutter S2 blocks circulation of the atmosphere between the respective sections as indicated by an arrow in FIG. 11B. Therefore, when the second shutter S2 is closed, the substrate W is not conveyed across the second shutter S2.

As illustrated in FIG. 11C, the third shutter S3 has a movable plate-like configuration intersecting the conveyance direction (Y direction) of the substrate W in the second belt conveyor mechanism 68. The third shutter S3 is closed to divide the relay apparatus 6 and the single-wafer processing apparatus 2 from each other. When the third shutter S3 is closed, the third shutter S3 blocks circulation of the atmosphere between the relay apparatus 6 and the single-wafer processing apparatus 2 as indicated by an arrow in FIG. 11C. Therefore, when the third shutter S3 is closed, the substrate W is not conveyed across the third shutter S3.

The first shutter S 1, the second shutter S2, and the third shutter S3 are opened only when the substrate W is conveyed. Therefore, for example, when the substrates W have not reached the in-bath carrier 71 during conveyance as described with reference to FIGS. 5A to 7D, each shutter is closed. In a case in which the operation of each shutter is sufficiently fast relative to the substrate conveyance, each shutter may be opened and closed every time one substrate W is conveyed. Each shutter is always in the closed state when the substrate processing system is operated without using the relay apparatus 6. This operation method of the substrate processing system is related to a batch mode and a single-wafer mode to be described later.

### <6. Single-Wafer Processing Apparatus: Indexer Block>

As illustrated in FIG. 1, the indexer block 4 includes the second load port 10 on which the carrier C is placed that accommodates the plurality of substrates W in a horizontal attitude at predetermined intervals in the vertical direction. Therefore, the second load port 10 is a placing table for the carrier C. The carrier C that accommodates the plurality of single-wafer-processed substrates W may also be placed on the second load port 10. Since the single-wafer processing apparatus 2 of the present embodiment is configured to receive the batch-processed substrates W from the relay apparatus 6 without using the second load port 10, an empty carrier C for accommodating the batch-processed and single-wafer-processed substrates W is placed on the second load port 10. Therefore, the second load port 10 is used as an outlet for the substrates W in the single-wafer processing apparatus 2. The carrier C that accommodates unprocessed substrates W may be placed on the second load port 10, but this is a case in which the second load port 10 is used as an inlet for the substrates W. This placing method is related to the single-wafer mode to be described later. The second load port 10 protrudes from an outer wall of the indexer block 4 extending in the width direction (Y direction). The second load port corresponds to a second carrier placement shelf of the present invention.

An internal structure of the indexer block 4 will be described. The indexer block 4 includes an indexer robot IR that conveys the substrates W in the horizontal attitude one by one between the carrier C and a pass 24 provided closer to the indexer block 4 in the single-wafer processing block 8 described below. The indexer robot IR includes a hand including a pair of grip bodies that grips the substrate W in the horizontal attitude at its distal end, and an arm that supports the hand. The arm has a plurality of joints, and has a distal end connected to the hand, and a proximal end connected to a base of the arm provided in the indexer block 4. The indexer robot IR of the present embodiment is configured to receive each single-wafer-processed substrate W from the pass 24 and allow the substrate W to be accommodated in the second load port 10 outside the indexer block 4.

### <7. Single-Wafer Processing Apparatus: Single-Wafer Processing Block>

The single-wafer processing block 8 is provided on the back side of the indexer block 4 as viewed from the second load port 10. The pass 24 accessible by the indexer robot IR, and the center robot CR that can place each single-wafer-processed substrate W on the pass 24 are provided in a center portion in the Y direction of the single-wafer processing block 8. The single-wafer conveyance region R3 extending in the X direction is provided in the single-wafer processing block 8 such that the center robot CR can reciprocate between the pass 24 and the base position SP of the center robot CR set at a position away from the pass 24 in the X direction. The center robot CR can move back and forth in the X direction in the single-wafer conveyance region R3.

The single-wafer processing block 8 includes a single-wafer processing chamber 48a, a single-wafer processing chamber 48b, and a single-wafer processing chamber 48c capable of performing a drying treatment on the batch-processed substrates W. The respective single-wafer processing chambers are provided in a single-wafer processing region R4 provided so as to sandwich the single-wafer conveyance region R3 therebetween from the Y direction. The single-wafer processing chamber 48a and the single-wafer processing chamber 48b are provided in the single-wafer processing region R4 on the right side of the single-wafer conveyance region R3. The single-wafer processing chamber 48c is provided in the single-wafer processing region R4 on the left side of the single-wafer conveyance region R3.

The base position SP of the center robot CR is set in the single-wafer conveyance region R3. The base position SP is positioned away from the pass 24 in the X direction. When the center robot CR is at the base position SP, the center robot CR can access the single-wafer processing chamber 48a, the single-wafer processing chamber 48b, the single-wafer processing chamber 48c, and the carry-out position OP of the relay apparatus 6. With reference to the base position SP, the single-wafer processing chamber 48a is provided on the right front side, the single-wafer processing chamber 48b is provided on the right rear side, the single-wafer processing chamber 48c is provided on the left rear side, and the carry-out position OP of the relay apparatus 6 is set on the left front side.

Each of the single-wafer processing chambers has a facing surface that crosses a flow line of each substrate W connecting this single-wafer processing chamber and the base position SP such that the center robot CR can easily access this single-wafer processing chamber from the base position SP. A shutter is provided in each of the facing surfaces. By opening the shutter, an opening used when the substrate W is transferred from the center robot CR at the base position SP to each of the single-wafer processing chambers is formed in the facing surface. The relay apparatus 6 is also provided with the third shutter S3 that crosses a flow line of each substrate W connecting the carry-out position OP and the base position SP. By opening the shutter S3, an opening used when the center robot CR at the base position SP receives the substrate W at the carry-out position OP is formed.

FIG. 12 is a drawing of the single-wafer processing block 8 as viewed from the batch processing apparatus 1. As illustrated in this drawing, the single-wafer processing chambers are stacked in the Z direction to form a stacked body. For example, a single-wafer processing chamber 49c is disposed on the single-wafer processing chamber 48c, and a single-wafer processing chamber 47c is disposed under the single-wafer processing chamber 48c. Similarly, another single-wafer processing chamber is disposed on the single-wafer processing chamber 48a, and another single-wafer processing chamber is disposed under the single-wafer processing chamber 48a. Another single-wafer processing chamber is disposed on the single-wafer processing chamber 48b, and another single-wafer processing chamber is disposed under the single-wafer processing chamber 48b.

FIG. 12 also illustrates a point in which the relay apparatus 6 is disposed at a position sandwiched from above and below between single-wafer processing chambers. That is, a single-wafer processing chamber 49d is disposed on the relay apparatus 6, and a single-wafer processing chamber 47d is disposed under the relay apparatus 6.

As described above, the single-wafer processing block 8 of the present embodiment includes a first stacked body, a second stacked body, and a third stacked body. In the first stacked body, the three single-wafer processing chambers to which the single-wafer processing chamber 48a belongs are arranged in the Z direction. In the second stacked body, the three single-wafer processing chambers to which the single-wafer processing chamber 48b belongs are arranged in the Z direction. In the third stacked body, the three single-wafer processing chambers to which the single-wafer processing chamber 48c belongs are arranged in the Z direction. The single-wafer processing block 8 of the present embodiment includes the two single-wafer processing chambers provided at positions to sandwich the relay apparatus 6 therebetween from the Z direction. Therefore, the single-wafer processing block 8, which includes the nine single-wafer processing chambers constituting the stacked bodies and the two single-wafer processing chambers provided on and under the relay apparatus 6, includes a total of 11 single-wafer processing chambers.

As illustrated in FIG. 12, a block plate 16 is a part of the fourth wall surface 2B of the single-wafer processing apparatus 2, and is at a position surrounded by the relay apparatus 6, the single-wafer processing chambers 47d and 49d positioned on and under the relay apparatus 6, and the indexer block 4. The block plate 16 is provided so as to close a rectangular opening that is not closed by the relay apparatus 6 shorter than the single-wafer processing chambers 47d and 49d in the X direction. When the block plate 16 is provided on the indexer block 4 side, the relay apparatus 6 can be positioned on the base position SP side of the center robot CR. This enables the substrate W received from the carry-out position OP to be transferred to each single-wafer processing chamber without moving the center robot CR in the X direction.

A hand of the center robot CR gripping the substrate W in the horizontal attitude is movable in the Z direction while maintaining the attitude of the substrate W. The center robot CR having such a configuration can transfer the substrate W received from the carry-out position OP to the single-wafer processing chambers positioned on and under the relay apparatus 6. By providing the relay apparatus 6 in a middle layer of the stacked body of the single-wafer processing chambers, the carry-out position OP becomes an intermediate position of the single-wafer processing block 8 in the Z direction. With such a configuration, the carry-out position OP is positioned close to both the upper and lower single-wafer processing chambers. This makes it unnecessary to move the center robot CR by a long distance in the Z direction at the time of substrate conveyance, and makes it possible to quickly convey the substrate W from the carry-out position OP to the single-wafer processing chambers.

The center robot CR includes a first hand 32a configured to grip the substrate W before a drying treatment, and a second hand 32b configured to grip the substrate after a drying treatment and provided above the first hand 32a.

A configuration of each single-wafer processing chamber will be described. The single-wafer processing chamber can perform a substrate drying treatment of drying the substrate by a spin-dry method. An internal structure of the single-wafer processing chamber is described in the single-wafer processing chamber 48a in FIG. 1. The other single-wafer processing chambers have the same configuration. A spin chuck 8a that rotates the substrate W in a state of adsorbing the substrate W is provided inside the single-wafer processing chamber. When the substrate before the drying treatment attached to the spin chuck 8a is rotated, a liquid adhering to the substrate W is dispersed by centrifugal force to be removed from the substrate W. The single-wafer processing chamber according to the present embodiment also includes a chemical solution nozzle 8b that supplies a chemical solution to the substrate W in addition to the substrate drying treatment. The chemical solution nozzle 8b is turnable between a standby position away from the spin chuck 8a and a supply position above the spin chuck 8a. The single-wafer processing apparatus 2 in the substrate processing system of the present embodiment is operated as a substrate drying apparatus. The chemical solution nozzle 8b is related to a modification to be described later.

### <8. Controller>

The substrate processing system includes a first controller 131 related to control of the batch processing apparatus 1, a second controller 132 related to control of the single-wafer processing apparatus 2, and a third controller 136 related to control of the relay apparatus 6. FIG. 1 can be referred to for each controller. Although not illustrated in FIG. 1, a storage corresponding to each controller is also provided in the substrate processing system. The controller 131, the controller 132, and the controller 136 include, for example, a central processing unit (CPU). A specific configuration of each controller is not limited. For example, the controllers may be configured by a single processor, or each controller may be configured by an individual processor. The controller related to the batch processing apparatus 1 may also be configured by a plurality of processors. The same applies to the single-wafer processing apparatus 2 and the relay apparatus 6.

Examples of the control related to the controller 131 include control related to the carrier conveyance mechanism 11, the first substrate conveyance mechanism HTR, the first attitude changing mechanism 15, the second substrate conveyance mechanism WTR, the batch processing units BPU1 to BPU6, and the batch drying chamber DC. Examples of the control related to the controller 132 include control related to the center robot CR, each single-wafer processing chamber, and the indexer robot IR. Examples of the control related to the third controller 136 include control related to the full-pitch arrangement substrate conveyance mechanism STR, the substrate standby bath 65, the lifter LF65, the underwater attitude changer 55 (second attitude changing mechanism), the substrate shift mechanism 57D, the first belt conveyor mechanism 67, the second belt conveyor mechanism 68, the pure water supply device, and the lift pins 70.

The storage stores programs, parameters, and the like related to the control. The storage may be configured by a single device or may be configured by individual devices corresponding to the respective controllers. The substrate processing system of the present embodiment has no particular limitation on a configuration of the device that achieves the storage.

### <9. Hybrid Mode>

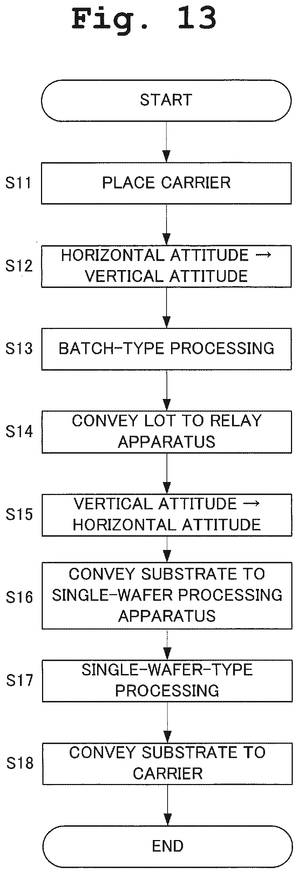

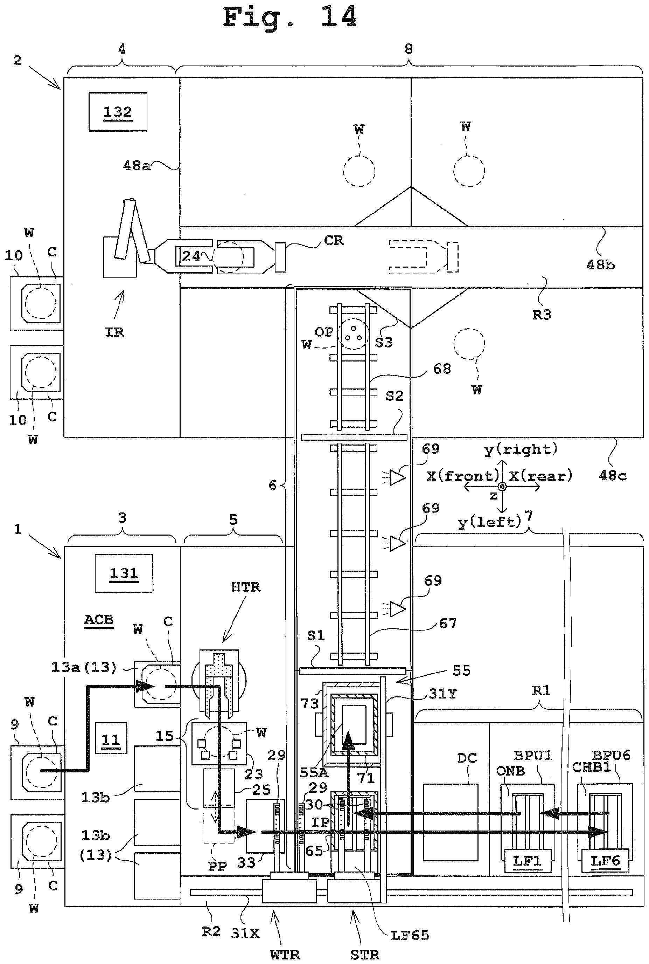

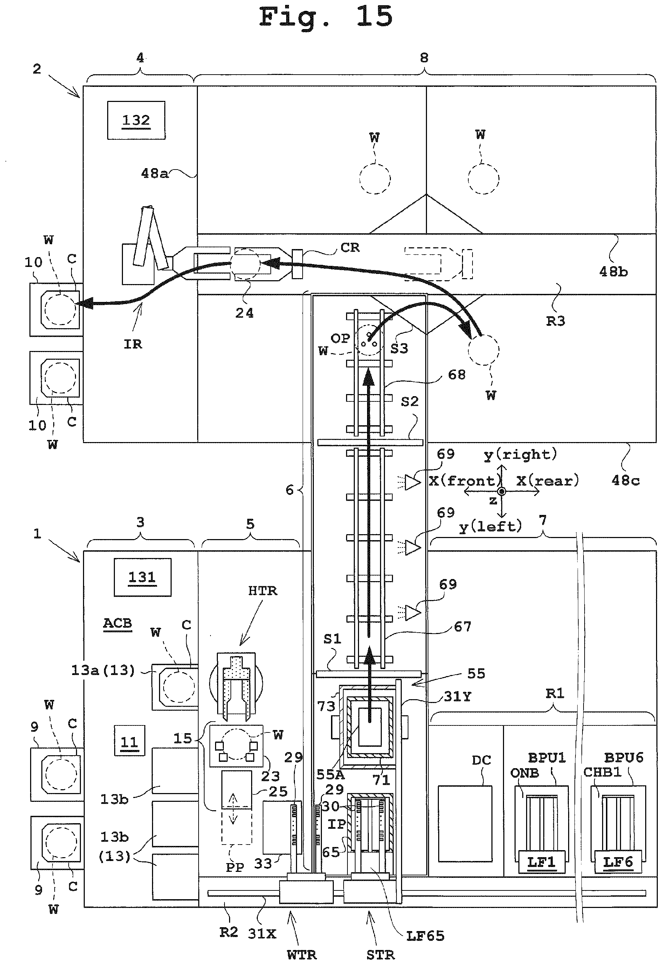

Hereinafter, a flow of substrate processing in a hybrid mode will be described with reference to a flowchart of FIG. 13. The substrate processing is performed by first performing the batch processing on the substrates W and then performing the single-wafer processing. The substrates W of the present embodiment are conveyed in the order of the first load port 9, the stocker block 3, the transfer block 5, the batch processing block 7, the relay apparatus 6, the single-wafer processing region R4, the indexer block 4, and the second load port 10, during which the batch processing and the single-wafer processing are completed (see FIGS. 14 and 15).

Step S11: The carrier C that arranges in the height direction and accommodates unprocessed substrates W in a horizontal attitude is placed on the first load port 9 in the batch processing apparatus 1. Thereafter, the carrier C is taken into the stocker block 3, and placed on the carrier placement shelf 13a. The carrier C may pass through the stock shelf 13b before being placed on the carrier placement shelf 13a. The carrier conveyance mechanism 11 moves the carrier C at this time. The first substrate conveyance mechanism HTR collectively takes out the plurality of substrates W in the horizontal attitude from the carrier C placed on the carrier placement shelf 13a, and transfers the substrates W to the HVC attitude changer 23. The carrier placement shelf corresponds to the first carrier placement shelf of the present invention.

Step S12: The HVC attitude changer 23 collectively changes the attitudes of the plurality of received substrates W from the horizontal attitude to a vertical attitude, and transfers the substrates W to the pusher mechanism 25. The HVC attitude changer 23 receives another set of substrates W derived from the carrier C different from the carrier C accommodating the plurality of substrates W whose attitudes have been changed, from the first substrate conveyance mechanism HTR, and changes the attitudes of the substrates W from the horizontal attitude to a vertical attitude. The plurality of substrates W whose attitudes have been changed are also transferred to the pusher mechanism 25. In this way, the substrates W arranged at the full pitch are assembled into a batch, and the substrates W corresponding to the two carriers are arranged at the half pitch in the pusher 25A. The pusher mechanism 25 conveys the lot generated in this way to the substrate transfer position PP defined in the transfer block 5.

Step S13: The second substrate conveyance mechanism WTR receives the lot on standby at the substrate transfer position PP from the pusher mechanism 25, and transfers the lot to the lifter LF6 on standby above the batch chemical treatment bath CHB6 in the sixth batch processing unit BPU6. At this time, the lot may pass through the dry lot support part 33 before being placed on the lifter LF6. The lot is transferred to the lifter LF6 to be given a phosphoric acid treatment. Therefore, the lot may be transferred to any one of the lifters LF2 to LF6 related to the phosphoric acid treatment. Hereinafter, the lot will be described as being transferred to the lifter LF6.

Thereafter, the lifter LF6 descends to the immersion position, and a batch-type phosphoric acid treatment is performed on the lot. The lot subjected to the phosphoric acid treatment is returned to above the batch chemical treatment bath CHB6 again by the lifter LF6, and transferred to the second substrate conveyance mechanism WTR. The second substrate conveyance mechanism WTR transfers the lot to the lifter LF1 on standby above the batch rinse treatment bath ONB in the first batch processing unit BPU1. Thereafter, the lifter LF1 descends to the immersion position, and a batch rinse treatment is performed on the lot. In this way, the series of batch processing is completed. The lot subjected to the batch processing is returned to above the batch rinse treatment bath ONB again by the lifter LF1, and transferred to the second substrate conveyance mechanism WTR. The second substrate conveyance mechanism corresponds to the collective conveyance mechanism of the present invention.

Step S14: The second substrate conveyance mechanism WTR transfers the batch-processed lot to the lifter LF65 on standby at the carry-in position IP. Thereafter, the lifter LF65 descends to the immersion position of the substrate standby bath 65, and causes the lot to stand by in pure water. In a case in which the plurality of substrates W are conveyed from the substrate standby bath 65 to the immersion bath 73 of the underwater attitude changer 55, the lifter LF65 first moves the lot from the immersion position to the carry-in position IP. The full-pitch arrangement substrate conveyance mechanism STR receives the substrate array in the vertical attitude from the lifter LF65 at the carry-in position IP, and conveys the substrate array in the Y direction (rightward). Since the full-pitch arrangement substrate conveyance mechanism STR is unable to convey the 50 substrates W constituting the lot at a time as described above, it is necessary to perform the conveyance operation twice in order to convey all the substrates W constituting the lot to the underwater attitude changer 55. The second conveyance operation by the full-pitch arrangement substrate conveyance mechanism STR is performed after all the substrates W conveyed in the first conveyance operation are carried out from the immersion bath 73. The underwater attitude changer corresponds to the second attitude changing mechanism of the present invention.

The pusher 55A positioned at the bottom of the immersion bath 73 of the underwater attitude changer 55 ascends to receive the substrate array from the full-pitch arrangement substrate conveyance mechanism STR on standby above the immersion bath 73. Thereafter, the pusher 55A descends to transfer the substrate array to the in-bath carrier 71.

FIG. 14 illustrates a state in which the plurality of substrates Ware collectively conveyed in steps S11 to S14 described above.

Step S15: The in-bath carrier 71 that has received the substrate array rotates counterclockwise to collectively change the attitudes of the substrates W from the vertical attitude to a horizontal attitude.

Step S16: The substrate shift mechanism 57D grips the substrates W held by the in-bath carrier 71 one by one and transfers the substrates W to the first belt conveyor mechanism 67 positioned on the right side of the underwater attitude changer 55. The first belt conveyor mechanism 67 receives the substrates W in the horizontal attitude one by one and conveys the substrates W to the right of the relay apparatus 6. A method in which the first belt conveyor mechanism 67 receives the substrates W is not particularly limited. The first belt conveyor mechanism 67 has an elongated shape. Thus, before one substrate W finishes being conveyed, the subsequent substrate W may be received from the underwater attitude changer 55. The conveyance speed of the first belt conveyor mechanism 67 may be increased, so that it is possible to adopt a configuration in which the subsequent substrate W is not received before one substrate W finishes being conveyed. The substrate W conveyed to the right end of the first belt conveyor mechanism 67 is then received from a left end of the second belt conveyor mechanism 68, and conveyed to the inside of the single-wafer processing apparatus 2. Since the second belt conveyor mechanism 68 also has an elongated shape similar to the first belt conveyor mechanism, the second belt conveyor mechanism 68 may place thereon and convey several substrates W in the horizontal attitude at a time.

The first belt conveyor mechanism 67 and the second belt conveyor mechanism 68 are configured to convey a plurality of substrates W at a time as described above. However, because the substrates W being conveyed are not stacked together, it can be said that the substrates W in the horizontal attitude are conveyed one by one. This is because the substrates W conveyed by the first belt conveyor mechanism 67 and the second belt conveyor mechanism 68 have different positions in the Y direction.

The second belt conveyor mechanism 68 conveys each substrate W to directly below the carry-out position OP of the relay apparatus 6. The three lift pins 70 raise the substrate W conveyed by the second belt conveyor mechanism 68 to convey the substrate W to the carry-out position OP.

The center robot CR positioned at the base position SP in the single-wafer conveyance region R3 receives the substrate W from the carry-out position OP of the relay apparatus 6, and conveys the substrate W to any one of the single-wafer processing chambers (for example, the single-wafer processing chamber 48c) positioned in the single-wafer processing region R4. At this time, the center robot CR gives and receives the substrate W before a drying treatment using the hand for conveying a substrate before a drying treatment.

Step S 17: The substrate W received by the single-wafer processing chamber 48c is subjected to the single-wafer processing on the spot. The single-wafer processing is specifically a spin-dry-type substrate drying treatment.

Step S18: The substrate W subjected to the single-wafer processing is received by the hand for conveying a substrate after a drying treatment included in the center robot CR, and is conveyed from the single-wafer processing chamber 48c to the pass 24. The indexer robot IR receives the processed substrate W from the pass 24 and transfers the substrate W to the carrier C placed on the second load port 10. In this way, the conveyance of the substrate W is completed.

FIG. 15 illustrates a state in which the substrates W in the horizontal attitude are conveyed one by one in steps S15 to S18 described above.

The respective steps are executed simultaneously in some cases, and this point will be described. While the substrate W is subjected to the drying treatment in step S17, the conveyance of the substrate in the horizontal attitude described in step S16 is continued. Therefore, steps S16 and S17 may be executed simultaneously. The substrate conveyance in step S16 is repeated until all the 11 single-wafer processing chambers of the single-wafer processing apparatus 2 are in use. When any one of the single-wafer processing chambers in use becomes empty, step S16 is executed again. Performing the single-wafer processing in parallel in this manner can increase the throughput of the substrate processing system.

After all of the plurality of substrates W whose attitudes have been changed to the horizontal attitude in step S15 are conveyed from the relay apparatus 6 to the single-wafer processing apparatus 2, the underwater attitude changer 55 can receive a new substrate array. The full-pitch arrangement substrate conveyance mechanism STR receives the substrate array on standby in the substrate standby bath 65 at this point from the lifter LF65, and transfers the substrate array to the underwater attitude changer 55. As described above, according to the present embodiment, it is necessary to perform step S15 twice to convey one lot. Therefore, step S15 may be executed simultaneously with steps S16 and S17.

By appropriately repeating steps S15, S16, and S17, it is possible to complete the substrate drying treatment by the single-wafer processing chambers while releasing the batch assembly of the lot. When all the substrates W constituting the lot are returned to the carrier C placed on the second load port, the substrate processing of the present embodiment ends.

Note that the substrate processing of the present embodiment is configured to process the two carriers C at a time. That is, the respective substrates W accommodated in the first carrier C and the second carrier C placed on the first load port 9 of the batch processing apparatus 1 are accommodated in a third carrier C and a fourth carrier C placed on the second load port 10 of the single-wafer processing apparatus 2.

In step S15, all the substrates W whose attitudes are changed are derived from the first carrier C. Therefore, the relay apparatus 6 conveys only the substrates W accommodated in the first carrier C to the single-wafer processing apparatus 2. The indexer robot IR allows all the substrates W related to the first carrier C conveyed in this manner to be accommodated in the third carrier C.

After all the substrates W related to the first carrier C are conveyed from the underwater attitude changer 55, step S15 is executed again. In this case, all the substrates W whose attitudes are changed are derived from the second carrier C. Therefore, the relay apparatus 6 conveys only the substrates W accommodated in the second carrier C to the single-wafer processing apparatus 2 this time. The indexer robot IR allows all the substrates W related to the second carrier C conveyed in this manner to be accommodated in the fourth carrier C.

As a result, the substrates W accommodated in the first carrier C and the substrates W accommodated in the second carrier C are accommodated in the third carrier C and the fourth carrier C, respectively, without being mixed.

### <10. Batch Mode>

The above-described substrate processing is related to the hybrid mode in which the batch processing and the single-wafer processing are continuously performed. In addition to the hybrid mode, the substrate processing system of the present embodiment can operate on the basis of the batch mode in which the substrate processing is completed only by the batch processing apparatus 1, and the single-wafer mode in which the substrate processing is completed only by the single-wafer processing apparatus 2.

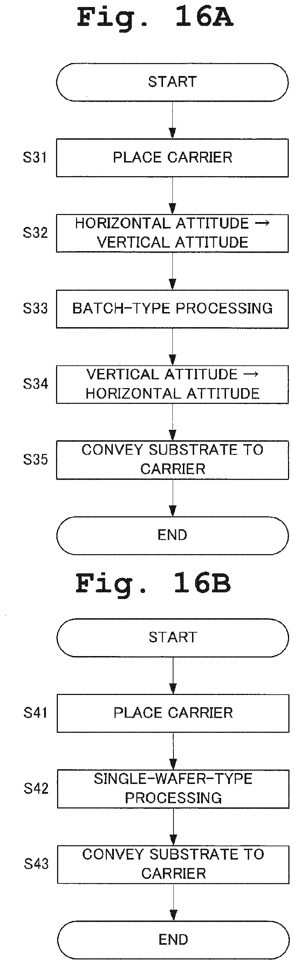

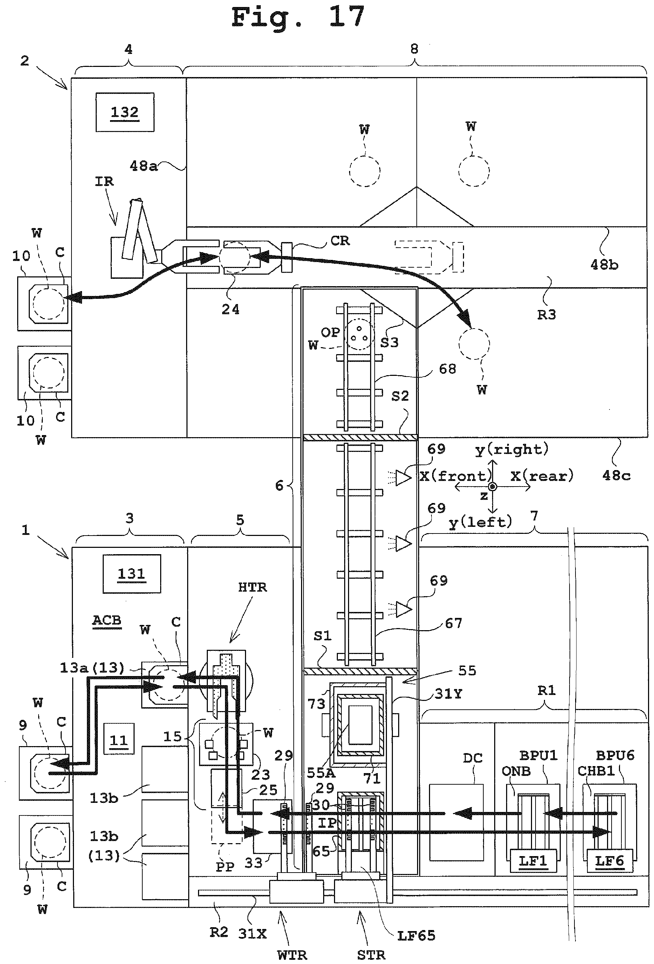

Hereinafter, a flow of the substrate processing in the batch mode will be described with reference to a flowchart of FIG. 16A. In the substrate processing, the substrates W are conveyed in the order of the first load port 9, the stocker block 3, the transfer block 5, the batch processing block 7, the transfer block 5, the stocker block 3, and the first load port 9, during which the batch processing is completed (see FIG. 17).

Step S31: The carrier C that arranges in the height direction and accommodates unprocessed substrates W in a horizontal attitude is placed on the first load port 9 in the batch processing apparatus 1. The plurality of substrates W are collectively transferred to the HVC attitude changer 23. The flow of the substrates W at this time is similar to step S11 described above.

Step S32: The HVC attitude changer 23 collectively changes the attitudes of the plurality of received substrates W from the horizontal attitude to a vertical attitude, and transfers the substrates W to the pusher mechanism 25. The HVC attitude changer 23 assembles a batch, and arranges the substrates W corresponding to two carriers on the pusher 25A. The pusher 25A conveys the lot to the substrate transfer position PP. The flow of the substrates W at this time is similar to step S12 described above.

Step S33: The second substrate conveyance mechanism WTR receives the lot on standby at the substrate transfer position PP from the pusher mechanism 25, and transfers the lot to the lifter LF6 on standby above the batch chemical treatment bath CHB6. The lot is immersed in the batch chemical treatment bath CHB6, and subjected to a phosphoric acid treatment. The lot subjected to the phosphoric acid treatment is conveyed by the second substrate conveyance mechanism WTR, and transferred to the lifter LF1 on standby above the batch rinse treatment bath ONB. The lot is immersed in the batch rinse treatment bath ONB, and subjected to a batch rinse treatment. The lot subjected to the batch rinse treatment is transferred to the second substrate conveyance mechanism WTR. The above flow of the substrates W is similar to step S13 described above.

This step is different from step S13 described above in that the batch processing apparatus 1 also performs a drying treatment on the substrates W. That is, the second substrate conveyance mechanism WTR that has received the lot subjected to the batch rinse treatment moves to above the batch drying chamber DC, and transfers the lot to the batch drying chamber DC. The lot subjected to the drying treatment by the batch drying chamber DC is received by the second substrate conveyance mechanism WTR again, and conveyed to the substrate transfer position PP of the transfer block 5.

Step S34: The lot subjected to the drying treatment is then transferred to the pusher mechanism 25 at the substrate transfer position PP. The pusher mechanism 25 brings the pusher 25A closer to the HVC attitude changer 23. The lot thereby assumes the state illustrated in FIG. 4F. An operation opposite to the batch assembling operation described with reference to FIGS. 4A to 4F is performed from this state to change the attitudes of the substrates W from the vertical attitude to a horizontal attitude while releasing the batch assembly. That is, the HVC attitude changer 23 receives half of the substrates W constituting the lot supported by the pusher mechanism 25 in FIG. 4F (see FIG. 4E). Thereafter, the HVC attitude changer 23 changes the attitudes of the received substrates W from the vertical attitude to the horizontal attitude (see FIG. 4D).

Step S35: The plurality of substrates W in the horizontal attitude in the HVC attitude changer 23 are received by the first substrate conveyance mechanism HTR, and returned to the empty carrier C placed on the carrier placement shelf 13a. Thereafter, the carrier conveyance mechanism 11 returns the carrier C to the first load port 9.

In the above description, the plurality of substrates W arranged at the full pitch are left in the pusher mechanism 25. The remaining substrates Ware rotated by 180° by the pusher mechanism 25 (see FIG. 4D), and received by the HVC attitude changer 23 (See FIGS. 4B and 4C). Thereafter, the HVC attitude changer 23 changes the attitudes of the received substrates W from the vertical attitude to the horizontal attitude (see FIG. 4A). Thereafter, step S35 described above is performed again, and the carrier C is returned to the first load port 9, so that the substrate processing in the batch mode ends.

FIG. 17 illustrates a state in which the batch processing is executed in steps S31 to S35 described above.

While the batch mode is being executed, the first shutter S1 is closed. With such a configuration, the atmosphere in the batch processing apparatus 1 is blocked from the outside air, so that the batch processing can be performed in a cleaner environment.

### <11. Single-Wafer Mode>

Next, a flow of the substrate processing in the single-wafer mode will be described with reference to a flowchart of FIG. 16B. In the substrate processing, the substrates W are conveyed in the order of the second load port 10, the indexer block 4, the single-wafer processing block 8, the indexer block 4, and the second load port 10, during which the single-wafer processing is completed (see FIG. 17).

Step S41: The carrier C that arranges in the height direction and accommodates unprocessed substrates W in a horizontal attitude is placed on the second load port 10 in the single-wafer processing apparatus 2. The indexer robot IR conveys the unprocessed substrates W accommodated in the carrier C one by one to the pass 24. The center robot CR can access the pass 24. The center robot CR receives each substrate W on the spot and moves to the base position SP separated therefrom in the X direction. In this state, the center robot CR transfers the substrate W to the single-wafer processing chamber 48c. The reason why the substrate W is transferred to the single-wafer processing chamber 48c is to perform the single-wafer processing on the substrate W. Therefore, this step may be completed by transferring the substrate W to another single-wafer processing chamber of the single-wafer processing block 8. The following description will be made assuming that the substrate W is transferred to the single-wafer processing chamber 48c.

Step S42: The single-wafer processing chamber 48c performs a chemical treatment such as a water repellent treatment, or a drying treatment on the received substrate W. When the substrate W is subjected to the water repellent treatment, the substrate W supported by the spin chuck 8a is rotated while a chemical solution is being supplied from the chemical solution nozzle 8b at the supply position. The chemical solution supplied from the chemical solution nozzle 8b may be a silane coupling agent that generates a water-repellent protective film on the substrate surface. The drying treatment on the substrate W is performed by the spin-dry method described above.

Step S43: The center robot CR receives the substrate W subjected to the single-wafer processing from the single-wafer processing chamber 48c at the base position SP, and moves to the pass 24 in the X direction. The indexer robot IR receives the substrate W placed on the pass 24 by the center robot CR, and conveys the substrate W to the original carrier C (the same carrier C as the carrier C to which the substrate W belongs at the time before the processing). By appropriately repeating steps S41 to S43 described above, the single-wafer processing is completed for all the substrates W accommodated in the carrier C.

FIG. 17 illustrates a state in which the single-wafer processing is executed in steps S41 to S43 described above.

While the single-wafer mode is being executed, the second shutter S2 is closed. With such a configuration, the atmosphere in the single-wafer processing apparatus 2 is blocked from the outside air, so that the single-wafer processing can be performed in a cleaner environment.

As described above, according to the present invention, the batch processing apparatus 1 and the single-wafer processing apparatus 2 separated from each other are connected by the relay apparatus 6, so that it is possible to configure the substrate processing system that continuously performs the batch processing of collectively processing the plurality of substrates W and the single-wafer processing of processing the substrates W one by one. That is, the present invention includes the relay apparatus 6 in which the two positions are defined: the carry-in position IP for receiving the batch-processed substrates W from the batch processing apparatus 1 and the carry-out position OP for transferring the substrates W received at the carry-in position IP to the single-wafer processing apparatus 2. The relay apparatus 6 receives the substrates W subjected to the batch processing by the existing batch processing apparatus 1 at the carry-in position IP, and transfers the substrates W to the existing single-wafer processing apparatus 2 at the carry-out position OP. This makes it possible to relatively easily configure the substrate processing system that continuously performs the batch processing and the single-wafer processing on the basis of technologies cultivated in the individual apparatuses. It is also possible to reduce the design cost and manufacturing cost of the system.

### [Second Embodiment]

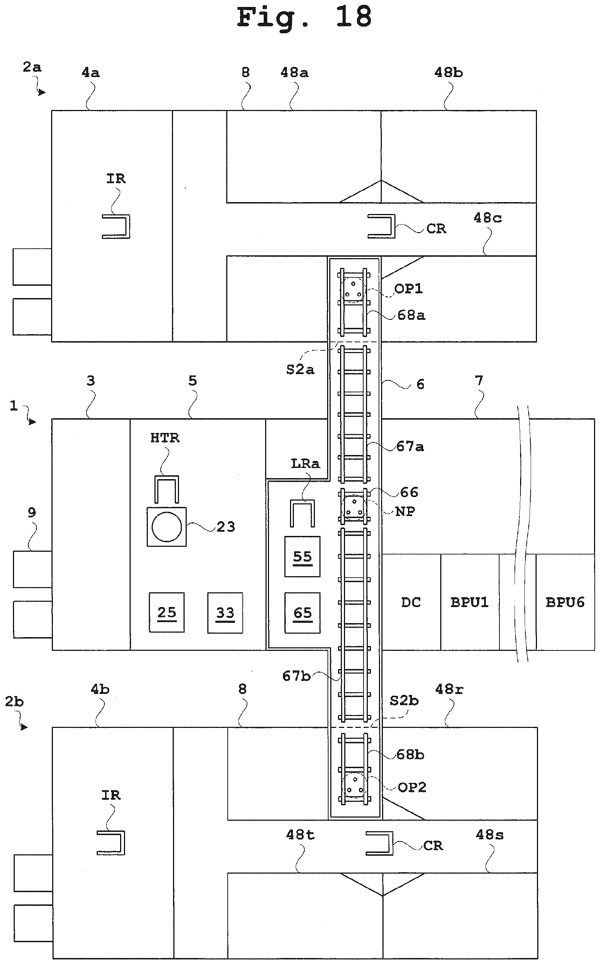

Subsequently, a substrate processing system according to a second embodiment will be described. As illustrated in FIG. 18, the substrate processing system according to the present embodiment has a configuration in which a plurality of single-wafer processing apparatuses are connected to one batch processing apparatus 1 by a relay apparatus 6. Specifically, a single-wafer processing apparatus 2a and a single-wafer processing apparatus 2b are disposed at positions to sandwich the batch processing apparatus 1 therebetween from the Y direction. The relay apparatus 6 is configured to bridge between the single-wafer processing apparatus 2a and the batch processing apparatus 1, and between the single-wafer processing apparatus 2b and the batch processing apparatus 1. In general, single-wafer processing takes more time for substrate processing than batch processing. Therefore, the substrate processing system is configured by the plurality of single-wafer processing apparatuses and the one batch processing apparatus 1, so that it is possible to provide an apparatus with improved substrate processing speed.

The batch processing apparatus 1 of the present embodiment has the same configuration as the batch processing apparatus of the first embodiment. That is, the batch processing apparatus 1 of the present embodiment includes the stocker block 3 from which the first load port 9 on which the carrier C is placed protrudes, the transfer block 5 provided at a position adjacent to the stocker block 3, and the batch processing block 7. The single-wafer processing apparatus 2a and the single-wafer processing apparatus 2b of the present embodiment have the same configuration as the single-wafer processing apparatus of the first embodiment. That is, the single-wafer processing apparatus 2a of the present embodiment includes the indexer block 4 from which the second load port 10 on which the carrier C is placed protrudes, and the single-wafer processing block 8 including the plurality of single-wafer processing chambers. The single-wafer processing apparatus 2b has the same configuration as the single-wafer processing apparatus 2a.

The relay apparatus 6 crosses the batch processing apparatus 1 in the Y direction, and has one end extending to the inside of the single-wafer processing apparatus 2a positioned on the right side of the batch processing apparatus 1, and the other end extending to the inside of the single-wafer processing apparatus 2b positioned on the left side of the batch processing apparatus 1. The relay block includes the substrate standby bath 65 and the underwater attitude changer 55 similar to those in the first embodiment.

The relay apparatus 6 of the present embodiment includes a relay local conveyance mechanism LRa that conveys the substrates W in the horizontal attitude one by one. The relay local conveyance mechanism LRa is provided on the right side of the underwater attitude changer 55, and can access the underwater attitude changer 55. The relay local conveyance mechanism LRa accesses the in-bath carrier 71 that arranges and holds the substrates W in the horizontal attitude, and receives the substrate W at the uppermost position among the substrates W held by the in-bath carrier 71, above the immersion bath 73. The relay local conveyance mechanism LRa includes a hand that holds the substrate W. The relay local conveyance mechanism LRa can move the hand from side to side in the Y direction, and can also rotate the hand by 90° around a rotation axis extending in the Z direction. As a result, the hand can face the in-bath carrier 71 or can face a distribution belt conveyor mechanism 66 described below.

The distribution belt conveyor mechanism 66 is positioned on the rear side of the relay local conveyance mechanism LRa, and is configured to convey rightward or leftward the substrate W transferred from the relay local conveyance mechanism LRa. To transfer the substrate W from the relay apparatus 6 to the single-wafer processing apparatus 2a, the distribution belt conveyor mechanism 66 conveys the substrate W rightward. To transfer the substrate W from the relay apparatus 6 to the single-wafer processing apparatus 2b, the distribution belt conveyor mechanism 66 conveys the substrate W leftward. As described above, the distribution belt conveyor mechanism 66 distributes the substrate W by conveying the substrate W in a forward direction or a reverse direction. The distribution belt conveyor mechanism 66 has the same configuration as the first belt conveyor mechanism 67 of the first embodiment, and includes a plurality of belts and a plurality of rollers.

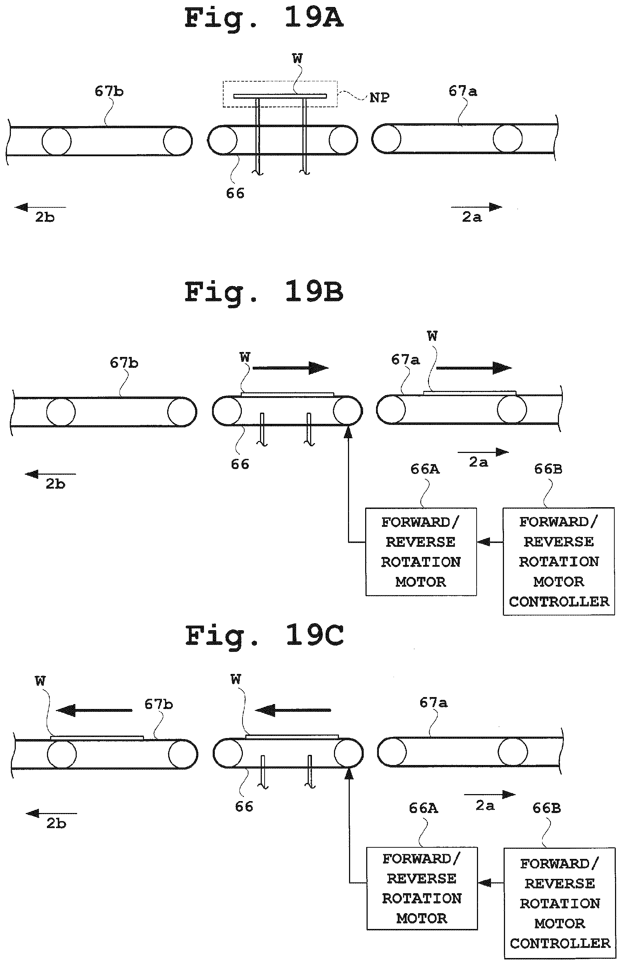

FIG. 19A specifically illustrates the distribution belt conveyor mechanism 66. The distribution belt conveyor mechanism 66 includes three or more lift pins similar to the lift pins 70 described using FIG. 8D. The lift pins can freely protrude from and retract into the belts of the distribution belt conveyor mechanism 66. The lift pins can reach a relay position NP set above the distribution belt conveyor mechanism 66 by extending. The relay local conveyance mechanism LRa conveys the substrate W received from the in-bath carrier 71 to the relay position NP above the distribution belt conveyor mechanism 66. Since the lift pins stand by at the relay position NP at this time, the substrate W maintains the horizontal attitude in a state of being supported by the lift pins. When the lift pins contract, the substrate W is transferred to the belts constituting the distribution belt conveyor mechanism 66.

FIG. 19B illustrates a state in which the substrate W is conveyed rightward by the distribution belt conveyor mechanism 66 operating in the forward direction. A first belt conveyor mechanism 67a for conveying the substrate W to the single-wafer processing apparatus 2a is provided on the right side of the distribution belt conveyor mechanism 66. The substrate W conveyed rightward by the distribution belt conveyor mechanism 66 is further conveyed rightward by the first belt conveyor mechanism 67a. Such an operation of the distribution belt conveyor mechanism 66 is achieved by a forward/reverse rotation motor 66A that drives the roller(s). That is, when the forward/reverse rotation motor 66A rotates the roller(s) in the forward direction, the belts operate to flow rightward. Such control of the forward/reverse rotation motor 66A is achieved by a forward/reverse rotation motor controller 66B. The forward/reverse rotation motor controller 66B is a part of the third controller 136.

FIG. 19C illustrates a state in which the substrate W is conveyed leftward by the distribution belt conveyor mechanism 66 operating in the reverse direction. A first belt conveyor mechanism 67b for conveying the substrate W to the single-wafer processing apparatus 2b is provided on the left side of the distribution belt conveyor mechanism 66. The substrate W conveyed leftward by the distribution belt conveyor mechanism 66 is further conveyed leftward by the first belt conveyor mechanism 67b. Such an operation of the distribution belt conveyor mechanism 66 is achieved by the forward/reverse rotation motor 66A that drives the roller(s). That is, when the forward/reverse rotation motor 66A rotates the roller(s) in the reverse direction, the belts operate to flow leftward. Such control of the forward/reverse rotation motor 66A is achieved by the forward/reverse rotation motor controller 66B.

In addition, the substrate processing system according to the present embodiment includes a second belt conveyor mechanism 68a at the right end portion of the relay apparatus 6, and a second belt conveyor mechanism 68b at the left end portion of the relay apparatus 6. A carry-out position OP1 of the relay apparatus 6 is set at the second belt conveyor mechanism 68a, and a carry-out position OP2 of the relay apparatus 6 is set at the second belt conveyor mechanism 68b. Therefore, in the relay apparatus 6 of the present embodiment, the plurality of carry-out positions are set. A right shutter S2a corresponds to the second shutter S2 of the first embodiment, and is configured to block communication between the batch processing apparatus 1 and the single-wafer processing apparatus 2a. A left shutter S2b also corresponds to the second shutter S2 of the first embodiment, and is configured to block communication between the batch processing apparatus 1 and the single-wafer processing apparatus 2b.

Paths of the first belt conveyor mechanism 67b and the second substrate conveyance mechanism WTR three-dimensionally cross each other such that the first belt conveyor mechanism 67b and the second substrate conveyance mechanism WTR do not interfere with each other.

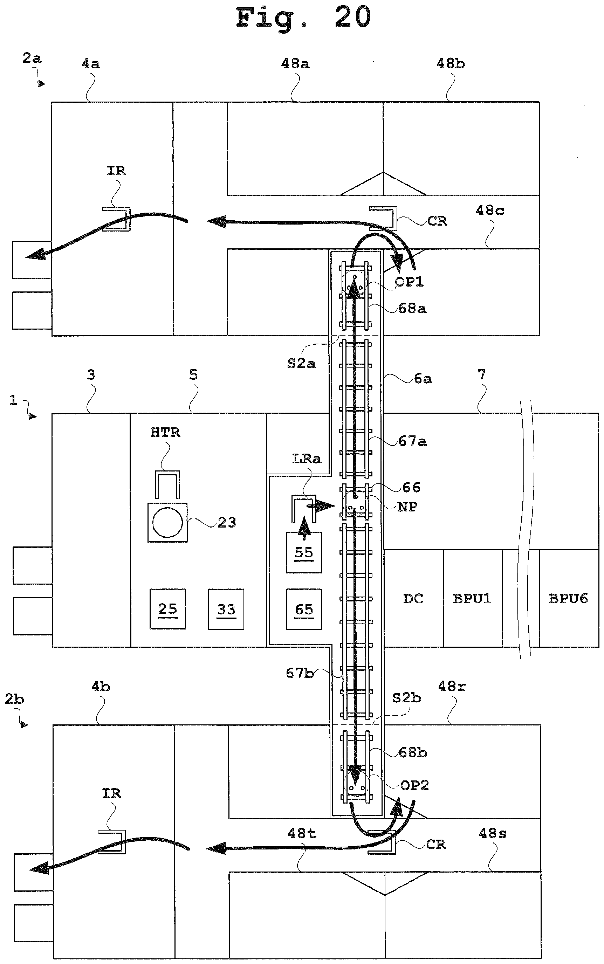

FIG. 20 illustrates a flow of the substrates according to the present embodiment. FIG. 20 illustrates a process of conveying the substrates W in the horizontal attitude one by one, and omits a process of collectively conveying the substrates. As illustrated in FIG. 20, each substrate W conveyed from the underwater attitude changer 55 to the distribution belt conveyor mechanism 66 by the relay local conveyance mechanism LRa is first conveyed in the forward direction to the single-wafer processing apparatus 2a. By repeating such conveyance, all the plurality of substrates W derived from the common carrier C are conveyed to the single-wafer processing apparatus 2a, and subjected to the single-wafer processing on the spot. The indexer robot IR allows all the single-wafer-processed substrates W to be accommodated in the single carrier C.

After finishing conveying the substrates W of one carrier C, the distribution belt conveyor mechanism 66 conveys the subsequent substrates transferred from the relay local conveyance mechanism LRa in the reverse direction. In this way, the substrates Ware conveyed one by one to the single-wafer processing apparatus 2b. By repeating such conveyance, all the plurality of substrates W derived from the common carrier C are conveyed to the single-wafer processing apparatus 2b, and subjected to the single-wafer processing on the spot. The indexer robot IR allows all the single-wafer-processed substrates W to be accommodated in the single carrier C.

According to the present embodiment, even during the substrate processing of the single-wafer processing apparatus 2a, the subsequent substrates W can be conveyed from the batch processing apparatus 1 to the single-wafer processing apparatus 2b as soon as the substrates W of one carrier C finish being conveyed. With such a configuration, the single-wafer processing can be simultaneously performed in parallel using the plurality of single-wafer processing apparatuses, so that it is possible to provide the substrate processing system having a high throughput.

### [Third Embodiment]

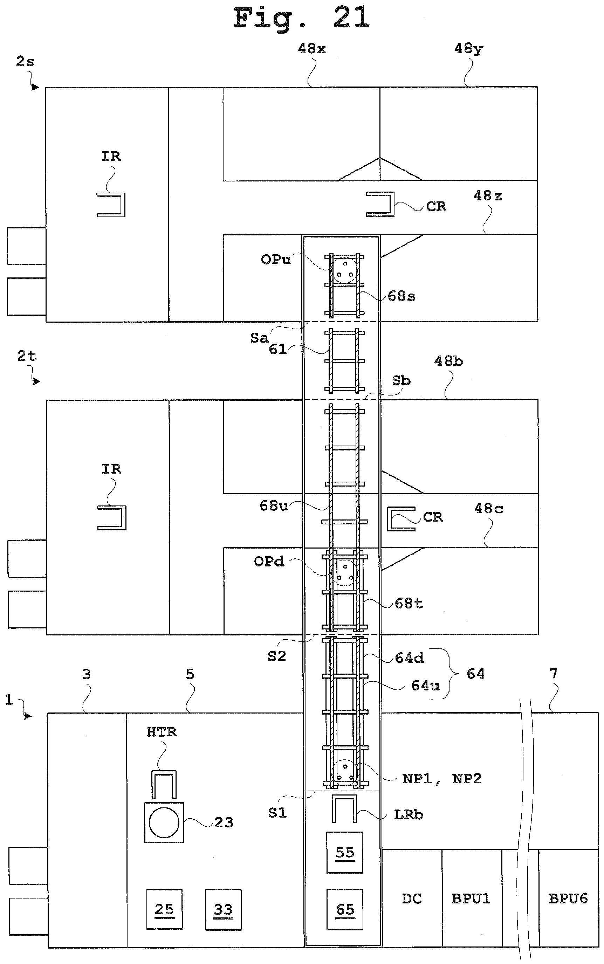

Subsequently, a substrate processing system according to a third embodiment will be described. As illustrated in FIG. 21, the substrate processing system according to the present embodiment has a configuration in which a plurality of single-wafer processing apparatuses are connected to one batch processing apparatus 1 by a relay apparatus 6. Specifically, a single-wafer processing apparatus 2s and the batch processing apparatus 1 are disposed at positions to sandwich a single-wafer processing apparatus 2t therebetween from the Y direction. The relay apparatus 6 is configured to bridge between the single-wafer processing apparatus 2t and the batch processing apparatus 1 and between the single-wafer processing apparatus 2s and the single-wafer processing apparatus 2t. In general, single-wafer processing takes more time for substrate processing than batch processing. Therefore, the substrate processing system is configured by the plurality of single-wafer processing apparatuses and the one batch processing apparatus 1, so that it is possible to provide an apparatus with improved substrate processing speed.

The batch processing apparatus 1 of the present embodiment has the same configuration as the batch processing apparatus of the first embodiment. That is, the batch processing apparatus 1 of the present embodiment includes the stocker block 3 from which the first load port 9 on which the carrier C is placed protrudes, the transfer block 5 provided at a position adjacent to the stocker block 3, and the batch processing block 7. The single-wafer processing apparatus 2s of the present embodiment has the same configuration as the single-wafer processing apparatus of the first embodiment. That is, the single-wafer processing apparatus 2s of the present embodiment includes the indexer block 4 from which the second load port 10 on which the carrier C is placed protrudes, and the single-wafer processing block 8 including the plurality of single-wafer processing chambers.

The single-wafer processing apparatus 2t is not only a substrate processing apparatus itself, but is also a relay point for transferring the substrates W carried out from the batch processing apparatus 1 to the single-wafer processing apparatus 2s. Therefore, unlike the single-wafer processing apparatus 2 of the first embodiment, the single-wafer processing apparatus 2t does not include a chamber corresponding to the single-wafer processing chamber 48a. That is, the single-wafer processing apparatus 2t has two rectangular openings perpendicular to the Y direction for the purpose of allowing the relay apparatus 6 to pass therethrough. The openings are at the same position in the X direction, one of the openings being provided on a side facing the batch processing apparatus 1 and the other opening being provided on a side opposite thereto. By passing through these openings, the relay apparatus 6 is fitted through the single-wafer processing apparatus 2t. Therefore, the single-wafer processing apparatus 2t has a configuration in which the relay apparatus 6 is disposed instead of the single-wafer processing chamber around the openings.

The relay apparatus 6 crosses the batch processing apparatus 1 in the Y direction, and has one end extending through the single-wafer processing apparatus 2t to the inside of the single-wafer processing apparatus 2s positioned on the right side of the batch processing apparatus 1. The relay block includes the substrate standby bath 65 and the underwater attitude changer 55 similar to those in the first embodiment.

The relay apparatus 6 of the present embodiment includes a relay local conveyance mechanism LRb that conveys the substrates W in the horizontal attitude one by one. The relay local conveyance mechanism LRb is provided on the right side of the underwater attitude changer 55, and can access the underwater attitude changer 55. The relay local conveyance mechanism LRb accesses the in-bath carrier 71 that arranges and holds the substrates W in the horizontal attitude, and receives the substrate W at the uppermost position among the substrates W held by the in-bath carrier 71, above the immersion bath 73. The relay local conveyance mechanism LRb includes a hand that holds the substrate W. The relay local conveyance mechanism LRb can move the hand from side to side in the Y direction, and can also rotate the hand by 180° around a rotation axis extending in the Z direction. As a result, the hand can face the in-bath carrier 71 or can face a multistage belt conveyor mechanism 64 described below.

The multistage belt conveyor mechanism 64 is a mechanism extending in the Y direction and having a two-stage structure of an upper belt conveyor mechanism 64u and a lower belt conveyor mechanism 64d. The multistage belt conveyor mechanism 64 is positioned on the right side of the relay local conveyance mechanism LRb, and is configured to convey the substrate W transferred from the relay local conveyance mechanism LRb to the single-wafer processing apparatus 2s or the single-wafer processing apparatus 2t. To transfer the substrate W from the relay apparatus 6 to the single-wafer processing apparatus 2t, the lower belt conveyor mechanism 64d constituting the multistage belt conveyor mechanism 64 conveys the substrate W rightward. To transfer the substrate W from the relay apparatus 6 to the single-wafer processing apparatus 2s, the upper belt conveyor mechanism 64u conveys the substrate W rightward. As described above, the multistage belt conveyor mechanism 64 distributes the substrate W by conveying the substrate W on the upper side or the lower side. The upper belt conveyor mechanism 64u and the lower belt conveyor mechanism 64d have the same configuration as the first belt conveyor mechanism 67 of the first embodiment, and include a plurality of belts and a plurality of rollers.

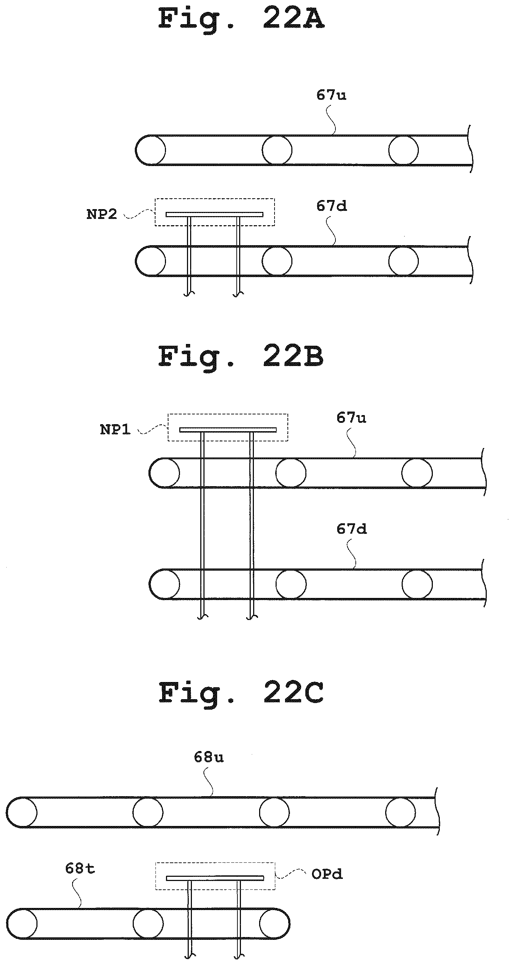

FIGS. 22A to 22C specifically illustrate the multistage belt conveyor mechanism 64. The multistage belt conveyor mechanism 64 includes three or more lift pins similar to the lift pins 70 described using FIG. 8D. The lift pins can freely protrude from and retract into the belts of the lower belt conveyor mechanism 64d. The lift pins can reach a relay position NP2 set above the lower belt conveyor mechanism 64d by extending in a first step (see FIG. 22A). The lift pins can reach a relay position NP1 set above the upper belt conveyor mechanism 64u by further extending in a second step (see FIG. 22B). The relay local conveyance mechanism LRb conveys the substrate W received from the in-bath carrier 71 to the relay position NP1 above the upper belt conveyor mechanism 64u or the relay position NP2 defined in a gap between the upper belt conveyor mechanism 64u and the lower belt conveyor mechanism 64d. When the substrate W is transferred to each relay position, the substrate W maintains the horizontal attitude in a state of being supported by the lift pins on standby on the spot. When the lift pins contract, the substrate W is transferred to the belts constituting the upper belt conveyor mechanism 64u or the lower belt conveyor mechanism 64d. The multistage belt conveyor mechanism 64 corresponds to the first belt conveyor mechanism 67 of the first embodiment.

A second belt conveyor mechanism 68t described in the first embodiment is provided on the right side of the lower belt conveyor mechanism 64d. In the second belt conveyor mechanism 68t, a carry-out position OPd at which the relay apparatus 6 discharges the substrate W to the single-wafer processing apparatus 2t is set. The plurality of lift pins 70 described in the first embodiment are provided at the carry-out position OPd. The substrate W conveyed in the Y direction is lifted and transferred to the center robot CR. As illustrated in FIG. 22C, the carry-out position OPd is defined in a gap between the second belt conveyor mechanism 68t and a through belt conveyor mechanism 68u described below.

The through belt conveyor mechanism 68u extending rightward relative to the second belt conveyor mechanism 68t is provided on the right side of the upper belt conveyor mechanism 64u. The through belt conveyor mechanism 68u is configured to convey the substrate W carried into the single-wafer processing apparatus 2t in the Y direction and send the substrate W to the outside of the single-wafer processing apparatus 2t. The through belt conveyor mechanism 68u is positioned above the second belt conveyor mechanism 68t.

A relay belt conveyor mechanism 61 extending rightward relative to the through belt conveyor mechanism 68u is provided on the right side of the through belt conveyor mechanism 68u. The relay belt conveyor mechanism 61 conveys rightward the substrate W carried out from the single-wafer processing apparatus 2t in the Y direction.

A second belt conveyor mechanism 68s described in the first embodiment is provided on the right side of the relay belt conveyor mechanism 61. In the second belt conveyor mechanism 68s, a carry-out position OPu at which the relay apparatus 6 discharges the substrate W to the single-wafer processing apparatus 2s is set. Therefore, in the relay apparatus 6 of the present embodiment, the plurality of carry-out positions are set. The plurality of lift pins 70 described in the first embodiment are provided at the carry-out position OPu. The substrate W conveyed in the Y direction is lifted and transferred to the center robot CR. The through belt conveyor mechanism 68u and the relay belt conveyor mechanism 61 have the same configuration as the first belt conveyor mechanism 67 of the first embodiment, and include a plurality of belts and a plurality of rollers.

In addition, a right shutter Sa corresponds to the second shutter S2 of the first embodiment, and is configured to block communication between the single-wafer processing apparatus 2s and the single-wafer processing apparatus 2t. The second shutter S2 on the left side is also configured to block communication between the single-wafer processing apparatus 2s and the single-wafer processing apparatus 2t, and is provided on the single-wafer processing apparatus 2t side.

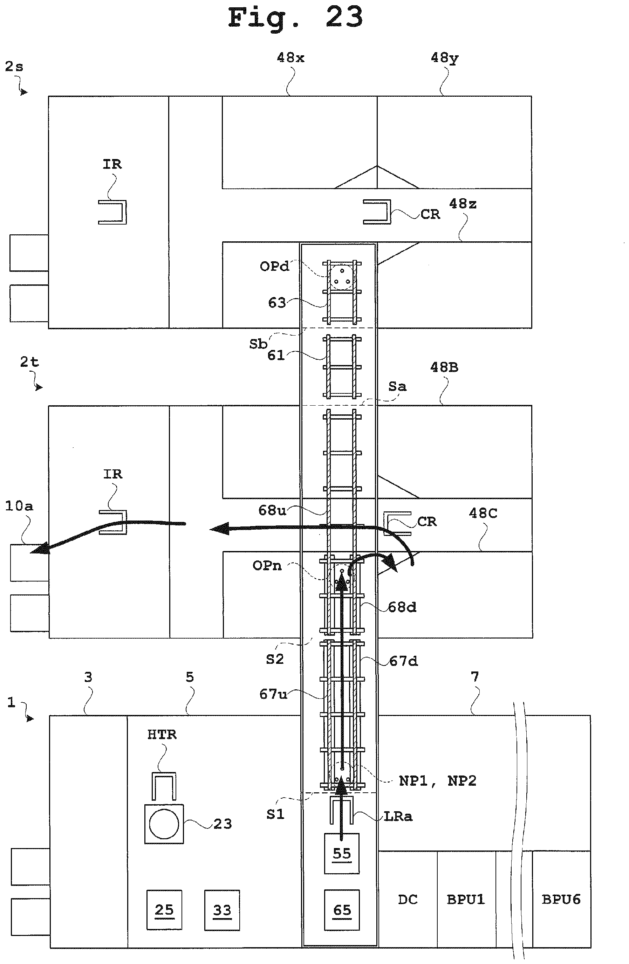

FIG. 23 illustrates a flow of the substrates according to the present embodiment. FIG. 23 illustrates a process of conveying the substrates W in the horizontal attitude one by one to the second load port 10 of the single-wafer processing apparatus 2t, and omits a process of collectively conveying the substrates. As illustrated in FIG. 23, each substrate W conveyed from the underwater attitude changer 55 to the lower belt conveyor mechanism 64d by the relay local conveyance mechanism LRb is first conveyed rightward to the single-wafer processing apparatus 2t. By repeating such conveyance, all the plurality of substrates W derived from the common carrier C are conveyed to the single-wafer processing apparatus 2t, and subjected to the single-wafer processing on the spot. The indexer robot IR allows all the single-wafer-processed substrates W to be accommodated in the single carrier C.

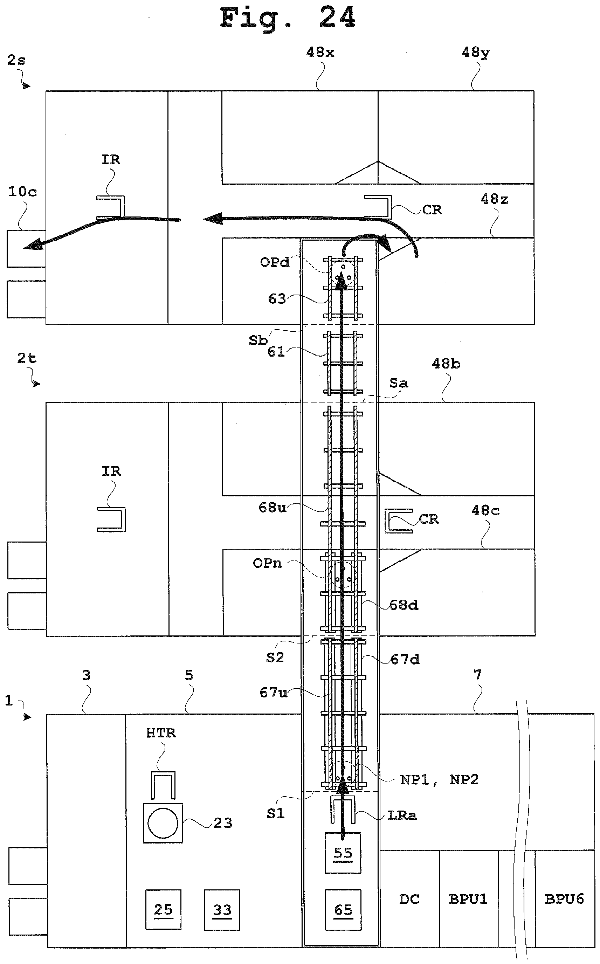

After finishing conveying the substrates W of one carrier C, the relay local conveyance mechanism LRb transfers each substrate W to the upper belt conveyor mechanism 64u as illustrated in FIG. 24. Thereafter, the substrate W is transferred sequentially to the through belt conveyor mechanism 68u, the relay belt conveyor mechanism 61, and the second belt conveyor mechanism 68s. In this way, the substrates W are conveyed one by one to the single-wafer processing apparatus 2s. By repeating such conveyance, all the plurality of substrates W derived from the common carrier C are conveyed to the single-wafer processing apparatus 2s, and subjected to the single-wafer processing on the spot. The indexer robot IR allows all the single-wafer-processed substrates W to be accommodated in the single carrier C.

According to the present embodiment, even during the substrate processing of the single-wafer processing apparatus 2t, the subsequent substrates W can be conveyed from the batch processing apparatus 1 to the single-wafer processing apparatus 2s as soon as the substrates W of one carrier C finish being conveyed. With such a configuration, the single-wafer processing can be simultaneously performed in parallel using the plurality of single-wafer processing apparatuses, so that it is possible to provide the substrate processing system having a high throughput.

The present invention can be modified as follows in addition to the above-described embodiments.

### <Modification 1>

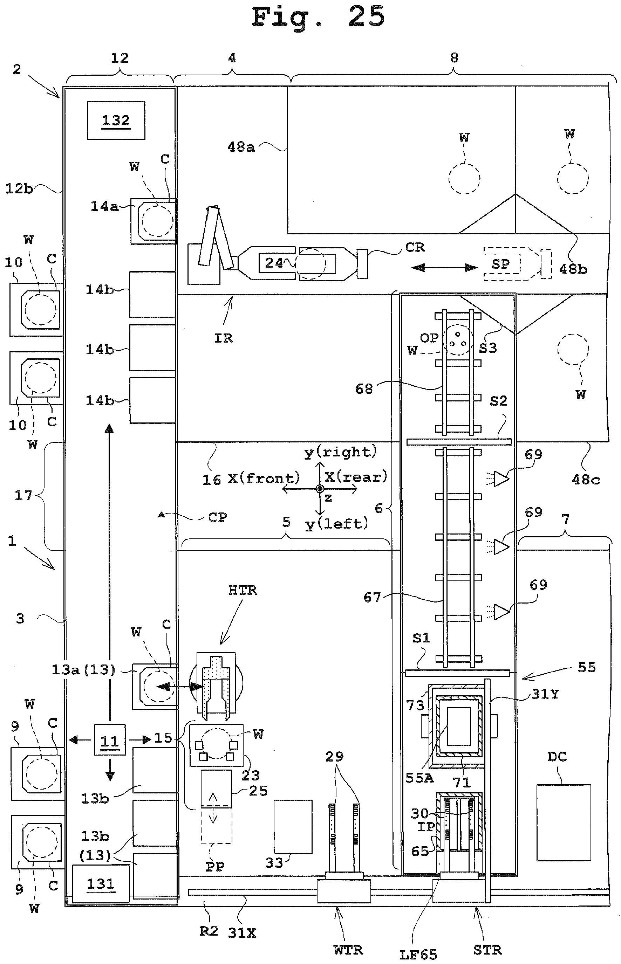

The above-described substrate processing system does not have a configuration for transporting the carrier C between the batch processing apparatus 1 and the single-wafer processing apparatus 2. However, the present invention is not limited to this configuration. The substrate processing system can also be configured as illustrated in FIG. 25. A configuration according to the present modification will be described with reference to this drawing. The single-wafer processing apparatus 2 of the present modification includes a carrier block 12 having a configuration similar to the stocker block 3 provided in the batch processing apparatus 1, between the indexer block 4 and the second load port 10. The carrier block 12 includes a plurality of shelves 14 on which the carrier C is placed. The shelves 14 are provided on a partition wall separating the carrier block 12 and the indexer block 4. The shelves 14 include a stock shelf 14b on which the carrier C is simply temporarily placed, and a carrier placement shelf 14a for substrate transfer to be accessed by the indexer robot IR of the indexer block 4. The carrier placement shelf 14a is configured to place thereon the carrier C in which the substrates W are to be accommodated. The carrier C that vertically arranges and accommodates the processed substrates W is placed on the carrier placement shelf 14a. Although one carrier placement shelf 14a is provided in the present modification, a plurality of the carrier placement shelves 14a may be provided.

The carrier block 12 of the single-wafer processing apparatus 2 and the stocker block 3 of the batch processing apparatus 1 are at the same position in the X direction. A communication path CP that allows the carrier C to move from side to side in the Y direction between the carrier block 12 and the stocker block 3 is provided between the carrier block 12 and the stocker block 3. The communication path CP is positioned inside a communication block 17 provided between the batch processing apparatus 1 and the single-wafer processing apparatus 2. The communication block 17 has a side wall and a top plate, and is configured to isolate the atmosphere in the substrate processing system from the outside air.

The carrier conveyance mechanism 11 in the stocker block 3 can move to the carrier block 12 of the single-wafer processing apparatus 2 through the communication path CP of the communication block 17. Therefore, the stocker block 3 and the carrier block 12 communicate with each other via the communication block 17.

The carrier conveyance mechanism 11 can convey the carrier C between the carrier placement shelf 14a and the second load port 10. When the carrier conveyance mechanism 11 conveys the carrier C from the carrier placement shelf 14a to the second load port 10, the batch-processed and single-wafer-processed substrates Ware discharged from the substrate processing system. This is because the processed substrates W are stacked and accommodated in the carrier C placed on the carrier placement shelf 14a. The carrier conveyance mechanism 11 can also temporarily place the carrier C on the stock shelf 14b before placing the carrier C on the second load port 10.

The carrier conveyance mechanism 11 can also convey the empty carrier C left on the carrier placement shelf 13a of the batch processing apparatus 1 to the single-wafer processing apparatus 2. The plurality of substrates Ware initially accommodated in the carrier C placed on the carrier placement shelf 13a. When the first substrate conveyance mechanism HTR accesses the carrier C in this state, and removes the plurality of substrates W from the carrier C, the carrier C becomes empty. The carrier conveyance mechanism 11 can convey the carrier C that has become empty from the carrier placement shelf 13a to the carrier placement shelf 14a or the shelf 14b. The carrier conveyance mechanism 11 conveys the empty carrier C conveyed to the shelf 14b, to the carrier placement shelf 14a at an appropriate timing.

Therefore, according to the configuration of the present modification, a correspondence relation between the carrier C and the substrates W can be maintained before and after the substrate processing. That is, according to the present modification, when the processed substrates W are carried into the empty carrier C, the same carrier C as the carrier accommodating the substrates W before the processing can be set as the carrier C into which the substrates are to be carried. This facilitates management of the substrates W.

### <Modification 2>

In the above-described embodiment, the three single-wafer processing chambers 48a, 48b, and 48c are provided so as to surround the base position SP of the center robot CR in the single-wafer processing apparatus 2. However, the base position SP may be surrounded by four single-wafer processing chambers. That is, the present modification has a configuration in which the carry-out position OP in the relay apparatus 6 is separated from the base position SP.

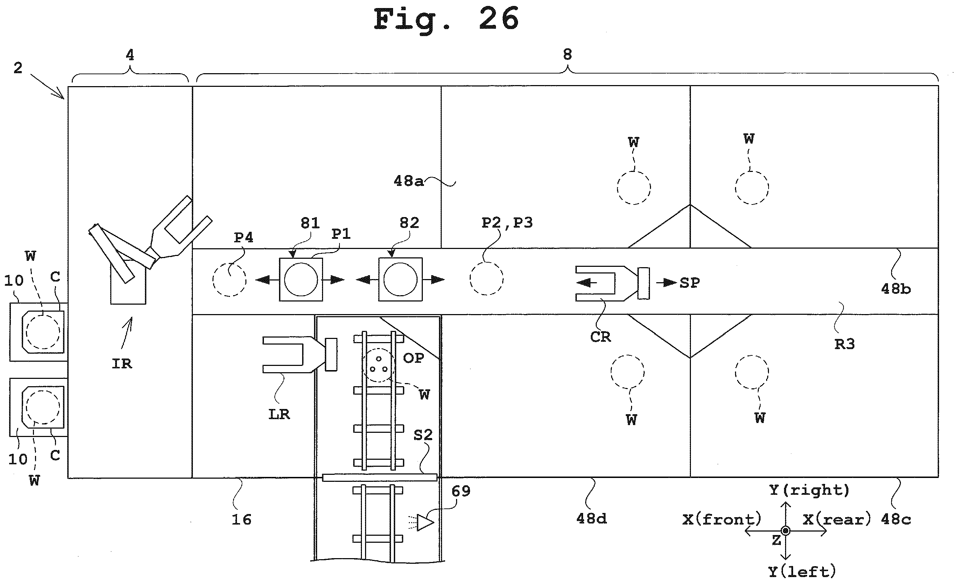

FIG. 26 specifically illustrates the present modification. In the substrate processing system according to the present modification, the base position SP of the center robot CR is surrounded by four single-wafer processing chambers as illustrated in this drawing. That is, with reference to the base position SP, the single-wafer processing chamber 48a is provided on the right front side, the single-wafer processing chamber 48b is provided on the right rear side, the single-wafer processing chamber 48c is provided on the left rear side, and a single-wafer processing chamber 48d is provided on the left front side. The single-wafer processing chamber 48d is positioned in a middle layer of a fourth stacked body including single-wafer processing chambers stacked in the Z direction. In this respect, the single-wafer processing chamber 48a belongs to the first stacked body described in the embodiment, the single-wafer processing chamber 48b belongs to the second stacked body described in the embodiment, and the single-wafer processing chamber 48c belongs to the third stacked body described in the embodiment. Therefore, the single-wafer processing block 8 includes 12 single-wafer processing chambers constituting the stacked bodies.

In the above-described embodiment, the carry-out position OP of the relay apparatus 6 is set on the left front side of the base position SP, whereas in the present modification, the single-wafer processing chamber 48d is provided at this position. The carry-out position OP of the relay apparatus 6 is disposed on the front side of the single-wafer processing chamber 48d.

In the present modification, the relay apparatus 6 and the base position SP at which the center robot CR can access each of the single-wafer processing chambers are separated from each other. Thus, a configuration is required that conveys the substrate W from the carry-out position OP of the relay apparatus 6 to the rear side of the single-wafer processing apparatus 2. In this regard, the single-wafer processing apparatus 2 of the present modification includes an outward shuttle mechanism 81 that conveys the substrate W before a drying treatment to the rear side of the single-wafer processing apparatus 2, in the single-wafer conveyance region R3. In the present modification, a configuration is also required that conveys the substrate W at the base position SP to a downstream position P4 to be described later accessible by the indexer robot IR. In this regard, the single-wafer processing apparatus 2 of the present modification includes a return shuttle mechanism 82 that conveys the substrate W after a drying treatment to the front side of the single-wafer processing apparatus 2, in the single-wafer conveyance region R3. The outward shuttle mechanism 81 conveys the substrate W in one direction. The return shuttle mechanism 82 conveys the substrate W in a direction opposite to the one direction. Each of the outward shuttle mechanism 81 and the return shuttle mechanism 82 includes a support body on which the substrate W is placed, and a moving mechanism that moves the support body in the X direction. The support body can support only one substrate W in the horizontal attitude.

A mechanism for reciprocating the substrate W in the single-wafer conveyance region R3 of the single-wafer processing apparatus 2 has a two-stage structure. The outward shuttle mechanism 81 is provided on a lower stage, and the return shuttle mechanism 82 is provided on an upper stage. Since the outward shuttle mechanism 81 conveys the substrate W before the drying treatment, pure water dripping from the substrate W adheres thereto. The pure water may drip from the outward shuttle mechanism 81. The dripping pure water does not reach the return shuttle mechanism 82 that conveys the substrate W after the drying treatment. This is because the return shuttle mechanism 82 is provided above the outward shuttle mechanism 81. As described above, according to the present modification, the substrate W after the drying treatment can surely be maintained in a dry state.

The outward shuttle mechanism 81 moves in the X direction from a receiving position P1 defined in the single-wafer conveyance region R3 as a starting point, to a transfer position P2 accessible by the first hand 32a of the center robot CR. The substrate W is placed on the outward shuttle mechanism 81 stopping at the receiving position P1. The substrate W is placed on the outward shuttle mechanism 81 and conveyed in the X direction.

The substrate W placed on the outward shuttle mechanism 81 and conveyed in the X direction stops when being conveyed to the transfer position P2.

The return shuttle mechanism 82 moves in the X direction from an upstream position P3 accessible by the second hand 32b of the center robot CR as a starting point, to the downstream position P4 accessible by the indexer robot IR. The upstream position P3 is positioned at the same position as the transfer position P2 in the X direction and the Y direction, and positioned above the transfer position P2.

The substrate W is placed on the return shuttle mechanism 82 stopping at the upstream position P3. The substrate W is placed on the return shuttle mechanism 82 and conveyed in the X direction.

The substrate W placed on the return shuttle mechanism 82 and conveyed in the X direction is conveyed to the downstream position P4. The downstream position P4 is a position accessible by the indexer robot IR.

The relay apparatus 6 is provided with a local robot LR that conveys the substrates W in the horizontal attitude one by one. The local robot LR can access the carry-out position OP of the relay apparatus 6 and the receiving position P1 of the single-wafer processing apparatus 2, and transfers the substrate W received at the carry-out position OP to the receiving position P1.

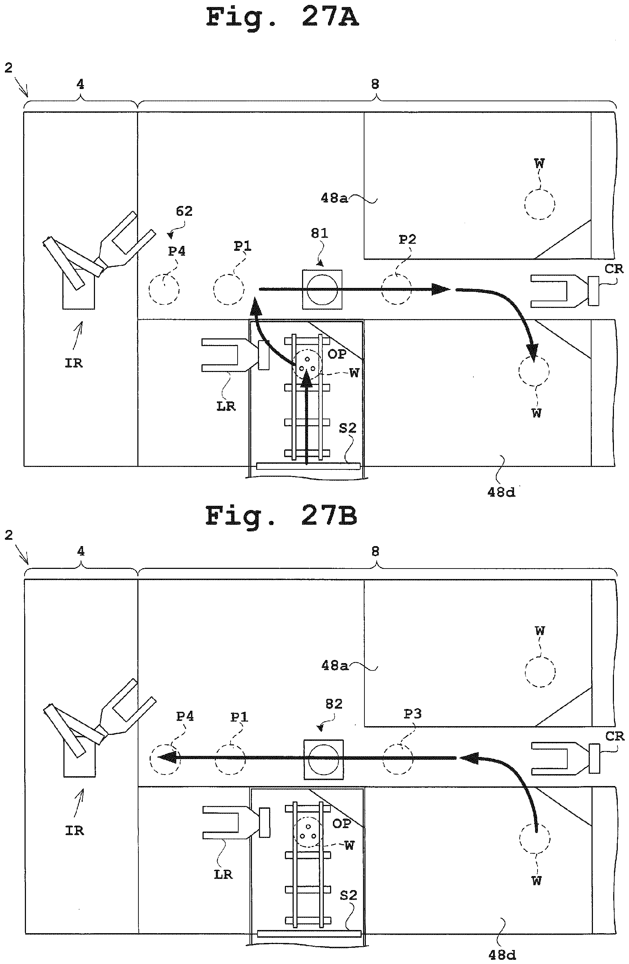

Therefore, the substrate W before the drying treatment in the present modification is conveyed from the carry-out position OP to the receiving position P1 by the local robot LR, and conveyed from the receiving position P1 to the transfer position P2 by the outward shuttle mechanism 81. The substrate W conveyed to the transfer position P2 is conveyed to each single-wafer processing chamber by the center robot CR. FIG. 27A illustrates a state in which the substrates W before the drying treatment are conveyed one by one.

The substrate W after the drying treatment in the present modification is conveyed from the single-wafer processing chamber to the upstream position P3 by the center robot CR, and conveyed from the upstream position P3 to the downstream position P4 by the return shuttle mechanism 82. FIG. 27B illustrates a state in which the substrates W after the drying treatment are conveyed one by one.

As described above, according to the present modification, the number of single-wafer processing chambers in the single-wafer processing apparatus 2 can be increased. This is because the center robot CR at the base position SP can access the four single-wafer processing chambers.

### <Modification 3>

The single-wafer processing apparatus 2 of the embodiment is provided with the single-wafer processing chamber for drying the substrate W by the spin-dry method. However, the present invention is not limited to this configuration, and can also adopt a configuration for drying the substrate W with a supercritical fluid. A substrate drying chamber mounted on the single-wafer processing apparatus 2 in the present modification is a supercritical fluid chamber. The supercritical fluid chamber performs a drying treatment on the substrate W with, for example, carbon dioxide that has become a supercritical fluid. As the supercritical fluid, a fluid other than carbon dioxide may also be used for drying. A supercritical state is obtained by placing carbon dioxide under inherent critical pressure and temperature. Specifically, the pressure is 7.38 MPa and the temperature is 31°C. In the supercritical state, the surface tension of the fluid becomes zero, so that a gas-liquid interface does not affect a circuit pattern on the surface of the substrate W. Therefore, when the drying treatment is performed on the substrate W with the supercritical fluid, it is possible to prevent the occurrence of so-called pattern collapse in which a circuit pattern collapses on the substrate W.

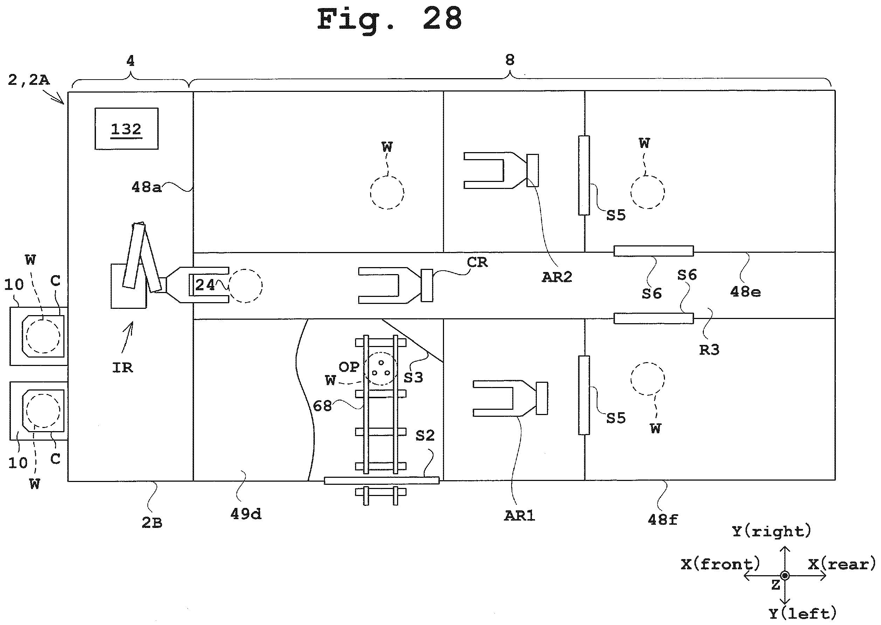

FIG. 28 illustrates a configuration of the single-wafer processing apparatus 2 according to the present modification. Each supercritical fluid chamber includes an inlet through which the substrate W before the drying treatment is carried in, and an outlet through which the substrate W after the drying treatment is carried out. The inlet is positioned on the front side or the rear side of the supercritical fluid chamber, and includes an openable shutter S5. The outlet is positioned on a side wall of the supercritical fluid chamber, and includes an openable shutter S6. The shutter S5 and the shutter S6 are closed during the drying treatment with the supercritical fluid. The inlets of the supercritical fluid chambers face a first wet conveyance robot AR1 and a second wet conveyance robot AR2. The outlets thereof face the single-wafer conveyance region R3.

The single-wafer processing apparatus 2 according to the present modification is characterized in that two robots are added in the single-wafer processing block 8. The first wet conveyance robot AR1, which is one of the added robots, is provided in a region sandwiched between the second belt conveyor mechanism 68 and a supercritical fluid chamber 48f positioned on the left side of the single-wafer conveyance region R3. The second wet conveyance robot AR2, which is the other robot, is provided in a region sandwiched between the single-wafer processing chamber 48a and a supercritical fluid chamber 48e positioned on the right side of the single-wafer conveyance region R3.

In addition, the single-wafer processing block 8 is provided with a single-wafer processing chamber capable of performing a chemical treatment. The single-wafer processing chamber is not a supercritical fluid chamber, but a chemical treatment chamber including the chemical solution nozzle 8b for supplying a chemical solution to the substrate W. Two chemical treatment chambers are provided in the single-wafer processing block 8. One of them is the single-wafer processing chamber 48a described above. The other is the single-wafer processing chamber 49d positioned above the second belt conveyor mechanism 68. As described with reference to FIG. 12, the chemical treatment chamber 49d is positioned on the relay apparatus 6. The chemical solution may be IPA. The chemical treatment chamber has an explosion-proof property enough to handle flammable IPA. In this way, the chemical treatment chamber can safely perform a required IPA treatment before the drying treatment with the supercritical fluid. However, the chemical solution used in the chemical treatment chamber of the present modification is not limited to IPA.

The position of the chemical treatment chamber can be relatively freely changed. One of the two chemical treatment chambers is positioned on the right side of the single-wafer conveyance region R3, and the other is positioned on the left side thereof. With such a configuration, it becomes unnecessary to cause the center robot CR positioned in the single-wafer conveyance region R3 to receive the IPA-treated substrate W. That is, since the substrate W subjected to the chemical treatment in the chemical treatment chamber is conveyed to the supercritical fluid chamber by the first wet conveyance robot AR1 or the second wet conveyance robot AR2, the throughput does not decrease due to congestion of the substrates W waiting for the IPA treatment.

The first wet conveyance robot AR1 receives the substrates W before the drying treatment (the substrates W after the chemical treatment) in the horizontal attitude one by one from the single-wafer processing chamber 49d, and carries each substrate W into any one of the supercritical fluid chambers positioned on the left side of the single-wafer conveyance region R3 from the above-described inlet. Therefore, a substrate conveyance hand of the first wet conveyance robot AR1 can access all the inlets of the single-wafer processing chamber 49d and the supercritical fluid chambers in the vicinity thereof. Since the chambers are stacked in the Z direction, the hand can move in the height direction. The chambers include a chamber on the front side of the first wet conveyance robot AR1 and a chamber on the rear side of the first wet conveyance robot AR1. Therefore, the hand can be directed forward or backward.

The second wet conveyance robot AR2 has the same configuration as the first wet conveyance robot AR1 described above. The second wet conveyance robot AR2 receives the substrates W before the drying treatment (the substrates W after the chemical treatment) in the horizontal attitude one by one from the single-wafer processing chamber 48a, and carries each substrate W into any one of the supercritical fluid chambers positioned on the right side of the single-wafer conveyance region R3 from the above-described inlet. Therefore, a substrate conveyance hand of the second wet conveyance robot AR2 can access all of the chambers forming the front stacked body and the chambers forming the rear stacked body.

The center robot CR can access the outlets of the supercritical fluid chambers. The second hand 32b of the center robot CR carries out the substrate W after the drying treatment through the above outlet from any one of the supercritical fluid chambers positioned on the left side of the single-wafer conveyance region R3 or the supercritical fluid chambers positioned on the right side thereof.

The center robot CR can also access the carry-out position OP in the relay apparatus 6.

The center robot CR can also access the pass 24 for transferring the substrate W to the indexer robot IR.

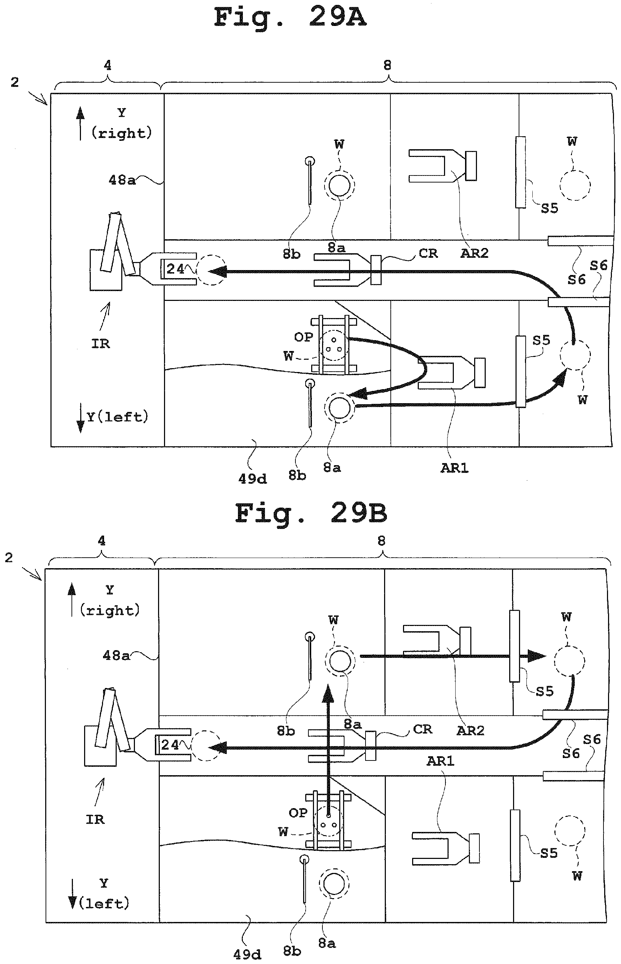

FIGS. 29A and 29B illustrate a flow of the substrate W according to the present modification. The present modification adopts roughly two substrate conveyance methods, and the respective methods will be described sequentially. FIG. 29A illustrates a first substrate conveyance method. According to this method, the substrate W positioned at the carry-out position OP in the relay apparatus 6 is first received by the center robot CR, and transferred to the single-wafer processing chamber 49d that is a chemical treatment chamber. The IPA-treated substrate W is then received by the first wet conveyance robot AR1 in an undried state, and conveyed to any one of the supercritical fluid chambers positioned on the left side of the single-wafer conveyance region R3. The substrate W after the drying treatment is then received by the center robot CR, and conveyed to the pass 24 accessible by the indexer robot IR. In this way, the substrate W carried into the single-wafer processing block 8 is discharged to the indexer block 4 after the single-wafer processing.

FIG. 29B illustrates a second substrate conveyance method. According to this method, the substrate W positioned at the carry-out position OP in the relay apparatus 6 is first received by the center robot CR, and transferred to the single-wafer processing chamber 48a that is a chemical treatment chamber. The IPA-treated substrate W is then received by the second wet conveyance robot AR2 in an undried state, and conveyed to any one of the supercritical fluid chambers positioned on the right side of the single-wafer conveyance region R3. The substrate W after the drying treatment is received by the center robot CR again, and conveyed to the pass 24 accessible by the indexer robot IR. In this way, the substrate W carried into the single-wafer processing block 8 is discharged to the indexer block 4 after the single-wafer processing.

Which method is used to dry the substrate W is determined by the availability of the supercritical fluid chamber.

In any method, the substrate W positioned at the carry-out position OP is subjected to the chemical treatment and the drying treatment, and conveyed to the pass 24. The indexer robot IR receives the substrate W held by the pass 24 and conveys the substrate W to the empty carrier C. In this way, the substrate processing of the present modification ends.

As described above, according to the present modification, it is possible to perform the substrate processing in which no pattern collapse occurs on the device surface by using the supercritical fluid chamber for drying the substrate. In order to dry the substrate in the supercritical fluid chamber, it is necessary to first perform a pretreatment using a chemical solution on the substrate W. According to the configuration of the present modification, one chemical treatment chamber is provided on the left side of the single-wafer conveyance region R3, and one chemical treatment chamber is provided on the right side thereof. Thus, the pretreatment can surely be performed. The number of chemical treatment chambers of the present modification is not limited to the above-described configuration. A plurality of chemical treatment chambers may be provided on the left side of the single-wafer conveyance region R3, or a plurality of chemical treatment chambers may be provided on the right side of the single-wafer conveyance region R3.

### <Modification 4>

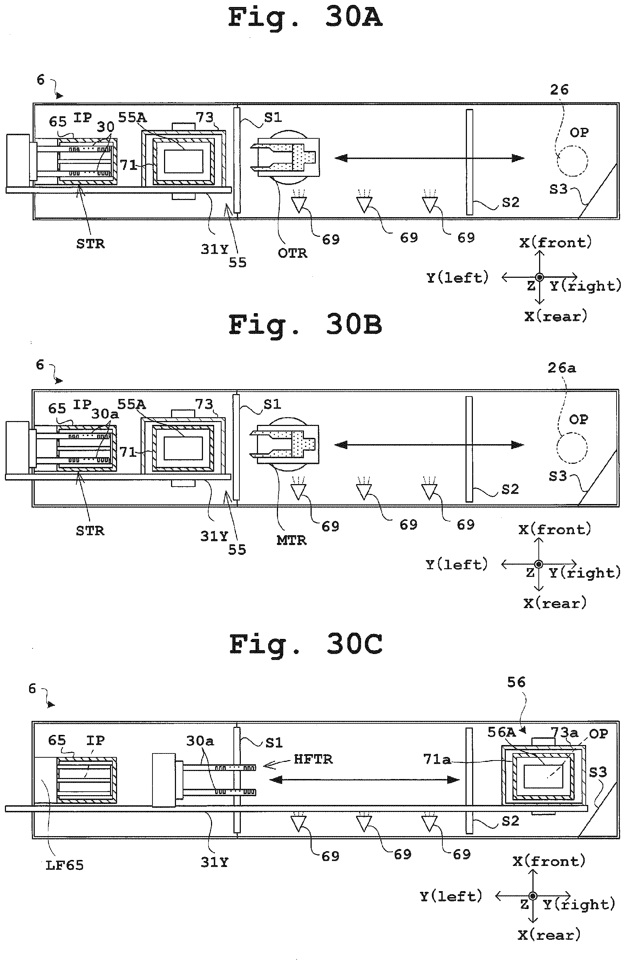

In the above-described embodiment, the belt conveyor mechanism of the relay apparatus 6 is configured to convey the substrates W in the horizontal attitude one by one. However, the present invention is not limited to this configuration. As illustrated in FIG. 30A, a third substrate conveyance mechanism OTR movable in the Y direction may be provided instead of the belt conveyor mechanism. The third substrate conveyance mechanism OTR is movable from the first shutter S1 to the carry-out position OP across the second shutter S2, and is also movable in a direction opposite thereto. The third substrate conveyance mechanism OTR can also receive the substrates W in the horizontal attitude one by one from the in-bath carrier 71 and convey the substrates W to the carry-out position OP. A pass 26 is provided at the carry-out position OP of the present modification. The third substrate conveyance mechanism OTR transfers the substrates W in the horizontal attitude one by one to the center robot CR of the single-wafer processing apparatus 2 via the pass 26. According to this configuration, the second shutter S2 can be provided in the middle of the substrate conveyance path without providing the plurality of belt conveyor mechanisms, and the apparatus configuration is simplified. The third substrate conveyance mechanism OTR has a hand that grips the substrate W. The hand directly accesses the in-bath carrier 71 to receive the substrate W. Therefore, the present modification can be configured such that the in-bath carrier shift mechanism 57C and the substrate shift mechanism 57D described in the embodiment are omitted.

### <Modification 5>

The configuration according to Modification 4 described above is a configuration in which the third substrate conveyance mechanism OTR conveys the substrates W one by one from the in-bath carrier 71 of the underwater attitude changer 55 to the carry-out position OP. However, the present invention is not limited to this configuration. Instead of the third substrate conveyance mechanism OTR, a fourth substrate conveyance mechanism MTR capable of collectively conveying the plurality of substrates W may be provided as illustrated in FIG. 30B, and the 25 substrates W arranged at the full pitch may be conveyed to the carry-out position OP. The carry-out position OP is provided with a pass 26a capable of stacking in the Z direction and holding the 25 substrates W in the horizontal attitude. The fourth substrate conveyance mechanism MTR conveys the plurality of received substrates W to the pass 26a. The fourth substrate conveyance mechanism MTR receives the plurality of substrates W in the horizontal attitude from the in-bath carrier 71, and conveys the substrates W to the pass 26a while maintaining the attitude. The center robot CR in the single-wafer processing apparatus 2 conveys the plurality of substrates W arranged in the pass 26a one by one from the top to each single-wafer processing chamber. With such a configuration, the substrate conveyance inside the relay apparatus 6 can be efficiently performed. It is also possible to prevent the substrates W waiting to be conveyed by the center robot CR from drying out by providing a pure water bath at the position of the pass 26a in the present modification, and immersing the substrates W therein. The relay apparatus 6 in this case includes a raising/lowering mechanism that raises and lowers the pass 26a.

### <Modification 6>

The relay apparatus 6 according to the above-described embodiment is configured to receive the plurality of substrates W arranged in the face-to-face manner at the carry-in position IP. However, the present invention is not limited to this configuration. The plurality of substrates W arranged in a face-to-back manner may be received at the carry-in position IP. In the present modification, a batch assembling method performed in the transfer block 5 is different from that of the embodiment. That is, the pusher mechanism 25 provided in the transfer block 5 in the embodiment (see FIGS. 4A to 4F) does not perform an operation of rotating the pusher 25A by 180° as described with reference to FIG. 4D when assembling a batch. By not performing this operation, the plurality of substrates Ware assembled into a batch without being inverted. Therefore, the substrates W of the lot configured by the batch assembly are arranged in the face-to-back manner with all the device surfaces directed leftward. The pusher 25A that has received the first substrates W1 can receive the second substrates W2 each between the adjacent first substrates W1 by shifting only by the half pitch. The horizontal mover 25C of the pusher mechanism 25 moves the pusher 25A.

According to the present modification, the configuration of the embodiment can be further simplified. In the embodiment, it is necessary to rotate the pusher 55A in the underwater attitude changer 55 by at least 180°. In comparison, according to the present modification, such complicated control is not required. This is because all the device surfaces of the substrates W constituting the lot are directed upward only by rotating the in-bath carrier 71 counterclockwise by 90°.

### <Modification 7>

In the case of adopting a configuration in which the plurality of substrates W arranged in the face-to-back manner are received at the carry-in position IP, the lot carried into the carry-in position IP may be conveyed to the carry-out position OP without changing the attitude as illustrated in FIG. 30C. As a result, the relay apparatus 6 can be further simplified. The substrate conveyance in the relay apparatus 6 in the present modification is performed by conveying the lot in which the substrates W in the vertical attitude are arranged at the half pitch. That is, the relay apparatus 6 of the present modification includes a half-pitch substrate conveyance mechanism HFTR capable of conveying the substrates W arranged at the half pitch, instead of the full-pitch arrangement substrate conveyance mechanism STR in the embodiment. The half-pitch substrate conveyance mechanism HFTR is movable from the carry-in position IP to the carry-out position OP, and is also movable in a direction opposite thereto. The half-pitch substrate conveyance mechanism HFTR can receive the lot from the lifter LF65 of the substrate standby bath 65 on the spot by accessing the carry-in position IP, and can transfer the lot to the in-bath carrier 71 of the underwater attitude changer 55 on the spot by accessing the carry-out position OP. The half-pitch substrate conveyance mechanism HFTR is configured to receive the plurality of substrates W by a pair of chucks 30a. In each chuck 30a, grooves for gripping the substrates Ware arranged at the half pitch.

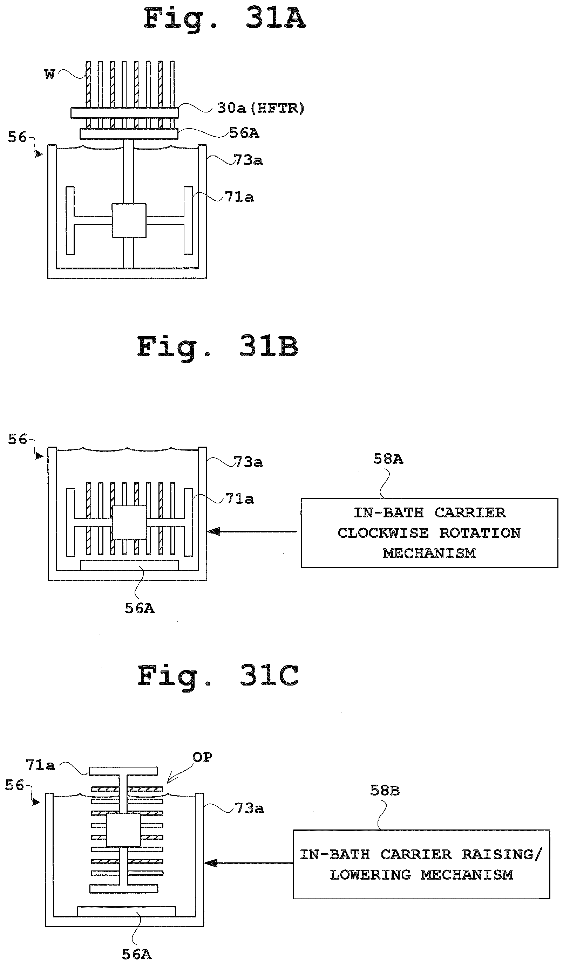

An underwater attitude changing device 56 having the same configuration as the underwater attitude changer 55 described in the embodiment is positioned at the carry-out position OP. The underwater attitude changing device 56 includes an in-bath carrier 71a capable of collectively receiving the 50 substrates arranged at the half pitch. The in-bath carrier 71a is positioned in an immersion bath 73a in which the lot is immersed in pure water. A pusher 56A is configured to hold the substrates W arranged at the half pitch, and is movable from a bottom surface of the immersion bath 73a to above the immersion bath 73a. FIG. 31A illustrates a state in which the substrates W are transferred from the half-pitch substrate conveyance mechanism HFTR to the pusher 56A of the underwater attitude changing device 56.

FIG. 31B illustrates a state when the pusher 56A then returns to the bottom surface of the immersion bath 73a. In this case, the plurality of substrates W held by the pusher 56A do not reach the bottom surface of the immersion bath 73a. This is because the in-bath carrier 71a stands by inside the immersion bath 73a. The in-bath carrier 71a can hold the plurality of substrates W arranged at the half-pitch intervals. An in-bath carrier clockwise rotation mechanism 58A can rotate the in-bath carrier 71a clockwise by 90° in a state in which the substrates W are immersed in the immersion bath 73a.

FIG. 31C illustrates a state in which the in-bath carrier 71a is raised by an in-bath carrier raising/lowering mechanism 58B after being rotated clockwise. At this time, the in-bath carrier 71a assumes a state in which only the uppermost substrate W among the held substrates W is positioned above the immersion bath 73a. The substrate W positioned above the immersion bath 73a is conveyed to each single-wafer processing chamber by the center robot CR. Therefore, the position above the immersion bath 73a corresponds to the carry-out position OP.

Thereafter, the uppermost substrate W is received by the center robot CR each time the in-bath carrier 71a is drawn out by the width of the half pitch by the in-bath carrier raising/lowering mechanism 58B. In this way, the substrates W held by the in-bath carrier 71a are conveyed to the single-wafer processing chambers one by one.

The substrates W constituting the lot include the first substrates W1 derived from the first carrier C and the second substrates W2 derived from the second carrier C. When conveying the substrates W to the second load port 10, the indexer robot IR conveys only the first substrates W1 to one of the two carriers C placed on the second load port 10 and conveys only the second substrates W2 to the other. With such a configuration, the first substrates W1 and the second substrates W2 are accommodated in the individual carriers C without being mixed, which facilitates management of the substrates W.

As described above, the apparatus configuration of the present modification is simpler than the apparatus configuration of the embodiment, so that it is possible to provide the substrate processing system that can be easily controlled.

### <Modification 8>

The relay apparatus 6 according to the above-described embodiment includes the shower heads 69. However, the present invention is not limited to this configuration, and does not have to include the shower heads 69 and the liquid supply part related thereto.

### <Modification 9>

The relay apparatus 6 according to the above-described embodiment includes the first shutter S1 and the second shutter S2. However, the present invention is not limited to this configuration, and does not have to include either or both of the first shutter S 1 and the second shutter S2.

### <Modification 10>

The relay apparatus 6 according to the above-described embodiment is positioned in the middle layer of the stacked body including the single-wafer processing chambers in the single-wafer processing apparatus 2. However, the present invention is not limited to this configuration, and the relay apparatus 6 may be positioned in an upper layer of the stacked body. With such a configuration, a maintenance space in a gap between the batch processing apparatus 1 and the single-wafer processing apparatus 2 is not divided by the relay apparatus 6, so that it is possible to provide the substrate processing system that is easy for maintenance. Similarly, the relay apparatus 6 may also be positioned in a lower layer of the stacked body.

### <Modification 11>

Although the relay apparatus 6 according to the above-described embodiment is positioned on the rear side of the transfer block 5, the present invention is not limited to this configuration. The relay apparatus 6 may be disposed on the rear side of the batch processing block 7.

### <Modification 12>

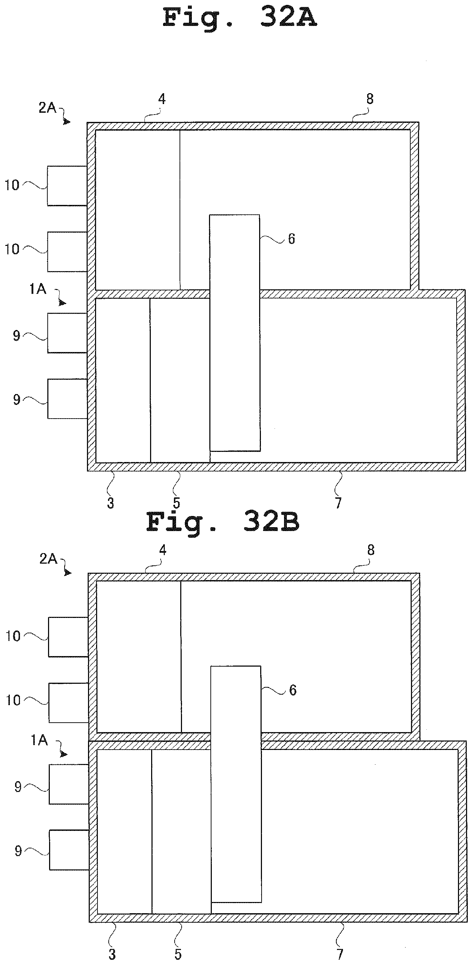

The substrate processing system according to the above-described embodiment includes the first housing 1A related to the batch processing apparatus 1, the second housing 2A related to the single-wafer processing apparatus 2, and the relay housing 6A that connects the first housing 1A and the second housing 2A. However, the present invention is not limited to this configuration. As illustrated in FIG. 32A, it is also possible to configure a substrate processing system including a common wall surface forming the first housing 1A and the second housing 2A and incorporating the relay housing 6A. According to the present modification, the relay apparatus 6 is incorporated in the housing of the substrate processing system. With such a configuration, it is possible to provide the substrate processing system with a small number of components.

### <Modification 13>

In the configuration of Modification 12 described above, the first housing 1A and the second housing 2A have the common wall surface. However, the present invention is not limited to this configuration. As illustrated in FIG. 32B, the relay housing 6A may be incorporated by individually providing a wall surface of the first housing 1A and a wall surface of the second housing 2A, and making a side surface of the first housing 1A and a side surface of the second housing 2A adjacent to each other in the Y direction. By doubly providing the wall surfaces separating the batch processing apparatus 1 and the single-wafer processing apparatus 2 in the first housing 1A and the second housing 2A, an existing substrate processing apparatus including its housing can be utilized in the substrate processing system of the present invention.

### <Modification 14>

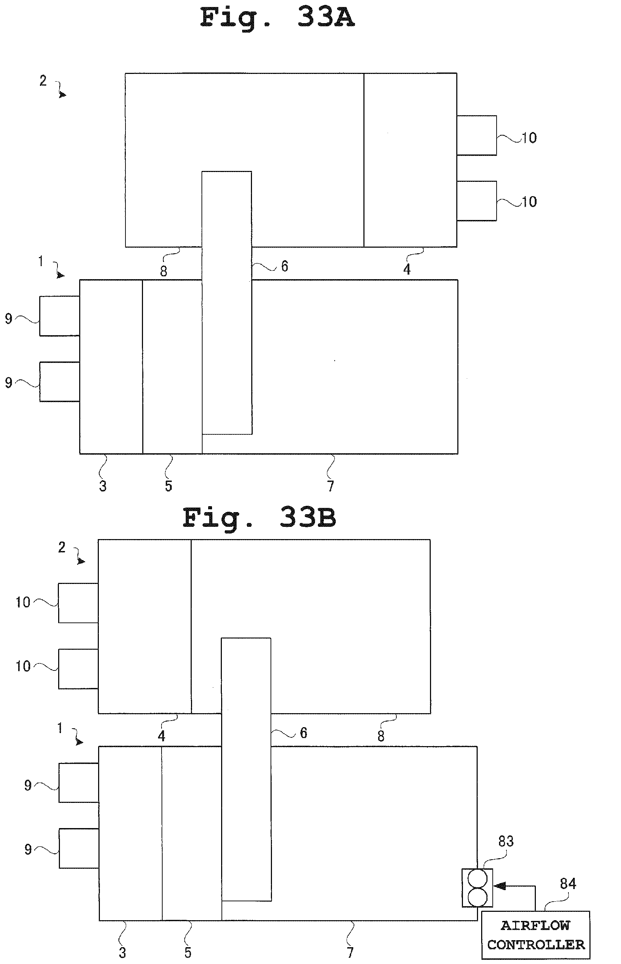

The first load port 9 of the batch processing apparatus 1 and the second load port 10 of the single-wafer processing apparatus 2 according to the above-described embodiment are at the same position in the X direction. However, the present invention is not limited to this configuration. As illustrated in FIG. 33A, the first load port 9 may be installed on a front wall surface of the first housing 1A constituting the batch processing apparatus 1, and the second load port 10 may be installed on a rear wall surface of the second housing 2A constituting the single-wafer processing apparatus 2. Thus, the first load port 9 and the second load port 10 can be disposed at different positions in the X direction.

### <Modification 15>

As illustrated in FIG. 33B, the substrate processing system according to the above-described embodiment may include an airflow generator 83 that generates an airflow inside the system. A specific configuration of the airflow generator 83 may be a fan, a pump, and the like. The airflow generator 83 is provided in at least one of the batch processing apparatus 1, the single-wafer processing apparatus 2, and the relay apparatus 6 so as to allow the atmosphere of the relay apparatus 6 to flow into the batch processing apparatus 1. With such a configuration, even if a phosphoric acid solution handled in the batch processing apparatus 1 drifts in the air as spray, the phosphoric acid solution does not reach the single-wafer processing apparatus 2. In this way, each chamber and each robot mechanism constituting the single-wafer processing apparatus 2 are not corroded by acid. An airflow controller 84 is configured to control the airflow generator. The airflow controller 84 is a part of the first controller 131.

### <Modification 16>

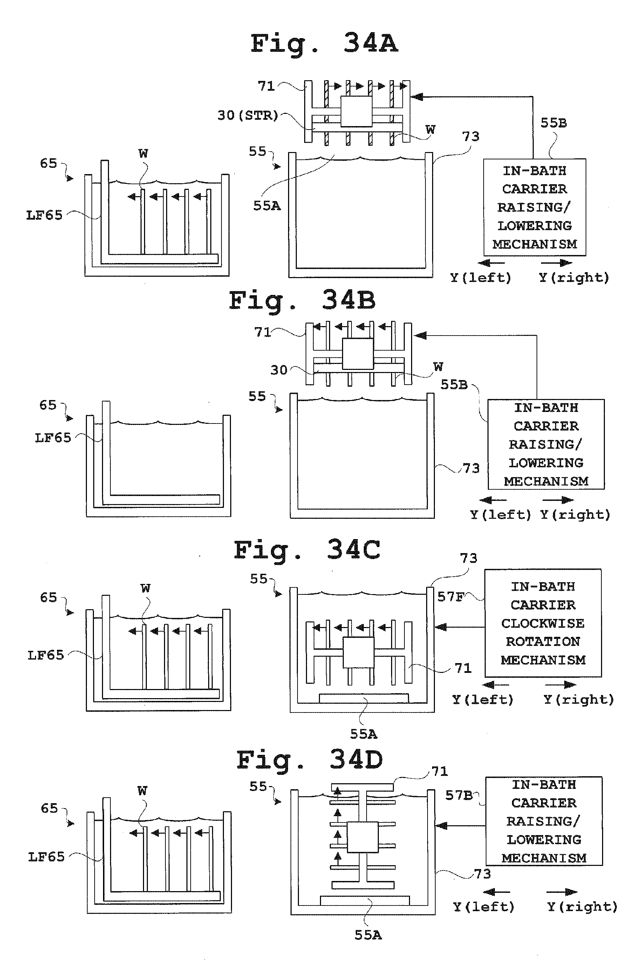

In the above-described embodiment, the pusher 55Ais provided in the immersion bath 73. However, the present invention is not limited to this configuration. The pusher 55A does not have to be provided as illustrated in FIGS. 34A to 34D. FIG. 34A illustrates a configuration of the present modification in which the chucks 30 of the full-pitch arrangement substrate conveyance mechanism STR directly transfer the plurality of substrates W to the in-bath carrier 71 positioned above the immersion bath 73. That is, the in-bath carrier 71 of the present modification can ascend to above the immersion bath 73. The ascending and descending action of the in-bath carrier 71 is achieved by an in-bath carrier raising/lowering mechanism 55B. When the in-bath carrier 71 descends into the immersion bath 73 from the state of FIG. 34A, the same state as that of FIG. 7B is obtained. The subsequent operations of the in-bath carrier 71 are similar to those of the above-described embodiment.

The lot in which the 50 substrates W are arranged at the half pitch is conveyed in two times by the full-pitch arrangement substrate conveyance mechanism STR capable of conveying the 25 substrates W. The present modification has a characteristic configuration in the second conveyance. FIG. 34B illustrates a state in which the in-bath carrier 71 receives the substrates W from the chucks 30 above the immersion bath 73 in the second conveyance. At this time, all the device surfaces of the substrates W are directed leftward, which is different from FIG. 34A.

As illustrated in FIG. 34C, the in-bath carrier 71 that has received the substrates W arranged in such a direction is first immersed in pure water in the immersion bath 73. Thereafter, the in-bath carrier 71 is rotated clockwise by 90° in the immersion bath 73. As described above, all the device surfaces of the substrates W directed leftward are rotated clockwise, so that the device surfaces are all directed upward (see FIG. 34D). Such rotation of the in-bath carrier 71 is achieved by an in-bath carrier clockwise rotation mechanism 57F. FIG. 34D corresponds to FIG. 7C of the embodiment. The subsequent operations of the in-bath carrier 71 are similar to those of the above-described embodiment. Since the substrate processing system can be configured without providing the pusher 55A in the immersion bath 73, the present modification is more advantageous than the embodiment in terms of cost.

### <Modification 17>

The substrate processing system in Modification 7 includes the pusher 56A, but the present invention is not limited to this configuration. It is also possible to adopt a configuration in which the pusher 56A is omitted by the half-pitch substrate conveyance mechanism HFTR transferring the plurality of substrates W arranged at the half pitch to the in-bath carrier 71 positioned above the immersion bath 73. The present modification has the same configuration as Modification 16.

## Claims

1. A substrate processing system that continuously performs batch processing of collectively processing a plurality of substrates and single-wafer processing of processing the substrates one by one, the substrate processing system comprising:
a batch processing apparatus (1) configured to perform batch processing;
at least one single-wafer processing apparatus (2) configured to perform single-wafer processing on a batch-processed substrate; and
at least one relay apparatus (6) in which two positions are defined, one being a carry-in position for receiving the batch-processed substrate from the batch processing apparatus (1), and the other being a carry-out position for transferring the substrate received at the carry-in position to the single-wafer processing apparatus (2),
wherein the batch processing apparatus (1) includes:
a first carrier placement shelf (13a) on which a carrier is placed, the carrier accommodating a plurality of substrates in a horizontal attitude at a predetermined interval in a vertical direction; a transfer block (5) adjacent to the first carrier placement shelf (13a); and a batch processing block (7) adjacent to the transfer block (5),
the transfer block (5) includes:
a substrate handling mechanism (HTR) configured to collectively take out the plurality of substrates from the carrier placed on the first carrier placement shelf (13a); and
a first attitude changing mechanism (23) configured to collectively change the plurality of substrates taken out from the carrier from the horizontal attitude to a vertical attitude,
the batch processing block (7) includes:
at least one batch processing bath in which the plurality of substrates in the vertical attitude are collectively immersed; and
a collective conveyance mechanism (WTR) configured to collectively convey the plurality of substrates in the vertical attitude among the transfer block (5), the batch processing bath, and the carry-in position of the relay apparatus (6),
the single-wafer processing apparatus (2) includes:
a second carrier placement shelf (10) on which the carrier is placed; an indexer block (4) adjacent to the second carrier placement shelf (10); and a single-wafer processing block (8) adjacent to the indexer block (4),
the single-wafer processing block (8) includes:
a plurality of single-wafer processing chambers (48a,48b, 48c) configured to perform a drying treatment on the substrates in a horizontal attitude one by one; and
a single-wafer conveyance mechanism (CR) configured to receive the batch-processed substrates in the horizontal attitude one by one from the carry-out position of the relay apparatus (6) and convey the substrates to the single-wafer processing chambers (48a,48b, 48c),
the indexer block (4) includes an)indexer robot (IR) configured to allow the single-wafer-processed substrates to be accommodated in the carrier placed on the second carrier placement shelf (10), and
the relay apparatus (6) includes:
a second attitude changing mechanism (55) configured to change the plurality of substrates received from the batch processing apparatus (1) from the vertical attitude to the horizontal attitude; and
a relay conveyance mechanism (STR, 67, 68) configured to convey the substrates along a substrate conveyance path provided between the carry-in position and the carry-out position.

2. The substrate processing system according to claim 1, wherein, in the relay apparatus (6),
the second attitude changing mechanism (55) is provided on the carry-in position side, the relay apparatus (6) further including a single-wafer substrate shift mechanism configured to take out, one by one, the plurality of substrates collectively changed from the vertical attitude to the horizontal attitude by the second attitude changing mechanism (55), and transfer the substrates to the relay conveyance mechanism (STR, 67, 68), and
the relay conveyance mechanism (STR, 67, 68) conveys the substrates in the horizontal attitude transferred from the single-wafer substrate shift mechanism, one by one toward the carry-out position.

3. The substrate processing system according to claim 1, wherein, in the relay apparatus (6),
the second attitude changing mechanism (55) is provided on the carry-in position side, and
the relay conveyance mechanism (STR, 67, 68) collectively conveys the plurality of substrates collectively changed from the vertical attitude to the horizontal attitude by the second attitude changing mechanism (55), toward the carry-out position.

4. The substrate processing system according to claim 1, wherein, in the relay apparatus (6),
the second attitude changing mechanism (55) is provided on the carry-out position side,
the relay conveyance mechanism (STR, 67, 68) collectively conveys the plurality of substrates in the vertical attitude received from the batch processing apparatus (1), to the second attitude changing mechanism (55), and
the second attitude changing mechanism (55) collectively changes the plurality of substrates received from the relay conveyance mechanism (STR, 67, 68) from the vertical attitude to the horizontal attitude.

5. The substrate processing system according to claim 1, wherein the relay conveyance mechanism (STR, 67, 68) includes a belt conveyor mechanism.

6. The substrate processing system according to claim 1, wherein the relay conveyance mechanism (STR, 67, 68) includes a robot configured to grip the substrate.

7. The substrate processing system according to claim 1, wherein the relay apparatus (6) includes, at the carry-in position, a standby bath in which the plurality of substrates in the vertical attitude carried in from the batch processing apparatus (1) are immersed in a liquid.

8. The substrate processing system according to claim 1, wherein the relay apparatus (6) includes a liquid supply part configured to supply a liquid to the substrate conveyed by the relay conveyance mechanism (STR, 67, 68) to wet a surface of the substrate with the liquid.

9. The substrate processing system according to claim 1, wherein the relay apparatus (6) includes a batch processing apparatus-side shutter (S1) configured to block circulation of an atmosphere through the substrate conveyance path and provided on the carry-in position side.

10. The substrate processing system according to claim 1, wherein the relay apparatus (6) includes a single-wafer processing apparatus-side shutter (S2) configured to block circulation of an atmosphere through the substrate conveyance path and provided on the carry-out position side.

11. The substrate processing system according to claim 1, wherein, in the relay apparatus (6), the carry-out position is positioned in a middle layer of a stacked body including the single-wafer processing chambers (48a,48b, 48c) stacked in the vertical direction in the single-wafer processing apparatus (2).

12. The substrate processing system according to claim 1, wherein the carry-out position of the relay apparatus (6) and the plurality of single-wafer processing chambers (48a,48b, 48c) are disposed around the single-wafer conveyance mechanism (CR).

13. The substrate processing system according to claim 1, wherein the relay apparatus (6) is provided closer to the transfer block (5) than the batch processing bath of the batch processing apparatus (1).

14. The substrate processing system according to claim 1, comprising
a carrier conveyance mechanism (11) configured to convey the carrier between the batch processing apparatus (1) and the single-wafer processing apparatus (2) to cause the substrates after substrate processing to return to the same carrier as the carrier that accommodates the substrates before substrate processing.

15. The substrate processing system according to claim 1, wherein
the batch processing apparatus (1) includes:
a first housing (1A) configured to accommodate the blocks constituting the batch processing apparatus (1); and
a first load port (9) protruding from a first wall surface perpendicular to a predetermined direction from the batch processing block (7) toward the transfer block (5), among wall surfaces forming the first housing (1A), and
the single-wafer processing apparatus (2) includes:
a second housing (2A) configured to accommodate the blocks constituting the single-wafer processing apparatus (2); and
a second load port (10) protruding from a second wall surface perpendicular to the predetermined direction, among wall surfaces forming the second housing (2A),
the second load port (10) being at a position on a same side as the first load port (9) in the predetermined direction.

16. The substrate processing system according to claim 1, wherein
the batch processing apparatus (1) includes:
a first housing (1A) configured to accommodate the blocks constituting the batch processing apparatus (1); and
a first load port (9) protruding from a first wall surface perpendicular to a predetermined direction from the batch processing block (7) toward the transfer block (5), among wall surfaces forming the first housing (1A),
the single-wafer processing apparatus (2) includes:
a second housing (2A) configured to accommodate the blocks constituting the single-wafer processing apparatus (2); and
a second load port (10) protruding from a second wall surface perpendicular to the predetermined direction, among wall surfaces forming the second housing (2A), and
the relay apparatus (6) includes a relay housing configured to connect the first housing (1A) and the second housing (2A) separated from each other,
the relay housing being provided between a first perpendicular wall surface of the first housing (1A) perpendicular to the first wall surface, and a second perpendicular wall surface of the second housing (2A) perpendicular to the second wall surface and provided at a position facing the first perpendicular wall surface.

17. The substrate processing system according to claim 1, comprising:
the one batch processing apparatus (1);
the first and second single-wafer processing apparatuses (2); and
the first and second relay apparatuses (6),
wherein the batch processing apparatus (1) is disposed between the first single-wafer processing apparatus (2) and the second single-wafer processing apparatus (2) with a gap between the respective apparatuses,
the batch processing apparatus (1) and the first single-wafer processing apparatus (2) are connected by the first relay apparatus (6), and
the batch processing apparatus (1) and the second single-wafer processing apparatus (2) are connected by the second relay apparatus (6).

18. The substrate processing system according to claim 1, comprising:
the one batch processing apparatus (1);
the first and second single-wafer processing apparatuses (2); and
the first and second relay apparatuses (6),
wherein the batch processing apparatus (1), the first single-wafer processing apparatus (2), and the second single-wafer processing apparatus (2) are disposed sequentially with a gap between the respective apparatuses,
the batch processing apparatus (1) and the first single-wafer processing apparatus (2) are connected by the first relay apparatus (6), and
the batch processing apparatus (1) and the second single-wafer processing apparatus (2) are connected by the second relay apparatus (6).

19. The substrate processing system according to claim 1, comprising
an airflow generator (83) configured to cause an atmosphere of the relay apparatus (6) to flow into the batch processing apparatus (1).

20. The substrate processing system according to claim 1, wherein
the batch processing block (7) includes a collective drying chamber configured to collectively dry the plurality of substrates,
the single-wafer processing block (8) includes a single-wafer processing chamber configured to perform a chemical treatment on the substrates one by one, and
control related to a batch processing mode in which substrate processing is completed only by the batch processing apparatus (1), control related to a single-wafer processing mode in which substrate processing is completed only by the single-wafer processing apparatus (2), and control related to a hybrid processing mode in which substrate processing is completed using the batch processing apparatus (1) and the single-wafer processing apparatus (2) are selectively configured.
